(19) 

Europäisches
Patentamt
European
Patent Office
Office européen
des brevets

(11) **EP 4 593 568 A1**

(12) **EUROPEAN PATENT APPLICATION**
published in accordance with Art. 153(4) EPC

(43) Date of publication:
**30.07.2025 Bulletin 2025/31**

(21) Application number: **23954968.6**

(22) Date of filing: **23.10.2023**

(51) International Patent Classification (IPC):
***H10K 59/121*** *(2023.01)*

(52) Cooperative Patent Classification (CPC):
**H10K 59/121**

(86) International application number:
**PCT/CN2023/125965**

(87) International publication number:
**WO 2025/086044 (01.05.2025 Gazette 2025/18)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicants:
• **Boe Technology Group Co., Ltd.
Beijing 100015 (CN)**
• **Chengdu BOE Optoelectronics Technology Co.,
Ltd.
Chengdu, Sichuan 611731 (CN)**

(72) Inventors:
• **FANG, Fei
Beijing 100176 (CN)**
• **SHI, Ling
Beijing 100176 (CN)**
• **ZHOU, Weifeng
Beijing 100176 (CN)**
• **WU, Qiyang
Beijing 100176 (CN)**
• **LIU, Lang
Beijing 100176 (CN)**

(74) Representative: **Durán-Corretjer, S.L.P.
Còrsega, 329
(Paseo de Gracia/Diagonal)
08037 Barcelona (ES)**

(54) **DISPLAY SUBSTRATE, DISPLAY APPARATUS AND ELECTRONIC APPARATUS**

(57)     Disclosed are a display substrate, a display apparatus and an electronic apparatus, the display substrate includes a base substrate and a plurality of subpixels disposed on the base substrate, at least one subpixel includes a pixel drive circuit, at least one pixel drive circuit includes a plurality of first-type transistors (M1) and a plurality of second-type transistors (M2), an orthographic projection of at least one first-type transistor (M1) on the base substrate is at least partially overlapped with an orthographic projection of at least one second-type transistor (M2) on the base substrate.

FIG. 4

Processed by Luminess, 75001 PARIS (FR)

EP 4 593 568 A1

**Description**

Technical Field

The present disclosure relates to, but is not limited to, the field of display technologies, and particularly to a display substrate, a display apparatus, and an electronic apparatus.

Background

An Organic Light Emitting Diode (OLED for short) and a Quantum dot Light Emitting Diode (QLED for short) are active light emitting display devices and have advantages such as self-luminescence, wide viewing angle, high contrast ratio, low power consumption, very high response speed, lightness and thinness, flexibility, and low cost.

Summary

The following is a summary of subject matters described herein in detail. This summary is not intended to limit the protection scope of claims.

In a first aspect, an embodiment of the present disclosure provides a display substrate including a base substrate and a plurality of sub-pixels disposed on the base substrate, wherein at least one sub-pixel includes a pixel drive circuit, at least one pixel drive circuit includes a plurality of first-type transistors and a plurality of second-type transistors, an orthographic projection of at least one of the first-type transistors on the base substrate is at least partially overlapped with an orthographic projection of at least one of the second-type transistors on the base substrate.

In an exemplary implementation, pixel drive circuits of the plurality of sub-pixels form a plurality of rows of pixel drive circuits, a light-transmitting region is provided between two adjacent rows of pixel drive circuits, and there is no overlapping region between an orthographic projection of the light-transmitting region on the base substrate and orthographic projections of the pixel drive circuits on the base substrate.

In an exemplary implementation, the display substrate further includes a shield layer, the shield layer is located between the base substrate and the pixel drive circuits in a direction perpendicular to a plane on which the display substrate is located, the shield layer is provided with a light-transmitting opening, and boundary lines of the light-transmitting opening are smoothly connected.

In an exemplary implementation, the display substrate further includes a black matrix layer, the black matrix layer is located at a side of the pixel drive circuits away from the base substrate in a direction perpendicular to a plane on which the display substrate is located, the black matrix layer is provided with a light-transmitting opening, and boundary lines of the light-transmitting opening are smoothly connected.

In an exemplary implementation, an orthographic projection of the light-transmitting opening on the base substrate is overlapped with an orthographic projection of the light-transmitting region on the base substrate.

In an exemplary implementation, the light-transmitting opening is in a shape of an ellipse or a polygon, and corners of the polygon are provided with rounded corner structures.

In an exemplary implementation, the display substrate further includes an anode conductive layer, the anode conductive layer is located at a side of the pixel drive circuits away from the base substrate, the anode conductive layer includes a plurality of anodes, each sub-pixel includes at least one anode, the anode and the pixel drive circuit in a same sub-pixel are electrically connected with each other, and there is no overlapping region between an orthographic projection of the anode on the base substrate and an orthographic projection of the light-transmitting region on the base substrate.

In an exemplary implementation, the plurality of sub-pixels include a plurality of first sub-pixels, a plurality of second sub-pixels, and a plurality of third sub-pixels, an area of an anode of a first sub-pixel and an area of an anode of a second sub-pixel are each greater than an area of an anode of a third sub-pixel, and orthographic projections of anodes of the first sub-pixel and the second sub-pixel on the base substrate are within a range of an orthographic projection of the pixel drive circuit on the base substrate.

In an exemplary implementation, anodes of the plurality of third sub-pixels are arranged in an array on a plane parallel to the display substrate, and the light-transmitting region is located between anodes of two adjacent columns of third sub-pixels in a row direction; in a column direction, anodes of the first sub-pixels and anodes of the second sub-pixels are alternately arranged, and the light-transmitting region is located between anodes of a first sub-pixel and a second sub-pixel which are adjacent.

In an exemplary implementation, a first-type transistor at least includes a third transistor as a drive transistor, a second-type transistor at least includes a first transistor as a first initialization transistor, a second electrode of the first transistor is electrically connected with a second electrode of the third transistor; an orthographic projection of the first transistor on the base substrate is at least partially overlapped with an orthographic projection of the third transistor on the base substrate .

In an exemplary implementation, orthographic projections of a control electrode and an active layer of the third transistor on the base substrate are at least partially overlapped with orthographic projections of a control electrode and an active layer of the first transistor on the base substrate, respectively.

In an exemplary implementation, the first-type transistor further includes a sixth transistor as a light emitting transistor, and the second-type transistor further includes a seventh transistor as a second initialization transistor, a first electrode of the sixth transistor and a second electrode of the seventh transistor are both electrically connected with the second electrode of the third transistor; an orthographic projection of the sixth transistor on the base substrate is at least partially overlapped with an orthographic projection of the seventh transistor on the base substrate.

In an exemplary implementation, orthographic projections of a control electrode and an active layer of the sixth transistor on the base substrate are at least partially overlapped with orthographic projections of a control electrode and an active layer of the seventh transistor on the base substrate, respectively.

In an exemplary implementation, the first-type transistor further includes a fourth transistor as a data writing transistor and a fifth transistor as a light emitting transistor, the second-type transistor further includes a second transistor as a compensation transistor and an eighth transistor as a third initialization transistor, a second electrode of the fourth transistor, a second electrode of the fifth transistor and a second electrode of the eighth transistor are all electrically connected with a first electrode of the third transistor, a first electrode of the second transistor is electrically connected with a control electrode of the third transistor, and second electrode of the second transistor is electrically connected with the second electrode of the third transistor;

on a plane parallel to the display substrate, in a first direction, the fourth transistor and the fifth transistor are located at one side of the first transistor and the third transistor, the second transistor, the sixth transistor, and the seventh transistor are located at the other side of the third transistor and the first transistor, and the eighth transistor is located between the fifth transistor and the seventh transistor; in a second direction, the fourth transistor and the second transistor are located at one side of the third transistor, the fifth transistor to the eighth transistor are located at the other side of the third transistor, and the first direction and the second direction intersect.

In an exemplary implementation, an orthographic projection of an active layer of the second transistor on the base substrate is at least partially overlapped with an orthographic projection of an active layer of the sixth transistor on the base substrate.

In an exemplary implementation, the display substrate further includes a drive circuit layer, the drive circuit layer includes pixel drive circuits of the plurality of sub-pixels, a pixel drive circuit further includes a storage capacitor, the drive circuit layer includes a first semiconductor layer, a first conductive layer, a second conductive layer, a third conductive layer, a second semiconductor layer, and a fourth conductive layer sequentially disposed on the base substrate in a direction perpendicular to a plane on which the display substrate is located;

the first semiconductor layer at least includes: an active layer of the first-type transistor; the first conductive layer at least includes a control electrode of the first-type transistor and a first plate of the storage capacitor; the second conductive layer at least includes: a second plate of the storage capacitor; the third conductive layer at least includes: a shield layer of the second-type transistor; the second semiconductor layer at least includes: an active layer of the second-type transistor; the fourth conductive layer at least includes a control electrode of the second-type transistor.

In an exemplary implementation, the drive circuit layer further includes a fifth conductive layer located on a side of the fourth conductive layer away from the second semiconductor layer, the fifth conductive layer at least includes: first electrodes and second electrodes of the first-type transistor and the second-type transistor;

orthographic projections of the first plate and the second plate on the base substrate are at least partially overlapped with an orthographic projection of the third transistor on the base substrate, on a plane parallel to the display substrate, in the second direction, a side of the first plate close to the second transistor is provided with a connection structure, an orthographic projection of the connection structure on the base substrate does not overlap at least partially with orthographic projections of the storage capacitor and the third transistor on the base substrate, a first electrode of the second transistor is electrically connected with the connection structure through a via, and there is no overlapping region between an orthographic projection of the second transistor on the base substrate and an orthographic projection of the storage capacitor on the base substrate.

In an exemplary implementation, the pixel drive circuits of the plurality of sub-pixels form a plurality of columns of pixel drive circuits, the drive circuit layer further includes a sixth conductive layer and a seventh conductive layer, in a direction perpendicular to a plane on which the display substrate is located, the sixth conductive layer is located on a side of the fifth conductive layer away from the fourth conductive layer and the seventh conductive layer is located on a side of the sixth conductive layer away from the fifth conductive layer, the sixth conductive layer at least includes: a data signal line electrically connected with first electrodes of fourth transistors in one column of the columns of pixel drive circuits; the seventh conductive layer at least includes: a first power supply line electrically connected with first electrodes of fifth transistors and second plates of storage capacitors in two adjacent columns of the columns of pixel drive circuits;

on a plane parallel to the display substrate, the data signal line and the first power supply line extend along the second direction and are arranged at intervals along the first direction, and data signal lines of two adjacent columns of pixel drive circuits are located at two sides of the first power supply line electrically connected with the two adjacent columns of pixel drive circuits; two adjacent columns of pixel drive circuits are symmetrically disposed along a second midline, and the second midline is a midline of the two adjacent columns of pixel drive circuits extending along the second direction. In an exemplary implementation, the sixth conductive layer further includes a shielding electrode, and the seventh conductive layer further includes a first power supply connection line and a second power supply connection line;

on the plane parallel to the display substrate, the first power supply connection line extends along the second direction, the second power supply connection line extends along the first direction, each second power supply connection line is connected with at least some of first power supply lines; in the first direction, the shielding electrode and the first power supply connection line are located between two adjacent data signal lines; in the second direction, the first power supply connection line is located between two adjacent second power supply connection lines, and two ends of the first power supply connection line are respectively connected with the two adjacent second power supply connection lines;

an orthographic projection of the shielding electrode on the base substrate covers an orthographic projection of the connection structure on the base substrate; the first power supply connection line is at least partially overlapped with an orthographic projection of the shielding electrode on the base substrate, and the first power supply connection line is electrically connected with the shielding electrode through a via.

In an exemplary implementation, at least partial structure of a first-type transistor and at least partial structure of a second-type transistor are located at different conductive layers, at least partial structure of a first-type transistor and at least partial structure of a second-type transistor are located at different conductive layers, an orthographic projection of the at least partial structure of at least one of the first-type transistors on the base substrate and is at least partially overlapped with an orthographic projection of the at least partial structure of at least one of the second-type transistors on the base substrate, the partial structure includes one or more of a control electrode and an active layer of a transistor.

In a second aspect, an embodiment of the present disclosure further provides a display substrate including a base substrate and a plurality of sub-pixels disposed on the base substrate, wherein a light-transmitting region is provided between at least two adjacent sub-pixels, and boundary lines of the light-transmitting region are smoothly connected.

In an exemplary implementation, a sub-pixel includes a pixel drive circuit, pixel drive circuits of the plurality of sub-pixels form a plurality of rows of pixel drive circuits, and the light-transmitting region is located between two adjacent rows of pixel drive circuits. In an exemplary implementation, the display substrate further includes a shield layer, the shield layer is located between the base substrate and the pixel drive circuits in a direction perpendicular to a plane on which the display substrate is located, the shield layer is provided with a light-transmitting opening, and boundary lines of the light-transmitting opening are smoothly connected.

In an exemplary implementation, the display substrate further includes a black matrix layer, the black matrix layer is located at a side of the pixel drive circuits away from the base substrate in a direction perpendicular to a plane on which the display substrate is located, the black matrix layer is provided with a light-transmitting opening, and boundary lines of the light-transmitting opening are smoothly connected.

In an exemplary implementation, an orthographic projection of the light-transmitting opening on the base substrate is overlapped with an orthographic projection of the light-transmitting region on the base substrate.

In an exemplary implementation, the light-transmitting opening is in a shape of an ellipse or a polygon, and corners of the polygon are provided in rounded corner structures.

In an exemplary implementation, the display substrate further includes an anode conductive layer and a drive circuit layer, the pixel drive circuit is disposed in the drive circuit layer, the anode conductive layer is located on a side of the drive circuit layer away from the base substrate, the anode conductive layer includes a plurality of anodes, each sub-pixel includes at least one anode, the anode and the pixel drive circuit in a same sub-pixel are electrically connected with each other, and there is no overlapping region between an orthographic projection of the anode on the base substrate and an orthographic projection of the light-transmitting region on the base substrate.

In an exemplary implementation, the plurality of sub-pixels include a plurality of first sub-pixels, a plurality of second sub-pixels, and a plurality of third sub-pixels, an area of an anode of a first sub-pixel and an area of an anode of a second sub-pixel are each greater than an area of an anode of a third sub-pixel, and orthographic projections of anodes of the first sub-pixel and the second sub-pixel on the base substrate are within a range of an orthographic projection of the pixel drive circuit on the base substrate.

In an exemplary implementation, anodes of the plurality of third sub-pixels are arranged in an array on a plane parallel to the display substrate, and the light-transmitting region is located between anodes of two adjacent columns of third sub-pixels in a row direction; in a column direction, anodes of the first sub-pixels and anodes of the second sub-pixels are alternately arranged, and the light-transmitting region is located between anodes of a first sub-pixel and a second sub-pixel which are adjacent.

In a third aspect, an embodiment of the present disclosure further provides a display substrate including a base substrate and a plurality of sub-pixels, a plurality of data signal lines, and a plurality of first power supply lines which are disposed on the base substrate, on a plane parallel to the display substrate, the plurality of data signal lines and the plurality of first power supply lines extend along a second direction and are arranged at intervals along a first direction, and the first direction intersects the second direction;

at least some of the sub-pixels include pixel drive circuits, pixel drive circuits of the plurality of sub-pixels form a plurality of columns of pixel drive circuits, each data signal line is electrically connected with at least some pixel drive circuits in one column of pixel drive circuits of the columns, each first power supply line is electrically connected with at least some pixel drive circuits in at least one column of pixel drive circuits, and in the first direction, two adjacent data signal lines are located at two sides of the first power supply line.

In an exemplary implementation, each first power supply line is electrically connected with two adjacent columns of pixel drive circuits, two adjacent columns of pixel drive circuits are symmetrically disposed along a second midline, and the second midline is a midline of the two adjacent columns of pixel drive circuits extending along the second direction.

In an exemplary implementation, the pixel drive circuit further includes a shielding electrode disposed between two adjacent data signal lines in the first direction, and the data signal line is located between the shielding electrode and the first power supply line in a same column of pixel drive circuits.

In an exemplary implementation, the display substrate further includes a first power supply connection line and a second power supply connection line, on a plane parallel to the display substrate, the first power supply connection line extends along the second direction and the second power supply connection line extends along the first direction, each second power supply connection line is connected with at least some of first power supply lines;

in the first direction, the first power supply connection line is located between two adjacent data signal lines; in the second direction, the first power supply connection line is located between two adjacent second power supply connection lines, and two ends of the first power supply connection line are respectively connected two with two adjacent second power supply connection lines;

the shielding electrode and the data signal line are located in a same conductive layer, the first power supply line, the first power supply connection line and the second power supply connection line are located in a same conductive layer, and the data signal line and the first power supply line are located in different conductive layers; an orthographic projection of the first power supply connection line on the base substrate is at least partially overlapped with an orthographic projection of the shielding electrode on the base substrate, and the first power supply line and the shielding electrode are electrically connected through a via.

In a fourth aspect, an embodiment of the present disclosure further provides a display apparatus, including the display substrate according to any one of the embodiments described above.

In a fifth aspect, an embodiment of the present disclosure further provides an electronic apparatus including a sensor and the display substrate according to any one of the embodiments described above, the display device includes a display substrate, the sensor is located on a side of a non-display surface of the display substrate, the display substrate includes a first display region, an orthographic projection of the sensor on the display substrate is at least partially overlapped with the first display region of the display substrate.

Other aspects of the present disclosure may be comprehended after the drawings and the detailed descriptions are read and understood.

Brief Description of Drawings

Accompanying drawings are intended to provide further understanding of technical solutions of the present disclosure and form a part of the specification, and are used to explain the technical solutions of the present disclosure together with embodiments of the present disclosure, but do not form limitations on the technical solutions of the present disclosure. Shapes and sizes of each component in the drawings do not reflect actual scales, but are only intended to schematically illustrate contents of the present disclosure.

FIG. 1 is a schematic diagram of a structure of a display substrate.
FIG. 2 is an equivalent circuit diagram of a pixel drive circuit.
FIG. 3 is a working timing diagram of the pixel drive circuit provided in FIG. 2.
FIG. 4 is a schematic diagram of a planar structure of a display substrate according to an exemplary embodiment of the present disclosure.
FIG. 5a is a schematic diagram of a planar structure of a display substrate according to an exemplary embodiment of the present disclosure.
FIG. 5b is a schematic diagram of a planar structure of a display substrate according to an exemplary embodiment of the present disclosure.

FIG. 5c is a schematic diagram of a planar structure of a display substrate according to an exemplary embodiment of the present disclosure.

FIG. 6a is a schematic diagram of a planar structure of a shield layer in a display substrate according to an exemplary embodiment of the present disclosure.

FIG. 6b is a schematic diagram of a planar structure of a shield layer in a display substrate according to an exemplary embodiment of the present disclosure.

FIG. 6c is a schematic diagram of a planar structure of a black matrix layer in a display substrate according to an exemplary embodiment of the present disclosure.

FIG. 6d is a schematic diagram of a planar structure of a black matrix layer in a display substrate according to an exemplary embodiment of the present disclosure.

FIG. 6e is a schematic diagram of a planar structure of a display substrate according to an exemplary embodiment of the present disclosure.

FIG. 6f is a schematic diagram of a planar structure of a display substrate according to an exemplary embodiment of the present disclosure.

FIG. 6g is a schematic diagram of a planar structure of a display substrate according to an exemplary embodiment of the present disclosure.

FIG. 6h is a schematic diagram of a planar structure of a display substrate according to an exemplary embodiment of the present disclosure.

FIG. 7 shows an equivalent circuit diagram of a pixel drive circuit according to an exemplary embodiment of the present disclosure.

FIG. 8 is a working timing diagram of the pixel drive circuit provided in FIG. 7.

FIG. 9 shows a schematic diagram of a display substrate after a shield layer is formed according to an exemplary embodiment of the present disclosure.

FIG. 10a is a schematic diagram of a display substrate after a first semiconductor layer is formed according to an exemplary embodiment of the present disclosure.

FIG. 10b is a schematic diagram of a planar structure of the first semiconductor layer in FIG. 10a.

FIG. 11a is a schematic diagram of a display substrate after a first conductive layer is formed according to an exemplary embodiment of the present disclosure.

FIG. 11b is a schematic diagram of a planar structure of the first conductive layer in FIG. 11a.

FIG. 12a is a schematic diagram of a display substrate after a second conductive layer is formed according to an exemplary embodiment of the present disclosure.

FIG. 12b is a schematic diagram of a planar structure of the second conductive layer in FIG. 12a.

FIG. 13a is a schematic diagram of a display substrate after a third conductive layer is formed according to an exemplary embodiment of the present disclosure.

FIG. 13b is a schematic diagram of a planar structure of the third conductive layer in FIG. 12a.

FIG. 14a is a schematic diagram of a display substrate after a second semiconductor layer is formed according to an exemplary embodiment of the present disclosure.

FIG. 14b is a schematic diagram of a planar structure of the second semiconductor conductive layer in FIG. 14a.

FIG. 15a is a schematic diagram of a display substrate after a fourth conductive layer is formed according to an exemplary embodiment of the present disclosure.

FIG. 15b is a schematic diagram of a planar structure of the fourth conductive layer in FIG. 15a.

FIG. 16 is a schematic diagram of a display substrate after a seventh insulation layer is formed according to an exemplary embodiment of the present disclosure.

FIG. 17a is a schematic diagram of a display substrate after a fifth conductive layer is formed according to an exemplary embodiment of the present disclosure.

FIG. 17b is a schematic diagram of a planar structure of the fifth conductive layer in FIG. 17a.

FIG. 18 shows a schematic diagram of a display substrate after a first planarization layer is formed according to an exemplary embodiment of the present disclosure.

FIG. 19a is a schematic diagram of a display substrate after a sixth conductive layer is formed according to an exemplary embodiment of the present disclosure.

FIG. 19b is a schematic diagram of a planar structure of the sixth conductive layer in FIG. 19a.

FIG. 20 shows a schematic diagram of a display substrate after a second planarization layer is formed according to an exemplary embodiment of the present disclosure.

FIG. 21a is a schematic diagram of a display substrate after a seventh conductive layer is formed according to an exemplary embodiment of the present disclosure.

FIG. 21b is a schematic diagram of a planar structure of the seventh conductive layer in FIG. 21a.

FIG. 22 shows a schematic diagram of a display substrate after a third planarization layer is formed according to an exemplary embodiment of the present disclosure.

FIG. 23a is a schematic diagram of a display substrate after an anode layer is formed according to an exemplary embodiment of the present disclosure.

FIG. 23b is a schematic diagram of a planar structure of the anode layer in FIG. 23a.

FIG. 24a is a schematic diagram of a display substrate after a pixel definition layer is formed according to an exemplary embodiment of the present disclosure.

FIG. 24b is a schematic diagram of a planar structure of the pixel definition layer in FIG. 24a.

FIG. 25 is a schematic diagram of a display apparatus according to an exemplary embodiment of the present disclosure.

FIG. 26 is a schematic diagram of an electronic apparatus according to an exemplary embodiment of the present disclosure.

Detailed Description

Embodiments of the present disclosure will be described in detail hereinafter with reference to the drawings. Implementation modes may be implemented in a plurality of different forms. Those of ordinary skills in the art can easily understand such a fact that implementation modes and contents may be transformed into various forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict. In order to keep following description of the embodiments of the present disclosure clear and concise, detailed description of part of known functions and known components are omitted in the present disclosure. The drawings in the embodiments of the present disclosure relate only to the structures involved in the embodiments of the present disclosure, and other structures may be described with reference to conventional designs.

Scales of the drawings in the present disclosure may be used as a reference in actual processes, but are not limited thereto. For example, a thickness and a pitch of each film layer, and a width and a pitch of each signal line may be adjusted according to an actual situation. The drawings described in the present disclosure are only schematic diagrams of structures, and one implementation of the present disclosure is not limited to shapes or numerical values or the like shown in the drawings.

Ordinal numerals "first", "second", "third", etc., in the specification are set not to form limits in numbers but only to avoid confusion between composition elements.

In the specification, for convenience, expressions "central", "above", "below", "front", "back", "vertical", "horizontal", "top", "bottom", "inside", "outside", etc., indicating directional or positional relationships are used to illustrate positional relationships between the composition elements, not to indicate or imply that involved devices or elements are required to have specific orientations and be structured and operated with the specific orientations but only to easily and simply describe the present specification, and thus should not be understood as limitations on the present disclosure. The positional relationships between the constituent elements may be changed as appropriate according to a direction which is used for describing each constituent element. Therefore, appropriate replacements based on situations are allowed, which is not limited to the expressions in the specification.

In the specification, unless otherwise specified and defined, terms "mounting", "mutual connection", and "connection" should be understood in a broad sense. For example, a connection may be fixed connection, or a detachable connection, or an integral connection; it may be a mechanical connection or an electrical connection; it may be a direct connection, or an indirect connection through middleware, or internal communication inside two elements. Those of ordinary skills in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode", as well as the "source terminal" and the "drain terminal", are interchangeable in the specification. In an embodiment of the present disclosure, the gate electrode may be referred to as a control electrode.

In the specification, "electrical connection" includes connection of composition elements through an element with a certain electrical action. An "element with a certain electrical action" is not particularly limited as long as electrical signals between the connected constituent elements may be sent and received. Examples of the "element with the certain electrical action" not only include an electrode and a wiring, but also include a switching element such as a transistor, a resistor, an inductor, a capacitor, another element with various functions, etc.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In the specification, a "film" and a "layer" are interchangeable. For example, a "conductive layer" may be replaced with a "conductive thin film" sometimes. Similarly, an "insulation film" may be replaced with an "insulation layer" sometimes.

Triangle, rectangle, trapezoid, pentagon, hexagon, etc. in this specification are not strictly defined, and they may be approximate triangle, rectangle, trapezoid, pentagon, hexagon, etc. There may be some small deformations caused by tolerance, and there may be chamfer, arc edge, deformation, etc.

In an embodiment of the present disclosure, "about" refers to a value that is not strictly limited, a value within a range of process and measurement error is allowed.

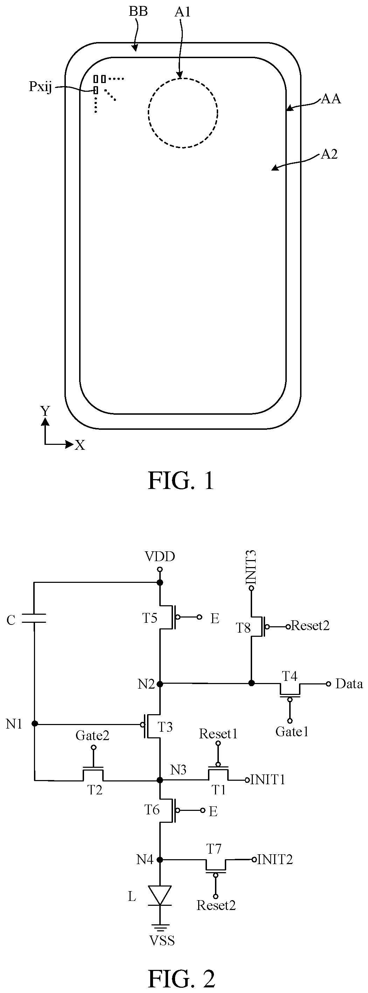

FIG. 1 is a schematic diagram of a planar structure of a display substrate. In some examples, as shown in FIG. 1, the display substrate may include a display region AA and a peripheral region BB located at a periphery of the display region AA. The display region AA of the display substrate may at least include a first display region A1 and a second display region A2. The second display region A2 may at least partially surround the first display region A1. For Example, the second display region A2 may surround the first display region A1. The peripheral region BB may surround the second display region A2. However, the present embodiment is not limited thereto.

In some examples, as shown in FIG. 1, the first display region A1 may be a light transmitting display region and may also be referred to as a Full Display with Camera (FDC) region. The second display region A2 may be referred to as a normal display region. For example, an orthographic projection of a sensor (such as a camera and other hardware) on the display substrate may be located within the first display region A1 of the display substrate. In some examples, as shown in FIG. 1, the first display region A1 may be circular, and a size of an orthographic projection of the sensor on the display substrate may be less than or equal to a size of the first display region A1. However, the present embodiment is not limited thereto. In some other examples, the first display region A1 may be rectangular, and a size of the orthographic projection of the sensor on the display substrate may be less than or equal to a size of an inscribed circle of the first display region A1.

In some examples, as shown in FIG. 1, the first display region A1 may be located at a middle position of the top of the display area AA. The second display region A2 may surround a periphery of the first display region A1. However, the present embodiment is not limited thereto. For example, the first display region A1 may be located in other positions such as an upper left corner, a lower left corner, a lower right corner or an upper right corner of the display region AA. For example, the second display region A2 may surround at least one side of the first display region A1.

In some examples, as shown in FIG. 1, the display region AA may be in a shape of a rectangle, e.g., a rounded rectangle. The first display region A1 may be circular or elliptical. However, the present embodiment is not limited thereto. For example, the first display region A1 may be rectangular, semicircular, pentagonal, or another shape.

In some examples, the display region AA may be provided with a plurality of sub-pixels Pxij, and i and j may be natural numbers. At least one sub-pixel Pxij may include a pixel drive circuit and a light emitting element. The pixel drive circuit may be configured to drive a light emitting element connected thereto. For example, the pixel drive circuit may be configured to provide a drive current for driving the light emitting element to emit light. The pixel drive circuit may include a plurality of transistors and at least one capacitor. For example, the pixel drive circuit may be a circuit of a 3T1C, 4T1C, 5T1C, 5T2C, 6T1C, 7T1C, or 8T1C structure. Herein, in the above circuit structure, T refers to a thin film transistor, C refers to a capacitor, a number before T represents a quantity of thin film transistors in the circuit, and a number before C represents a quantity of capacitors in the circuit.

In some examples, the light emitting element may be any of a Light Emitting Diode (LED), an Organic Light Emitting Diode (OLED), a Quantum dot Light Emitting Diode (QLED), a micro LED (including: mini-LED or micro-LED), and the like. For example, the light emitting element may be an OLED, and the light emitting element may emit red light, green light, blue light, or white light, etc. under drive of a pixel drive circuit corresponding to the light emitting element. A color of light emitted by the light emitting element may be determined as required. In some examples, the light emitting element may include an anode, a cathode, and an organic emitting layer located between the anode and the cathode. The anode of the light emitting element may be electrically connected to a corresponding pixel drive circuit. However, the present embodiment is not limited thereto.

FIG. 2 is a schematic diagram of a structure of a pixel drive circuit. FIG. 2 is illustrated by an example of 8T1C. As shown in FIG. 2, the pixel drive circuit may be connected with eleven signal lines (a data line Data, a first scan line Gate1, a second scan line Gate2, a first reset line Reset1, a second reset line Reset2, a light emitting line E, a first initial signal line INIT1, a second initial signal line INIT2, a third initial signal line INIT3, a first power supply line VDD, and a second power supply line VSS). Gate lines include the first scan line Gate1, the second scan line Gate2, the first reset line Reset1, the second reset line Reset2, and the light emitting line E.

In an exemplary implementation, as shown in FIG. 2, a control electrode of a first transistor T1 is connected to the first reset line Reset1, a first electrode of the first transistor T1 is connected to the first initial signal line INIT1, and a second electrode of the first transistor is connected to a third node N3. A control electrode of a second transistor T2 is connected with the second scan line Gate2, a first electrode of the second transistor T2 is connected with a first node N1, and a second electrode of the second transistor T2 is connected with a third node N3. A control electrode of a third transistor T3 is connected with the first node N1, a first electrode of the third transistor T3 is connected with a second node N2, and a second electrode of the third transistor T3 is connected with the third node N3. A control electrode of a fourth transistor T4 is connected with a first scan line Gate1, a first electrode of the fourth transistor T4 is connected with a data line Data, and a second electrode of the fourth transistor T4 is connected with the second node N2. A control electrode of a fifth transistor T5 is connected to the light emitting line E, a first electrode of the fifth transistor T5 is connected to the first power supply line VDD, and a second electrode of the fifth transistor T5 is connected to the second node N2. A control electrode of a sixth transistor T6 is connected to the light emitting line E, a first electrode of the sixth transistor T6 is connected to the third node N3, and a second electrode of the sixth transistor T6 is connected to a fourth node N4. A control electrode of a seventh transistor T7 is connected to the second reset line Reset2, a first electrode of the seventh transistor T7 is connected to the second initial signal line INIT2, and a second electrode of the seventh transistor T7 is connected to the fourth node N4. A control electrode of an eighth transistor T8 is connected to the second reset line Reset2, a first electrode of the eighth transistor T8 is connected to the third initial signal line INIT3, a second electrode of the eighth transistor T8 is connected to the second node N2. A first terminal of a capacitor C is connected to the first power supply line VDD, and a second terminal of the capacitor C is connected to the first node N1.

In an exemplary implementation, a first electrode of a light emitting device is electrically connected to the fourth node N4, a second electrode of the light emitting device is connected to the second power supply line VSS,

In an exemplary implementation, a signal of the second power supply line VSS is a low-level signal, and a signal of the first power supply line VDD is a continuously provided high-level signal.

Transistors may be divided into N-type transistors and P-type transistors according to their characteristics. When a transistor is a P-type transistor, its turn-on voltage is a low-level voltage (e.g., 0V, -5 V, -10 V, or another suitable voltage), and its turn-off voltage is a high-level voltage (e.g., 5 V, 10 V, or another suitable voltage). When a transistor is an N-type transistor, its turn-on voltage is a high-level voltage (e.g., 5 V, 10 V, or another suitable voltage), and its turn-off voltage is a low-level voltage (e.g., 0 V, -5 V, -10 V, or another suitable voltage).

In an exemplary implementation, the first transistor T1 to the eighth transistor T8 may be P-type transistors or N-type transistors. Use of a same type of transistors in a pixel drive circuit may simplify a process flow, reduce a process difficulty of a display panel, and improve a product yield. In some possible implementations, the first transistor T1 to the eighth transistor T8 may include P-type transistors and N-type transistors.

In an exemplary implementation, for the first transistor T1 to the eighth transistors T8, low temperature poly-silicon thin film transistors may be used, or oxide thin film transistors may be used, or both of low temperature poly-silicon thin film transistors and oxide thin film transistors may be used. An active layer of a low temperature poly silicon thin film transistor is made of Low Temperature Poly silicon (LTPS for short), and an active layer of an oxide thin film transistor is made of an oxide semiconductor (Oxide). A Low temperature poly silicon thin film transistor has advantages such as a high migration rate and fast charging, and an oxide thin film transistor has advantages such as a low leakage current. The low temperature poly silicon thin film transistor and the oxide thin film transistor are integrated on one display substrate to form a Low Temperature Polycrystalline Oxide (LTPO for short) display substrate, so that advantages of both the low temperature poly silicon thin film transistor and the oxide thin film transistor may be utilized, low-frequency drive may be achieved, power consumption may be decreased, and display quality may be improved.

In an exemplary implementation, as shown in FIG. 2, the second transistor T2 may be an N-type transistor, and the first transistor T1, the third transistor T3 to the eighth transistor T8 may be P-type transistors.

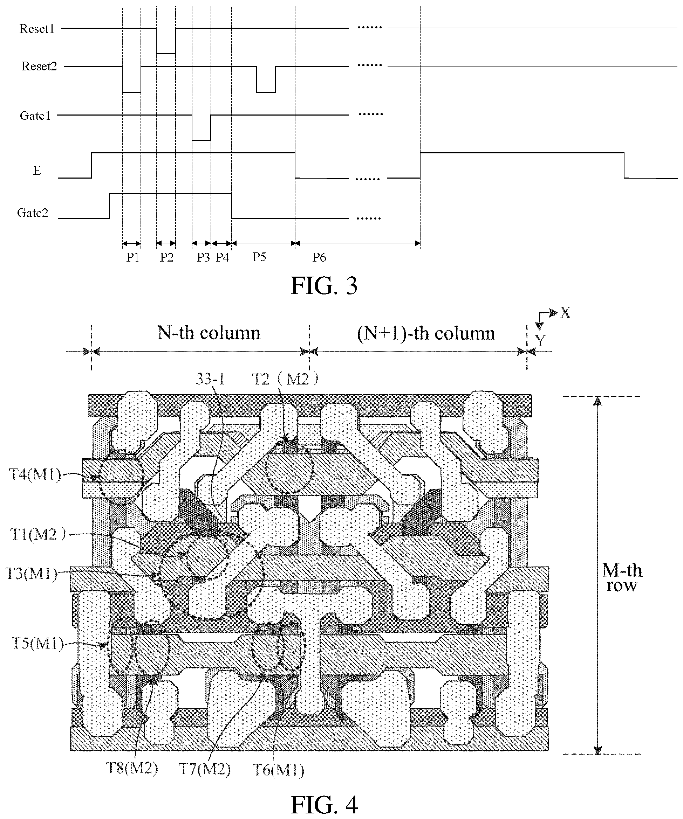

FIG. 3 is a diagram illustrating a working process of the pixel drive circuit provided in FIG. 2. In an exemplary implementation, the working process of the pixel drive circuit may include following stages.

In a first stage P1, referred to as a first reset stage, a signal of the second reset line Reset2 is a low-level signal, and signals of the first reset line Reset1, the first scan line Gate1, the second scan line Gate2, and the light emitting line E are high-level signals. The signal of the second reset line Reset2 is a low-level signal, so that the seventh transistor T7 and the eighth transistor T8 are turned on, and a signal of the second initial signal line INIT2 is provided to the fourth node N4, to initialize (reset) a first electrode of the light emitting device L, and clear an original charge in the first electrode of the light emitting device L. A signal of the third initial signal line INIT3 is provided to the second node N2, to initialize (reset) the second node N2 and clear an original charge in the second node N2. In this stage, the third transistor T3 is turned on. A signal of the second scan line Gate2 is a high-level signal, and the second transistor T2 is turned on. The signal of the second node N2 is provided to the first node N1 and the third node N3, the first node N1 and the third node N3 are initialized, signals of the first reset line Reset1, the first scan line Gate1, and the light emitting line E are high-level signals, and the first transistor T1, the fourth transistor T4, the fifth transistor T5, and the sixth transistor T6 are turned off. The light emitting device L does not emit light in this stage.

In a second stage P2, referred to as a second reset stage, a signal of the first reset line Reset1 is a low-level signal, and signals of the second reset line Reset2, the first scan line Gate 1, the second scan line Gate 2, and the light emitting line E are high-level signals. The signal of the first reset line Reset1 is a low-level signal, so that a signal of the first transistor T1 and the first initial signal line INIT1 is provided to the third node N3, to initialize (reset) the third node N3 again and clear an original charge in the third node N3. In this stage, the third transistor T3 is continuously turned on. A signal of the second scan line Gate2 is a high-level signal, and the second transistor T2 is turned on. The third node N3 is provided to the first node N1 to continuously initialize the first node N1, signals of the second reset line Reset2, the first scan line Gate1, and the light emitting line E are high-level signals, and the fourth transistor T4, the fifth transistor T5, the sixth transistor T6, the seventh transistor T7, and the eighth transistor T8 are turned off. The light emitting device L does not emit light in this stage.

In a third stage P 3, referred to as a data writing stage or a threshold compensation stage, a signal of the first scan line Gate1 is a low-level signal, and signals of the first reset line Reset1, the second reset line Reset2, the second scan line Gate2, and the light emitting line E are high-level signals. The data line Data outputs a data voltage. In this stage, the third transistor T3 is continuously turned on. The signal of the first scan line Gate1 is a low-level signal, so that the fourth transistor T4 is turned on. A signal of the second scan line Gate2 is a high-level signal, and the second transistor T2 is turned on. The data voltage outputted from the data line Data is provided to the first node N1 through the turned-on fourth transistor T4, the second node N2, the turned-on third transistor T3, the third node N3, and the turned-on second transistor T2, and the difference between the data voltage outputted from the data line Data and the threshold voltage of the third transistor T3 is charged into the capacitor C, the voltage at the second end of the capacitor C (the first node N1) is Vd-|Vth|, Vd is the data voltage outputted from the data line Data, and Vth is the threshold voltage of the third transistor T3. Signals of the first reset line Reset1, the second reset line Reset2 and the light emitting line E are high-level signals, and the first transistor T1, the fifth transistor T5, the sixth transistor T6, the seventh transistor T7 and the eighth transistor T8 are turned off. The light emitting device L does not emit light in this stage.

In a fourth stage P4, referred to as a continuous compensation stage, signals of the first reset line Reset1, the second reset line Reset2, the first scan line Gate1, the second scan line Gate2, and the light emitting line E are high-level signals. A signal of the second scan line Gate2 is a high-level signal, the second transistor T2 is continuously turned on, signals of the first scan line Gate1, the first reset line Reset1, the second reset line Reset2 and the light emitting line E are high-level signals, and the first transistor T1, the fourth transistor T4, the fifth transistor T5, the sixth transistor T6, the seventh transistor T7 and the eighth transistor T8 are turned off. Although the signal of the data line Data is stopped to write, the second node N2 is provided to the first node N1 through the turned-on third transistor T3, the third node N3, and the turned-on second transistor T2, to continuously compensate the threshold voltage of the third transistor T3.

In a fifth stage P5, referred to as a bias stage, signals of the second scan line Gate2 and the second reset line Reset2 are low-level signals, and signals of the first reset line Reset1, the first scan line Gate1 and the light emitting line E are high-level signals. A signal of the second scan line Gate2 is a low-level signal, signals of the first scan line Gate1, the first reset line Reset1 and the light emitting line E are high-level signals, and the first transistor T1, the second transistor T2, the fourth transistor T4, the fifth transistor T5 and the sixth transistor T6 are all turned off. A signal of the second reset line Reset2 is a low-level signal, the seventh transistor T7 and the eighth transistor T8 are turned on, the signal of the third initial signal line INIT3 is written to the second node N2 and the third node N3, and the signal of the second initial signal line INIT2 is written to the fourth node N3. In this stage, the third transistor T3 is in a biased state, and the light emitting device L does not emit light.

In a sixth stage P6, referred to as a light emitting stage, signals of the light emitting line E and the second scan line Gate2 are low-level signals, and signals of the first reset line Reset1, the second reset line Reset2 and the first scan line Gate1 are high-level signals. A signal of the light emitting signal line E is a low-level signal, so that the fifth transistor T5 and the sixth transistor T6 are turned on, and a power supply voltage outputted from the first power supply line VDD provides a driving voltage to a first electrode of the light emitting device L through the fifth transistor T5, the third transistor T3 and the sixth transistor T6 which are turned on, so as to drive the light emitting device L to emit light.

In a drive process of the pixel drive circuit, a drive current flowing through the third transistor T3 (drive transistor) is determined by a voltage difference between a gate electrode and the first electrode of the third transistor T3. Because the voltage of the first node N1 is Vdata-|Vth|, the drive current of the third transistor T3 is as follows.

$$I=K*(Vgs-Vth)^2=K*[(Vdd-Vd+|Vth|)-Vth]^2 = K*[(Vdd-Vd)]^2$$

Herein, I is the drive current flowing through the third transistor T3, i.e., a drive current for driving the light emitting device L, K is a constant, Vgs is the voltage difference between the gate electrode and the first electrode of the third transistor T3, Vth is the threshold voltage of the third transistor T3, Vd is the data voltage output by the data signal line D, and Vdd is the power voltage output by the first power supply line VDD.

It can be seen from the derivation result of the above formula about current that in the light emitting stage, the driving current of the third transistor T3 is not affected by the threshold voltage of the third transistor T3. Therefore, the influence of the threshold voltage of the third transistor T3 on the driving current is eliminated, which can ensure uniformity of the display brightness of the display product, and improve the overall display effect of the display product.

With continuous development of display technologies, a camera is usually installed on a display device to meet the needs of shooting or face recognition. In order to maximize a screen-to-body ratio, technologies such as fringe screen, water drop screen and in-screen hole have successively came into being. These technologies reduce the area occupied by a camera by digging a hole locally in a display region and placing the camera under a hole-digging region, thus increasing the screen-to-body ratio. However, the above technologies need to dig out part of the display region, which will cause some regions in a display picture to be unable to be displayed, and make it impossible to further improve the screen-to-body ratio. In order to avoid punching holes in the display region and under a premise of ensuring practicability of the display substrate, it is possible to achieve a true full-screen by adopting a pixel drive circuit built-out method or a pixel drive circuit built-in method in the full display with camera (FDC) region.

The pixel drive circuit built-out method means that the pixel drive circuits connected with the light emitting elements in the FDC region is provided in the normal display region, and the light transmittance of the FDC region is improved by arranging the light emitting elements and the pixel drive circuits separately. Because the pixel drive circuit is not provided in the FDC region, there is no light-shielding layer other than the anodes of the light emitting elements in this region, and a higher light transmittance can be achieved. However, in this mode, the pixel drive circuits and the light emitting elements need to be electrically connected through conductive connection lines, the size (e.g., aperture) of the FDC region of the display substrate using the pixel drive circuit built-out method is limited due to the limitation of the space for the arrangement of the conductive connection lines. Increasing the aperture of the FDC region usually requires an increased mask process of the conductive connection lines, resulting in increased cost. Moreover, the material of the conductive connection line is usually a transparent conductive material, such as indium tin oxide (ITO). Due to the large square resistance of ITO, the load of the conductive connection line is large, which easily affects the brightness of the light emitting elements in the FDC region and reduces the brightness of the FDC region, which leads to a display defect in the FDC region, such as a vertical display defect (Mura).

The pixel drive circuit built-in method refers to the provision of light emitting elements and the pixel drive circuit connected with the light emitting elements in the FDC region. Compared with the pixel drive circuit built-out method, the built-in method eliminates the need for long conductive connection lines for the electric connection between the pixel drive circuits and the light emitting elements in the FDC region, which can avoid the display defect of the FDC region caused by the conductive connection lines. Moreover, the built-in method does not limit the size of the FDC region and can support the FDC region with large aperture. However, in the display substrate using the pixel drive circuit built-in method, it is difficult to avoid the light-transmitting region due to the large number of pixel drive circuit signal lines in the FDC region, so the light transmittance of the FDC region will be affected.

In a structure of the pixel drive circuit shown in FIG. 2, when the second transistor T2 is an N-type transistor and the first transistor T1, the third transistor T3 to the eighth transistor T8 are P-type transistors, that is, there are one N-type transistor and seven P-type transistors in the pixel drive circuit, the following problems exist in this structure: on the one hand, because control electrodes of the seven P-type transistors are located in a same conductive layer, sources, drains and channels of the seven P-type transistors are located in a same film layer, this results in limited wiring space for the P-type transistors, causing the pixel drive circuit to occupy a large space. This makes it difficult to increase the PPI (Pixels Per Inch, which can be referred to as pixel density) of the display substrate. Due to the large space occupied by the pixel drive circuit, the light transmittance is affected. On the other hand, because a top gate, a bottom gate and a channel of the N-type transistor collectively occupy three film layers, and just one N-type transistor is provided in a space where these three film layers are located, there is a surplus of space, which results in wasted space to a certain degree on the display substrate.

An exemplary embodiment of the present disclosure provides a display substrate, which may include a base substrate and a plurality of sub-pixels disposed on the base substrate, at least one sub-pixel includes a pixel drive circuit, at least one pixel drive circuit includes a plurality of first-type transistors and a plurality of second-type transistors, and an orthographic projection of at least one first-type transistor on the base substrate is at least partially overlapped with an orthographic projection of at least one second-type transistor on the base substrate.

An embodiment of the present disclosure provides a display substrate wherein an orthographic projection of at least one first-type transistor on the base substrate is at least partially overlapped with an orthographic projection of at least one second-type transistor on the base substrate, which can reduce the area of the pixel drive circuit, save the space of the display substrate, and can increase the light transmittance of the display substrate, or improve the PPI of the display substrate.

As shown in FIG. 4, the display substrate according to an embodiment of the present disclosure may include a base substrate and a plurality of sub-pixels disposed on the base substrate, at least one sub-pixel may include a pixel drive circuit, at least one pixel drive circuit may include a plurality of first-type transistors M1 and a plurality of second-type transistors M2, and an orthographic projection of at least one first-type transistor M1 on the base substrate is at least partially overlapped with an orthographic projection of at least one second-type transistor M2 on the base substrate.

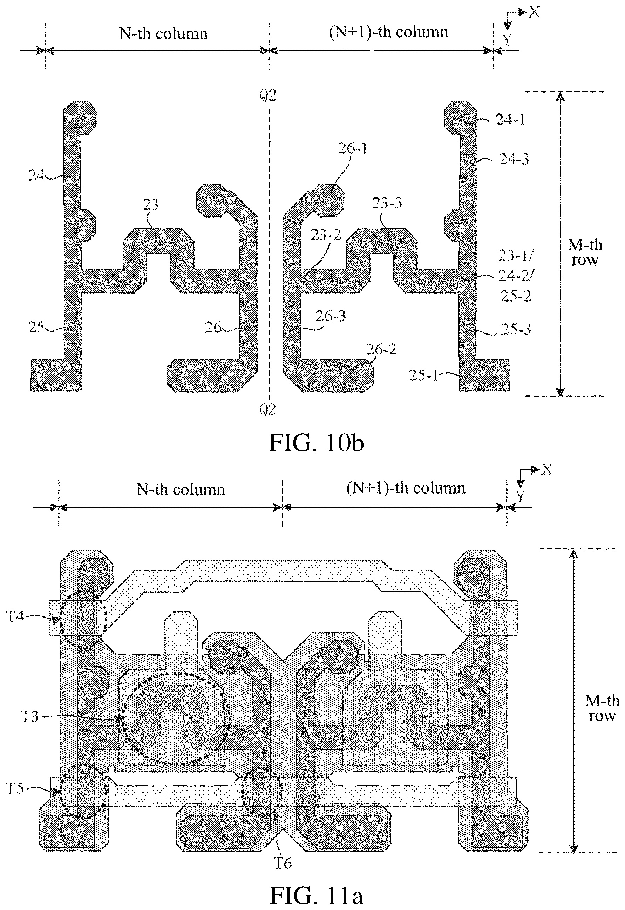

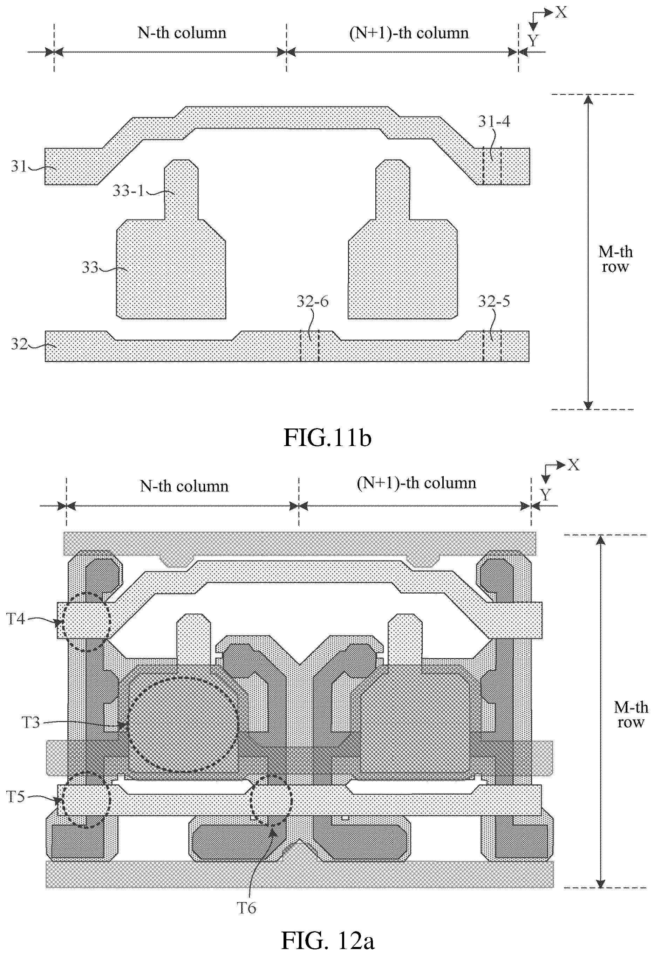

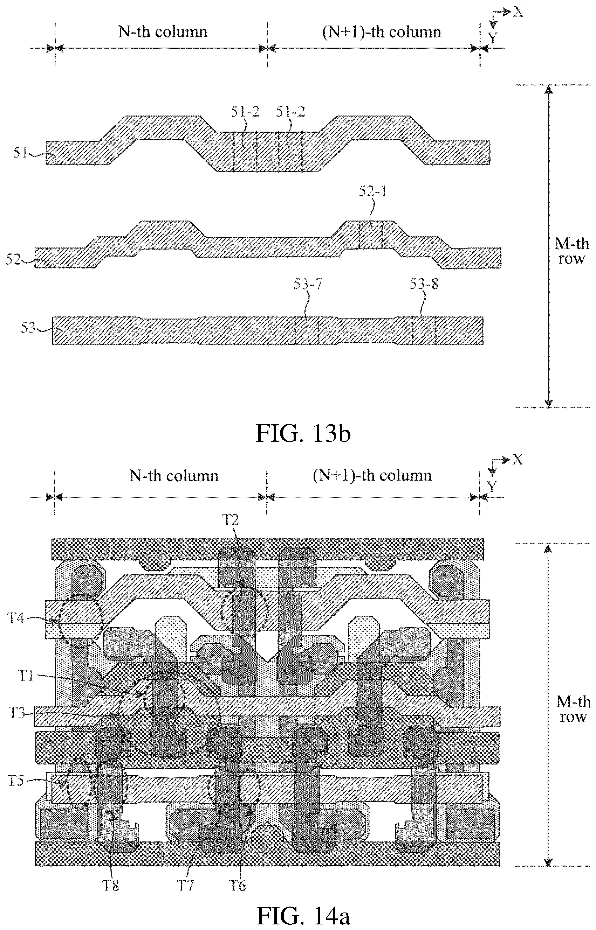

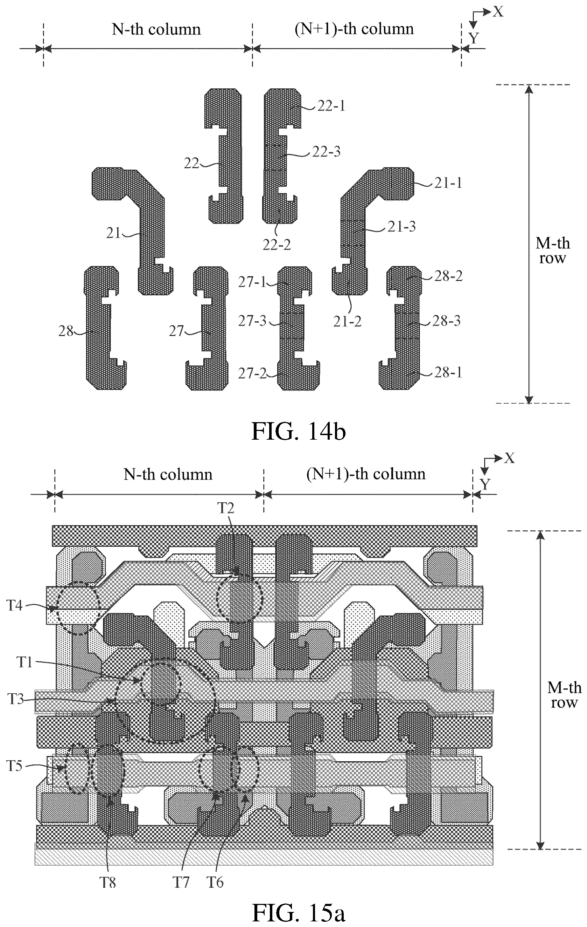

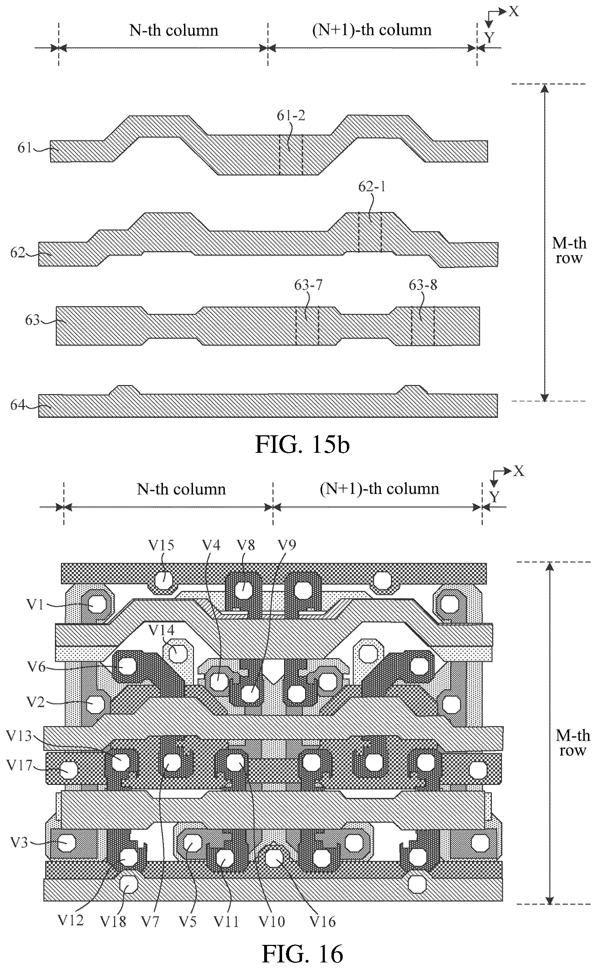

In an exemplary implementation, the display substrate may include a first semiconductor layer, a first conductive layer, a second conductive layer, a third conductive layer, a second semiconductor layer, and a fourth conductive layer sequentially disposed on the base substrate, wherein a first-type transistor M1 may at least include an active layer disposed on the first semiconductor layer (as shown in FIG. 10b), a control electrode disposed on the first conductive layer (as shown in FIG. 11b, which may be referred to as a first gate metal GATE1 layer), and a second-type transistor M2 may include a shield line disposed on the third conductive layer (as shown in FIG. 13b, which may be referred to as a third gate metal GATE3 layer), an active layer disposed on the second semiconductor layer (as shown in FIG. 14b), a control electrode disposed on the fourth conductive layer (as shown in FIG. 15b, which may be referred to as a fourth gate metal GATE4 layer) .

In an exemplary implementation, orthographic projections of active layers of at least some of the first-type transistors M1 (as shown in FIG. 10b) on the base substrate may be at least partially overlapped with orthographic projections of active layers of at least some of the second-type transistors M2 (as shown in FIG. 14b) on the base substrate. In an exemplary implementation, an active layer of each transistor may include a first region, a second region, and a channel region provided between the first region and the second region. In an exemplary implementation, orthographic projections of channel regions of at least some of the first-type transistors M1 (as shown in FIG. 10b) on the base substrate may be at least partially overlapped with orthographic projections of channel regions of at least some of the second-type transistors M2 (as shown in FIG. 14b) on the base substrate.

In an exemplary implementation, orthographic projections of control electrodes of at least some of the first-type transistors M1 on the base substrate may be at least partially overlapped with orthographic projections of control electrodes of at least some of the second-type transistors M2 on the base substrate.

In an exemplary implementation, the first-type transistor M1 may be a low temperature poly silicon thin film transistor (i.e., a P-type transistor), and the second-type transistor M2 may be an oxide thin film transistor (i.e., an N-type transistor).

In an exemplary implementation, as shown in FIG. 4, the first-type transistors M1 may at least include a third transistor T3 as a drive transistor, and the second-type transistors M2 may at least include a first transistor T1 as a first initialization transistor; an orthographic projection of the first transistor T1 on the base substrate is at least partially overlapped with an orthographic projection of the third transistor T3 on the base substrate. In an exemplary implementation, a second electrode of the first transistor T1 may be electrically connected to a second electrode of the third transistor T3, and the first transistor T1 may be configured to provide a first initialization signal to the third transistor T3.

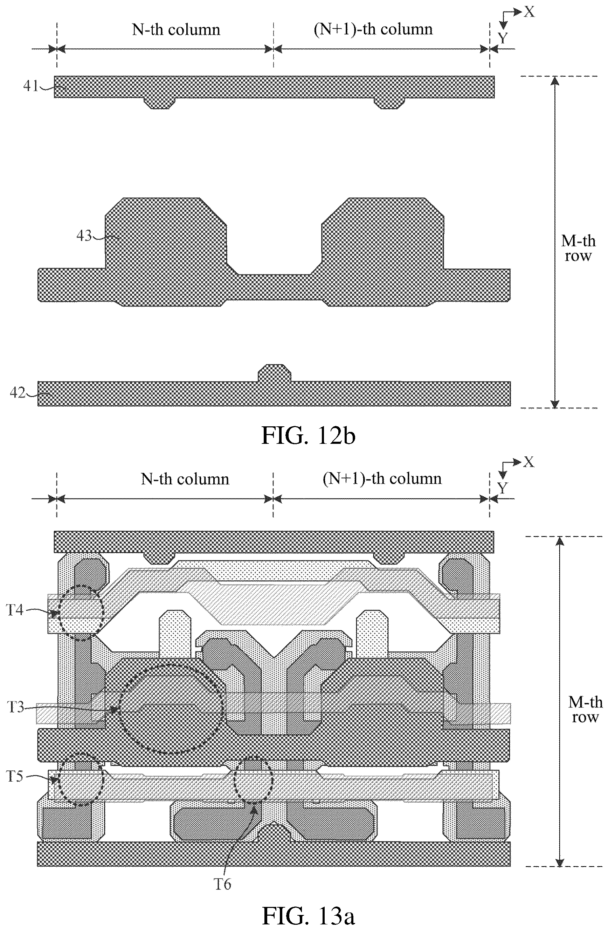

In an exemplary implementation, as shown in FIG. 4, orthographic projections of a control electrode and an active layer of the third transistor T3 on the base substrate are at least partially overlap with orthographic projections of a control electrode and an active layer of the first transistor T1 on the base substrate, respectively. As shown in FIGs. 10b and 14b, an orthographic projection of the active layer 21 of the first transistor T1 on the base substrate may be at least partially overlapped with an orthographic projection of the active layer 23 of the third transistor T3 on the base substrate, for example, an orthographic projection of the channel region 21-3 of the first transistor T1 on the base substrate may be at least partially overlapped with an orthographic projection of the channel region 23-3 of the third transistor T3 on the base substrate. As shown in FIGs. 11b, 13b and 15b, an orthographic projection of the control electrode 33 of the third transistor T3 on the base substrate is at least partially overlapped with an orthographic projection of the control electrode (which may be referred to as a gate, including a bottom gate 52-1 in FIG. 13b and a top gate 62-1 in FIG. 15b) of the first transistor T1 on the base substrate.

In an exemplary implementation, as shown in FIGs. 4, 11b, and 12b, the pixel drive circuit may include a storage capacitor, the storage capacitor may include a first plate 33 and a second plate 43, the first plate 33 may serve as a control electrode of the third transistor T3, and orthographic projections of the first plate 33, the second plate 43, the channel region 23-3 of the active layer 23 of the third transistor T3 and the channel region 21-3 of the active layer 21 of the first transistor T1 on the base substrate are at least partially overlapped.

In an exemplary implementation, as shown in FIG. 4, the first-type transistors M1 may further include a sixth transistor T6 as a light emitting transistor, and the second-type transistors M2 may further include a seventh transistor T7 as a second initialization transistor, and an orthographic projection of the sixth transistor T6 on the base substrate is at least partially overlapped with an orthographic projection of the seventh transistor T7 on the base substrate. In an exemplary implementation, a first electrode of the sixth transistor T6 and a second electrode of the seventh transistor T7 are both electrically connected to the second electrode of the third transistor T3, and the seventh transistor T7 may be configured to provide a second initialization signal to the third transistor T3.

In an exemplary implementation, as shown in FIG. 4, orthographic projections of a control electrode and an active layer of the sixth transistor T6 on the base substrate are at least partially overlapped with orthographic projections of a control electrode and an active layer of the seventh transistor T7 on the base substrate, respectively. As shown in FIGs. 10b and 14b, an orthographic projection of the active layer 26 of the sixth transistor T6 on the base substrate may be at least partially overlapped with an orthographic projection of the active layer 27 of the seventh transistor T7 on the base substrate, for example, an orthographic projection of the channel region 26-3 of the active layer 26 of the sixth transistor T6 on the base substrate may be at least partially overlapped with an orthographic projection of the channel region 27-3 of the active layer 27 of the seventh transistor T7 on the base substrate; an orthographic projection of the second region 26-2 of the active layer 26 of the sixth transistor T6 on the base substrate may be at least partially overlapped with an orthographic projection of the second region 27-2 of the active layer 27 of the seventh transistor T7 on the base substrate. As shown in FIGs. 11b, 13b and 15b, an orthographic projection of the control electrode 32-6 of the sixth transistor T6 on the base substrate is at least partially overlapped with an orthographic projection of the control electrode (which may be referred to as a gate, including a bottom gate 53-7 in FIG. 13b and a top gate 63-7 in FIG. 15b) of the seventh transistor T7 on the base substrate.

In an exemplary implementation, as shown in FIG. 4, the first-type transistors M1 may further include a fourth transistor T4 as a data writing transistor and a fifth transistor T5 as a light emitting transistor, and the second-type transistors M2 may further include a second transistor T2 as a compensation transistor and an eighth transistor T8 as a third initialization transistor; in an exemplary implementation, a second electrode of the fourth transistor T4, a second electrode of the fifth transistor T5, and a second electrode of the eighth transistor T8 are all electrically connected to a first electrode of the third transistor T3, a first electrode of the second transistor T2 is electrically connected to a control electrode of the third transistor T3, and a second electrode of the second transistor is electrically connected to a second electrode of the third transistor T3; in an exemplary implementation, the fourth transistor T4 may be configured to provide a data signal to the third transistor T3, and the second transistor T2 may be configured to provide a compensation signal to the third transistor T3.

In an exemplary implementation, as shown in FIG. 4, an orthographic projection of an active layer of the second transistor T2 on the base substrate is at least partially overlapped with an orthographic projection of an active layer of the sixth transistor T6 on the base substrate. As shown in FIGs. 10b and 14b, an orthographic projection of the active layer 26 of the sixth transistor T6 on the base substrate may be at least partially overlapped with an orthographic projection of the active layer 22 of the second transistor T2 on the base substrate, for example, an orthographic projection of a first region 26-1 of the active layer 26 of the sixth transistor T6 on the base substrate may be at least partially overlapped with an orthographic projection of a second region 22-2 of the active layer 22 of the second transistor T2 on the base substrate.

In an exemplary implementation, as shown in FIG. 4, on a plane parallel to the display substrate, in a first direction X, the fourth transistor T4 and the fifth transistor T5 are located at a side of the first transistor T1 and the third transistor T3, the second transistor T2, the sixth transistor T6, and the seventh transistor T7 are located at the other side of the third transistor T3 and the first transistor T1, and the eighth transistor T8 is located between the fifth transistor T5 and the seventh transistor T7; in a second direction Y, the fourth transistor T4 and the second transistor T2 are located at a side of the third transistor T3, the fifth transistor T5 to the eighth transistor T8 are located at the other side of the third transistor T3, and the first direction X intersects the second direction Y.

In an exemplary implementation, as shown in FIG. 4, at least partial structure of the first-type transistor M1 and at least partial structure of the second-type transistor M2 are located in different conductive layers, an orthographic projection of the at least partial structure of the at least one first-type transistor M1 and an orthographic projection of the at least partial structure of the at least one second-type transistor M2 on the base substrate are at least partially overlapped, the partial structure may include one or more of control electrodes and active layers of transistors (which may include at least some of the first-type transistors M1 and at least some of the second-type transistors M2).

In an exemplary implementation, an orthographic projection of a control electrode of the at least one first-type transistor M1 on the base substrate is at least partially overlapped with an orthographic projection of a control electrode of the at least one second-type transistor M2 on the base substrate. For example, as shown in FIGs. 4, 11a, 11b, 13b, 15a and 15b, an orthographic projection of the control electrode 33 of the third transistor T3 on the base substrate is at least partially overlapped with an orthographic projection of the control electrode (including a top gate electrode 62-1 and a ground gate electrode 52-1) of the first transistor T1 on the base substrate, and an orthographic projection of the control electrode 32-6 of the sixth transistor T6 on the base substrate is at least partially overlapped with an orthographic projection of the control electrode (including a top gate electrode 63-7 and a bottom gate electrode 53-7) of the seventh transistor T7 on the base substrate.

In an exemplary implementation, an orthographic projection of an active layer of the at least one first-type transistor M1 on the base substrate is at least partially overlapped with an orthographic projection of an active layer of the at least one second-type transistor M2 on the base substrate. For example, as shown in FIGs. 4, 10b, 11a, 14a to 15a, the first region 26-1 of the active layer 26 of the sixth transistor T6 may be at least partially overlapped with an orthographic projection of the second region 22-2 of the active layer 22 of the second transistor T2 on the base substrate; orthographic projections of the channel region 27-3 and the second region 27-2 of the active layer 27 of the seventh transistor T7 on the base substrate are at least partially overlapped with orthographic projections of the channel region 26-3 and the second region 26-2 of the active layer 26 of the sixth transistor T6 on the base substrate, and an orthographic projection of the channel region 23-3 of the active layer 23 of the third transistor T3 on the base substrate is at least partially overlapped with an orthographic projection of the channel region 21-3 of the active layer 21 of the first transistor T1 on the base substrate.

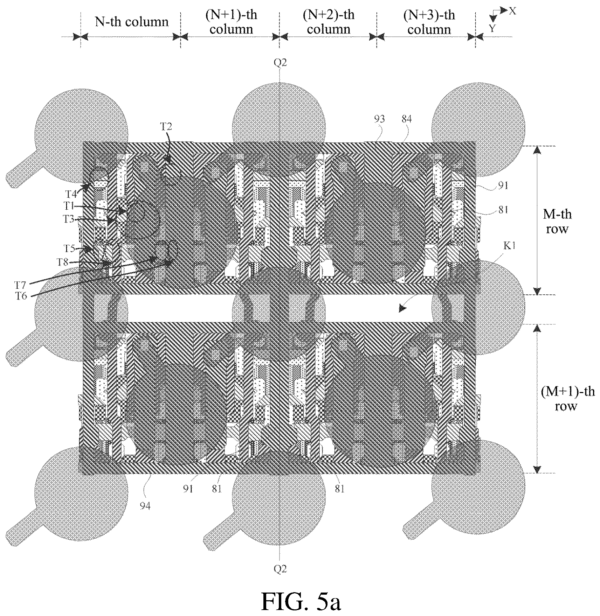

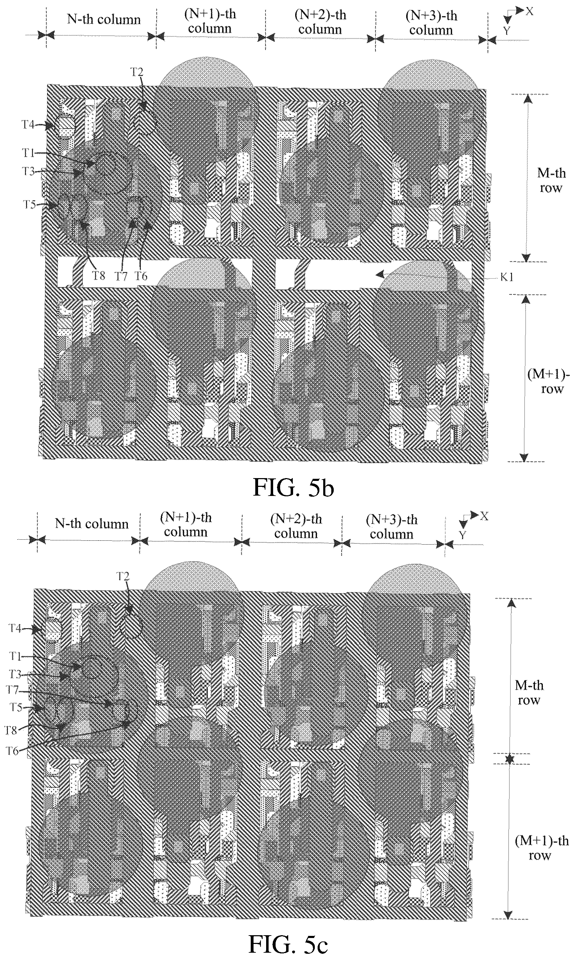

In an exemplary implementation, as shown in FIGs. 5a and 5b, the pixel drive circuits of the plurality of sub-pixels are arranged in a plurality of rows, a light-transmitting region K1 is provided between two adjacent rows of pixel drive circuits, and there is no overlapping region between an orthographic projection of the light-transmitting region K1 on the base substrate and orthographic projections of the pixel drive circuits on the base substrate, so that the pixel drive circuits shielding the light-transmitting region K1 can be avoided. In an exemplary implementation, in a structure in which a full display with camera is not required to be provided, as shown in FIG. 5c, the light-transmitting region K1 may not be provided, and the PPI of the display substrate may be further improved.

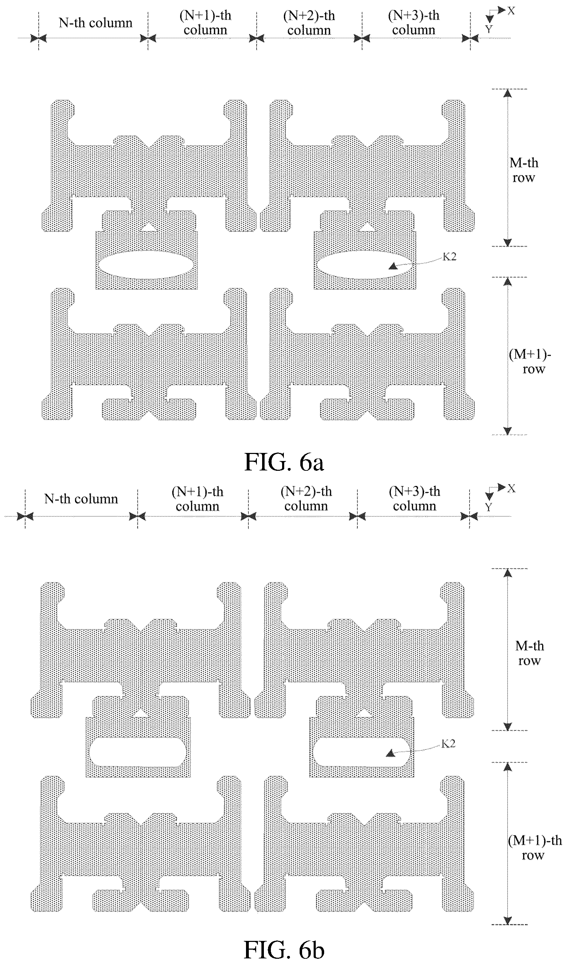

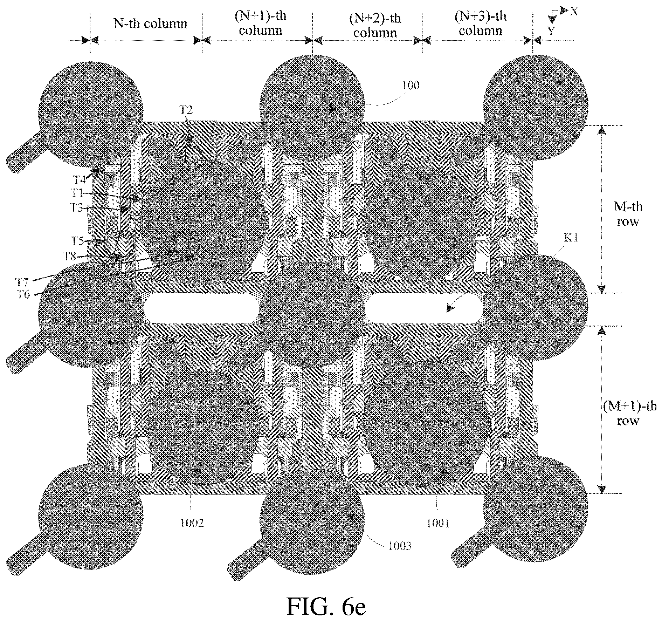

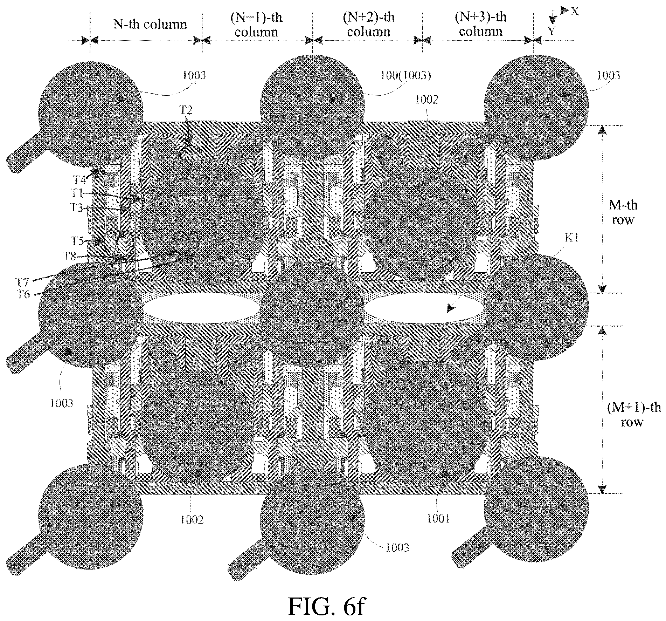

In an exemplary implementation, as shown in FIGs. 6a and 6b, the display substrate may further include a shield layer, which may be located between the base substrate and the pixel drive circuits in a direction perpendicular to the plane on which the display substrate is located, and the shield layer is provided with a light-transmitting opening K2, boundary lines of the light-transmitting opening K2 are smoothly connected with each other, FIGs. 6e and 6f are a schematic diagram of a planar structure of the light-transmitting opening K2 provided in the shield layer in the display substrate, as shown in FIGs. 6a, 6b, 6e, and 6f, a shape of the light-transmitting region K1 in FIGs. 6e and 6f can be consistent with a shape of the light-transmitting opening K2 in the shield layer shown in FIGs. 6a and 6b.

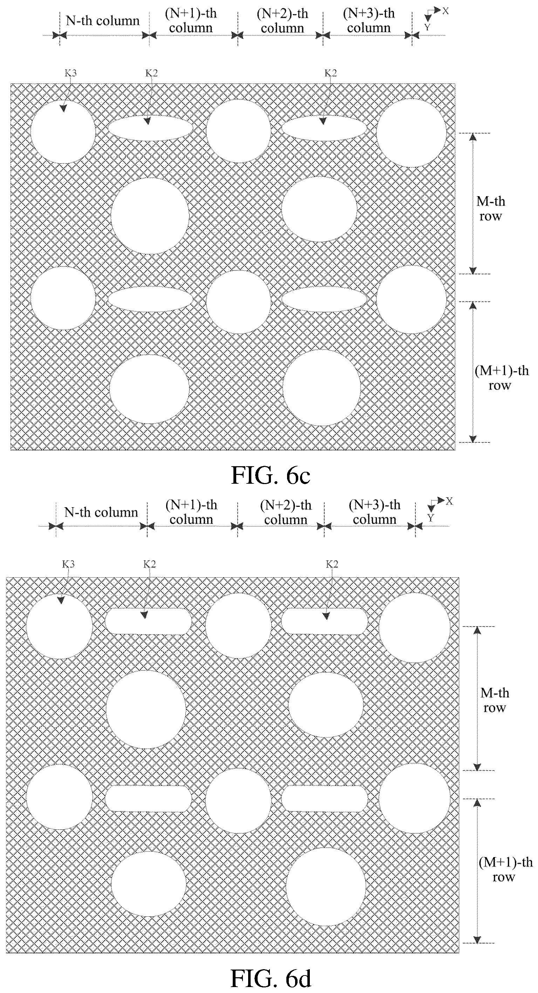

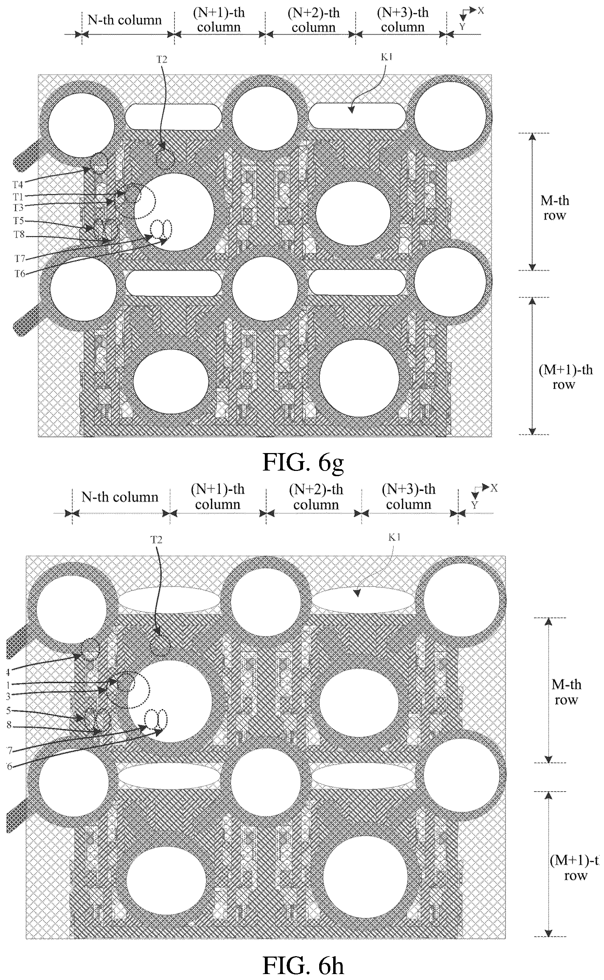

In an exemplary implementation, as shown in FIGs. 6c and 6d, the display substrate may further include a black matrix layer, and the black matrix layer may be located at a side of the pixel drive circuits away from the base substrate in a direction perpendicular to the plane where the display substrate is located, the black matrix layer is provided with a light-transmitting opening K2, and boundary lines of the light-transmitting opening K2 are smoothly connected with each other. FIGs. 6g and 6h are schematic diagrams of a planar structure of the light-transmitting opening K2 provided in the shield layer in the display substrate. As shown in FIGs. 6c, 6d, 6g, and 6h, a shape of the light-transmitting region K1 in FIGs. 6g and 6h can be consistent with a shape of the light-transmitting opening K2 in the black matrix layer shown in FIGs. 6c and 6d. In an exemplary implementation, K3 in FIGs. 6c and 6d is a light-transmitting hole corresponding to a pixel opening, and the black matrix layer may be provided on a side of the encapsulation layer away from the base substrate.

In an exemplary implementation, as shown in FIGs. 6a to 6d, the light-transmitting opening K2 may be in a shape of an ellipse or a polygon, and corners of the polygon are provided with rounded corner structures. As shown in FIGs. 6b and 6d, the light-transmitting opening K2 may be in a shape of a rectangle, and corners of the rectangle are rounded, one pair of opposite sides of the rectangle has a shorter side length, and in the case where the corners are rounded, the shorter pair of opposite sides forms an arc structure.

In an exemplary implementation, as shown in FIGs. 6a to 6h, an orthographic projection of the light-transmitting opening K2 on the base substrate is overlapped with an orthographic projection of the light-transmitting region K1 on the base substrate.

In an exemplary implementation, the light-transmitting opening K2 is provided in the shield layer or the black matrix layer, a shape of the light-transmitting region K1 in the display substrate can be defined by the light-transmitting opening K2, and boundary lines of the light-transmitting opening K2 are smoothly connected with each other, so that diffraction can be reduced, and the display effect can be improved. In an exemplary implementation, the light-transmitting opening K2 may be achieved by one of film layers in the shield layer or the black matrix, or may be achieved by two film layers in combination, for example, the light-transmitting opening K2 in the black matrix layer and the light-transmitting opening K2 in the shield layer may be arranged at intervals, or orthographic projections of the light-transmitting opening K2 in the black matrix layer and the light-transmitting opening K2 in the shield layer on the base substrate at least partially overlap to form the final light-transmitting region K1.

In an exemplary implementation, as shown in FIGs. 6e and 6f, the display substrate may further include an anode conductive layer located at a side of the pixel drive circuits away from the base substrate, the anode conductive layer may include a plurality of anodes 100, each sub-pixel includes at least one anode 100, the anode 100 and the pixel drive circuit in a same sub-pixel are electrically connected to each other, and there is no overlapping region between an orthographic projection of the anode 100 on the base substrate and an orthographic projection of the light-transmitting region K1 on the base substrate.

In an exemplary implementation, as shown in FIGs. 6e and 6f, the plurality of sub-pixels may include a plurality of first sub-pixels, a plurality of second sub-pixels, and a plurality of third sub-pixels, an area of an anode of a first sub-pixel and an area of an anode of a second sub-pixel are each greater than an area of an anode of a third sub-pixel, and orthographic projections of anodes of the first sub-pixel and the second sub-pixel on the base substrate are within a range of an orthographic projection of the pixel drive circuit on the base substrate.

In an exemplary implementation, as shown in FIGs. 6e and 6f, on the plane parallel to the display substrate, anodes 1003 of the plurality of third sub-pixels are arranged in an array, and in a row direction (i.e., the first direction X), the light-transmitting region K1 is located between anodes 1003 of two adjacent columns of third sub-pixels; in a column direction (i.e., the second direction Y), anodes 1001 of the first sub-pixels and anodes 1002 of the second sub-pixels are alternately arranged, and the light-transmitting region K2 may be located between an anode 1001 of a first sub-pixel and an anode 1002 of a second sub-pixel which are adjacent. In an exemplary implementation, the row direction may be the first direction X, and the column direction may be the second direction Y.

In an exemplary implementation, because a light-transmitting region K1 is located in a gap between two adjacent rows of pixel drive circuits, that is, no pixel drive circuit is disposed in a region of the light-transmitting region K1 to avoid blocking caused by the pixel drive circuit, in this case, in the first direction X, the light-transmitting region K1 is disposed between anodes 1003 of two adjacent third sub-pixels, which can increase an area of the light-transmitting region K1 as much as possible; if in the first direction X, the light-transmitting region K1 is disposed between anodes 1001 of two adjacent first sub-pixels, or the light-transmitting region K1 is disposed between anodes 1002 of two adjacent second sub-pixels, or the light-transmitting region K1 is disposed between an anode 1001 of a first sub-pixel and an anode 1002 of a second sub-pixel which are adjacent, because areas of the anode 1001 of the first sub-pixel and the anode 1002 of the second sub-pixel are both greater than an area of the anode 1003 of the third sub-pixel, the area of the light-transmitting region K1 is reduced, and it is difficult to improve the light transmittance of the display substrate. In addition, because orthographic projections of anodes of the first sub-pixel and the second sub-pixel on the base substrate are within a range of an orthographic projection of the pixel drive circuit on the base substrate, the light-transmitting region K1 is disposed between an anode 1001 of a first sub-pixel and an anode 1002 of a second sub-pixel which are adjacent in the column direction (i.e., the second direction Y), the anodes of the first sub-pixel and the second sub-pixel do not occupy the space of the light-transmitting region K1 and do not affect the light transmittance. The light transmittance can be increased as much as possible in a case of a reasonable design of the anodes.

In an exemplary implementation, the display substrate includes a drive circuit layer, the drive circuit layer includes pixel drive circuits of a plurality of sub-pixels, the pixel drive circuit may further include a storage capacitor, and the drive circuit layer includes a first semiconductor layer, a first conductive layer, a second conductive layer, a third conductive layer, a second semiconductor layer, and a fourth conductive layer sequentially disposed on the base substrate in a direction perpendicular to a plane on which the display substrate is located.

The first semiconductor layer at least includes: active layers of the first-type transistors M 1; the first conductive layer at least includes control electrodes of the first-type transistors M1 and a first plate of the storage capacitor; the second conductive layer at least includes: a second plate of the storage capacitor; the third conductive layer at least includes: shield layers of the second-type transistors M2; the second semiconductor layer at least includes: active layers of the second-type transistors M2; the fourth conductive layer at least includes control electrodes of the second-type transistors M2.

In an exemplary implementation, the drive circuit layer may further include a fifth conductive layer located at a side of the fourth conductive layer away from the second semiconductor layer, and the fifth conductive layer at least includes: first electrodes and second electrodes of the first-type transistors M1 and the second-type transistors M2; Orthographic projections of the first plate and the second plate on the base substrate are at least partially overlapped with an orthographic projection of the third transistor T3 on the base substrate, on the plane parallel to the display substrate, in the second direction Y, a side of the first plate close to the second transistor T2 is provided with a connection structure 33-1 (as shown in FIG. 4), an orthographic projection of the connection structure 33-1 on the base substrate does not overlap at least partially with orthographic projections of the storage capacitor and the third transistor T3 on the base substrate, a first electrode of the second transistor T2 is electrically connected with the connection structure through a via, and there is no overlapping region between an orthographic projection of the second transistor T2 on the base substrate an orthographic projection of the storage capacitor on the base substrate.

In an exemplary implementation, the pixel drive circuits of the plurality of sub-pixels are arranged in a plurality of columns, and the drive circuit layer further includes a sixth conductive layer and a seventh conductive layer, the sixth conductive layer is located on a side of the fifth conductive layer away from the fourth conductive layer and the seventh conductive layer located on a side of the sixth conductive layer away from the fifth conductive layer in a direction perpendicular to the plane where the display substrate is located, as shown in FIG. 5a, the sixth conductive layer at least includes: a data signal line 81 electrically connected to first electrodes of the fourth transistors T4 in one column of the columns of pixel drive circuits; the seventh conductive layer at least includes: a first power supply line 91 electrically connected to first electrodes of the fifth transistors T5 and the second plate of the storage capacitor in two adjacent columns of pixel drive circuits.

On the plane parallel to the display substrate, the data signal line 81 and the first power supply line 91 extend along the second direction Y and are arranged at intervals along the first direction X, and the data signal lines 81 of adjacent two columns of pixel drive circuits are located at two sides of the first power supply line 91 electrically connected to the adjacent two columns of pixel drive circuits; two adjacent columns of pixel drive circuits are symmetrically disposed along a second midline Q2-Q2, and the second midline Q2-Q2 is a midline of the two adjacent columns of pixel drive circuits extending along the second direction Y. In an embodiment of the present disclosure, two adjacent data signal lines 81 are separated by the first power supply line 91, and signal crosstalk between the two adjacent data signal lines 81 can be avoided.

In an exemplary implementation, as shown in FIG. 5a, the sixth conductive layer may further include a shielding electrode 84, and the seventh conductive layer may further include a first power supply connection line 93 and a second power supply connection line 94.

On the plane parallel to the display substrate, the first power supply connection line 93 extends along the second direction Y, the second power supply connection line 94 extends along the first direction X, and each second power supply connection line 94 is connected to at least some of the first power supply lines 91; in the first direction, the shielding electrode 84 and the first power supply connection line 93 are located between two adjacent data signal lines 81; in the second direction, the first power supply connection line 93 is located between two adjacent second power supply connection lines 94, and two ends of the first power supply connection line 93 are respectively connected to two adjacent second power supply connection lines 94.

An orthographic projection of the shielding electrode 84 on the base substrate covers an orthographic projection of the connection structure 33-1 on the base substrate; an orthographic projection of the first power supply connection line 93 on the base substrate is at least partially overlapped with an orthographic projection of the shielding electrode 81 on the base substrate, and the first power supply connection line 93 is electrically connected to the shielding electrode 84 through a via.

In an embodiment of the present disclosure, the shielding electrode 84 is located between two adjacent data signal lines 81, which can avoid signal crosstalk between the two adjacent data signal lines 81 on the one hand, and can achieve the first node N1 of the pixel drive circuit (the first node N1 in FIG. 2, which is also a node where the connection structure 33-1 is located) being blocked on the other hand, thereby shielding the influence of other signals on the first node N1 of the pixel drive circuit.

In an embodiment of the present disclosure, the second power supply connection line 94 is interconnected with the first power supply line 91 and the first power supply connection line 93 to form a mesh structure, so that a power supply signal provided by the first power supply line 91 to the display substrate is as consistent as possible, and thus the display uniformity can be improved.

In an exemplary implementation, orthographic projections of the first power supply line 91 and two data signal lines 81 adjacent to the first power supply line 91 on the base substrate may be symmetrical with respect to an orthographic projection of a midline of a main body portion of the anode 1003 of the third sub-pixel extending along the second direction Y on the base substrate, so that the anode 1003 of the third sub-pixel can be located as centrally as possible between the first power supply line 91 and the two data signal lines 81 adjacent to the first power supply line 91, and the area of the light-transmitting region K1 may be increased as much as possible, thereby improving the light transmittance of the display substrate.

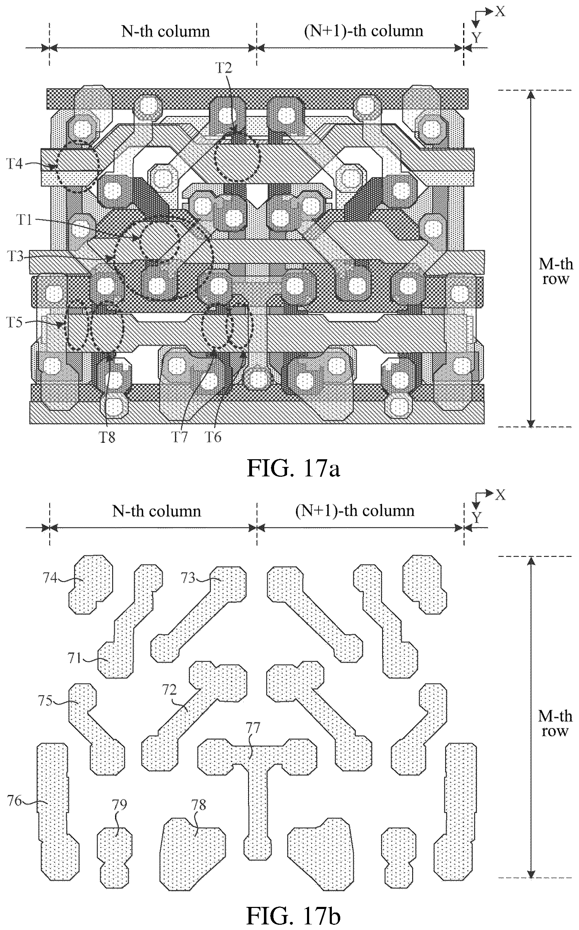

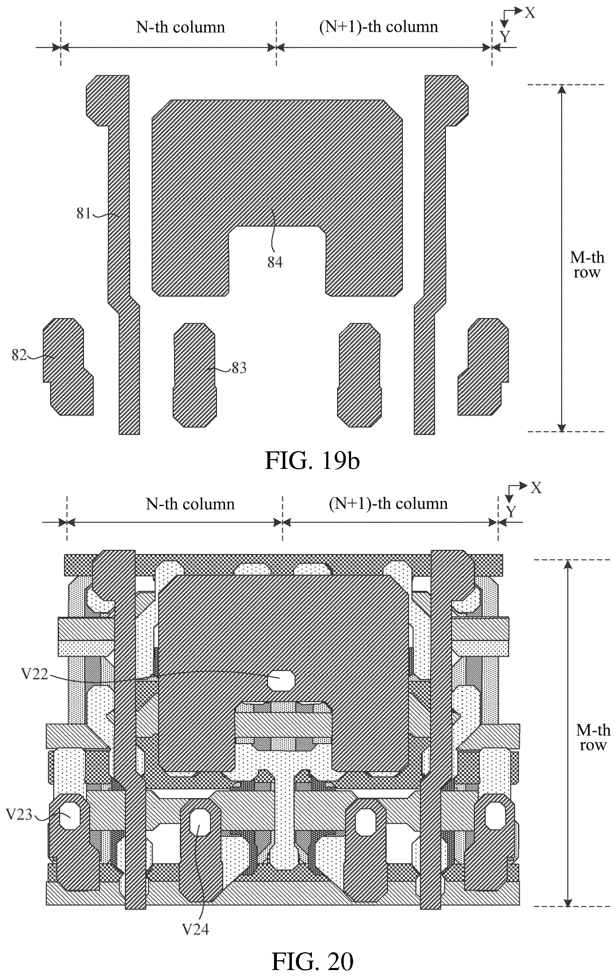

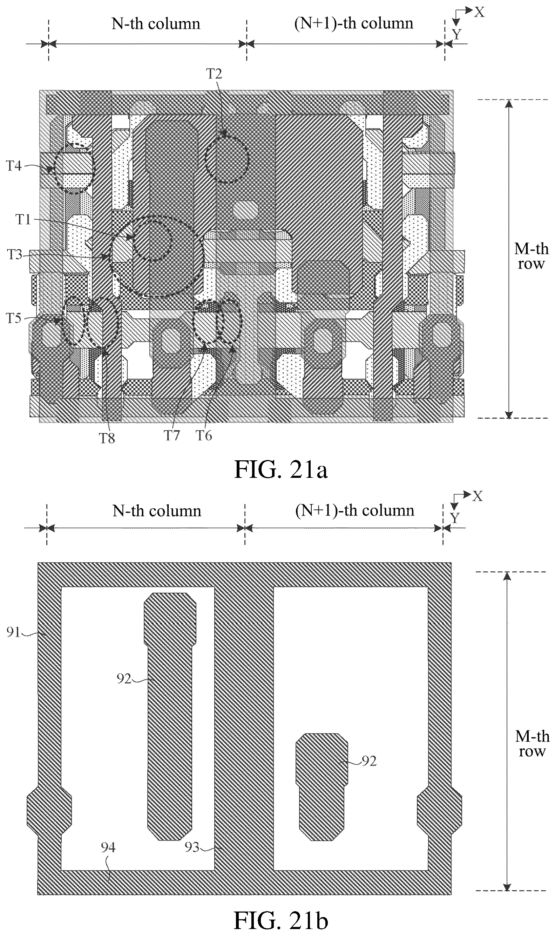

In an exemplary implementation, as shown in FIGs. 6e and 6f, an orthographic projection of the anode 1003 of the third sub-pixel on the base substrate may be at least partially overlapped with orthographic projections of two adjacent rows of pixel drive circuits and a gap between the two adjacent rows of pixel drive circuits on the base substrate. In an exemplary implementation, the orthographic projection of the anode 1003 of the third sub-pixel on the base substrate may be at least partially overlapped with orthographic projections of at least some of film layers in two adjacent rows of pixel drive circuits on the base substrate, for example, at least some of the film layers in the pixel drive circuit can include at least some film layers or all film layers of the first semiconductor layer (as shown in FIG. 10b), the first conductive layer (as shown in FIG. 11b, which can be referred to as a first gate metal GATE1 layer), the second conductive layer (as shown in FIG. 12b, which can be referred to as a second gate metal GATE2 layer), the third conductive layer (as shown in FIG. 13b, which can be referred to as a third gate metal GATE3 layer), the second semiconductor layer (as shown in FIG. 14b), the fourth conductive layer (as shown in FIG. 15b, which can be referred to as a fourth gate metal GATE4 layer), the fifth conductive layer (as shown in FIG. 17b, which can be referred to as a first source-drain metal SD1 layer), the sixth conductive layer (as shown in FIG. 19b, which can be referred to as a second source-drain metal SD2 layer), and the seventh conductive layer (as shown in FIG. 21b, which can be referred to as a third source-drain metal SD3 layer). In an exemplary implementation, there may be no overlapping region between the orthographic projection of the anode 1003 of the third sub-pixel on the base substrate and orthographic projections of the second semiconductor layers in two adjacent rows of pixel drive circuits on the base substrate.

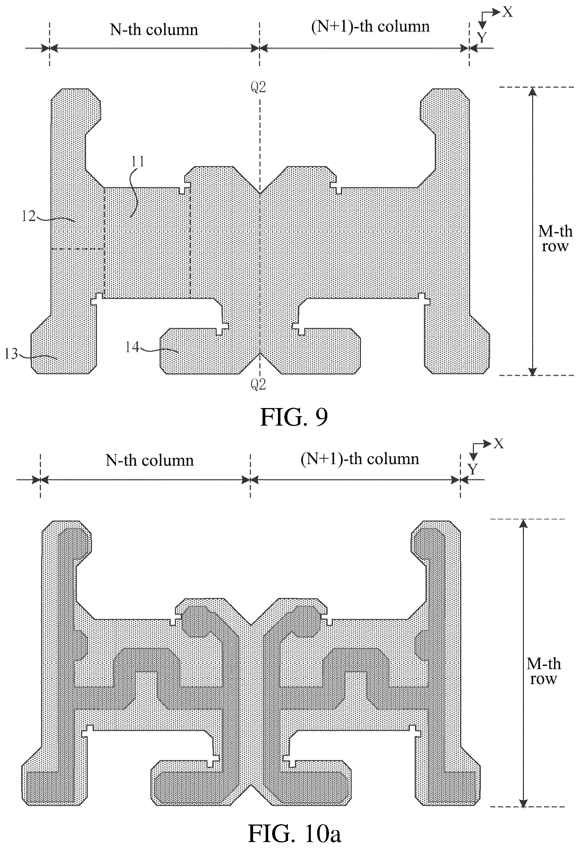

In an exemplary implementation, orthographic projections of the anode 1001 of the first sub-pixel and the anode 1002 of the second sub-pixel on the base substrate may be at least partially overlapped with orthographic projections of at least some of film layers of a corresponding pixel drive circuit on the base substrate. For example, at least some of film layers in the pixel drive circuit can be at least some film layers or all film layers of the first semiconductor layer (as shown in FIG. 10b), the first conductive layer (as shown in FIG. 11b, which can be referred to as a first gate metal GATE1 layer), the second conductive layer (as shown in FIG. 12b, which can be referred to as a second gate metal GATE2 layer), the third conductive layer (as shown in FIG. 13b, which can be referred to as a third gate metal GATE3 layer), the second semiconductor layer (as shown in FIG. 14b), the fourth conductive layer (as shown in FIG. 15b, which can be referred to as a fourth gate metal GATE4 layer), the fifth conductive layer (as shown in FIG. 17b, which can be referred to as a first source-drain metal SD1 layer), the sixth conductive layer (as shown in FIG. 19b, which can be referred to as a second source-drain metal SD2 layer), and the seventh conductive layer (as shown in FIG. 21b, which can be referred to as a third source-drain metal SD3 layer) in the pixel drive circuit. In an exemplary implementation, orthographic projections of the anode 1001 of the first sub-pixel and the anode 1002 of the second sub-pixel on the base substrate may be at least partially overlapped with an orthographic projection of a corresponding shield layer (as shown in FIG. 9) on the base substrate.

An embodiment of the present disclosure further provides a display substrate, which, as shown in FIGs. 6c to 6g, may include a base substrate and a plurality of sub-pixels disposed on the base substrate, a light-transmitting region K1 is provided between at least two adjacent sub-pixels, and boundary lines of the light-transmitting region K1 are smoothly connected with each other.

In the display substrate according to an embodiment of the present disclosure, a light-transmitting region is provided between at least two adjacent sub-pixels, and boundary lines of the light-transmitting region are smoothly connected, which can reduce diffraction, thereby improving the display effect.

In an exemplary implementation, a sub-pixel includes a pixel drive circuit, pixel drive circuits of the plurality of sub-pixels are arranged in a plurality of rows, and a light-transmitting region is located between two adjacent rows of pixel drive circuits, thereby preventing the pixel drive circuits from blocking the light-transmitting region K1.

In an exemplary implementation, as shown in FIGs. 6a and 6b, the display substrate may further include a shield layer, which may be located between the base substrate and the pixel drive circuits in a direction perpendicular to the plane on which the display substrate is located, and the shield layer is provided with a light-transmitting opening K2, boundary lines of the light-transmitting opening K2 are smoothly connected, FIGs. 6e and 6f are a schematic diagram of a planar structure of the light-transmitting opening K2 provided in the shield layer in the display substrate, as shown in FIGs. 6a, 6b, 6e, and 6f, a shape of the light-transmitting region K1 in FIGs. 6e and 6f can be consistent with a shape of the light-transmitting opening K2 in the shield layer shown in FIGs. 6a and 6b.

In an exemplary implementation, as shown in FIGs. 6c and 6d, the display substrate may further include a black matrix layer, and the black matrix layer may be located at a side of the pixel drive circuits away from the base substrate in a direction perpendicular to the plane where the display substrate is located, the black matrix layer is provided with a light-transmitting opening K2, and boundary lines of the light-transmitting opening K2 are smoothly connected. FIGs. 6g and 6h are a schematic diagram of a planar structure of the light-transmitting opening K2 provided in the shield layer in the display substrate. As shown in FIGs. 6c, 6d, 6g, and 6h, a shape of the light-transmitting region K1 in FIGs. 6g and 6h can be consistent with a shape of the light-transmitting opening K2 in the black matrix layer shown in FIGs. 6c and 6d. In an exemplary implementation, K3 in FIGs. 6c and 6d is a light-transmitting hole corresponding to a pixel opening, and the black matrix layer may be provided on a side of the encapsulation layer away from the base substrate.

In an exemplary implementation, as shown in FIGs. 6a to 6d, the light-transmitting opening K2 may be in a shape of an ellipse or a polygon, and corners of the polygon are provided with rounded corner structures. As shown in FIGs. 6b and 6d, the light-transmitting opening K2 may be in a shape of a rectangle, and corners of the rectangle are provided with rounded corner structures, one pair of opposite sides of the rectangle has a shorter side length, and in the case where the corners are provided with rounded corner structures, the shorter pair of opposite sides forms an arc structure.

In an exemplary implementation, as shown in FIGs. 6a to 6h, an orthographic projection of the light-transmitting opening K2 on the base substrate is overlapped with an orthographic projection of the light-transmitting region K1 on the base substrate.

In an exemplary implementation, the light-transmitting opening K2 is provided in the shield layer or the black matrix layer, a shape of the light-transmitting region K1 in the display substrate can be defined by the light-transmitting opening K2, and boundary lines of the light-transmitting opening K2 are smoothly connected, so that diffraction can be reduced, and the display effect can be improved. In an exemplary implementation, the light-transmitting opening K2 may be achieved by one of the shield layer or the black matrix, or may be achieved by the shield layer and the black matrix in combination, for example, the light-transmitting opening K2 in the black matrix layer and the light-transmitting opening K2 in the shield layer may be arranged at intervals, or orthographic projections of the light-transmitting opening K2 in the black matrix layer and the light-transmitting opening K2 in the shield layer on the base substrate at least partially overlap to form the final light-transmitting region K1.

In an exemplary implementation, as shown in FIGs. 6e and 6f, the display substrate may further include an anode conductive layer and a drive circuit layer, the pixel drive circuit is disposed on the drive circuit layer, the anode conductive layer is located at a side of the drive circuit layer away from the base substrate, the anode conductive layer may include a plurality of anodes 100, each sub-pixel includes at least one anode 100, the anode 100 and the pixel drive circuit in a same sub-pixel are electrically connected to each other, and there is no overlapping region between an orthographic projection of the anode 100 on the base substrate and an orthographic projection of the light-transmitting region K1 on the base substrate.

In an exemplary implementation, as shown in FIGs. 6e and 6f, the plurality of sub-pixels may include a plurality of first sub-pixels, a plurality of second sub-pixels, and a plurality of third sub-pixels, an area of an anode of a first sub-pixel and an area of an anode of a second sub-pixel are each greater than an area of an anode of a third sub-pixel, and orthographic projections of anodes of the first sub-pixel and the second sub-pixel on the base substrate are within a range of an orthographic projection of the pixel drive circuit on the base substrate.

In an exemplary implementation, as shown in FIGs. 6e and 6f, on the plane parallel to the display substrate, anodes 1003 of the plurality of third sub-pixels are arranged in an array, and in a row direction (i.e., the first direction X), the light-transmitting region K1 is located between anodes 1003 of two adjacent columns of third sub-pixels; in a column direction (i.e., the second direction Y), anodes 1001 of the first sub-pixels and anodes 1002 of the second sub-pixels are alternately arranged, and the light-transmitting region K2 may be located between an anode 1001 of a first sub-pixel and an anode 1002 of a second sub-pixel which are adjacent. In an exemplary implementation, the column direction may be the second direction Y.

In an exemplary implementation, because a light-transmitting region K1 is located in a gap between two adjacent rows of pixel drive circuits, that is, no pixel drive circuit is disposed in a region of the light-transmitting region K1 to avoid blocking caused by the pixel drive circuit, in this case, in the first direction X, the light-transmitting region K1 is disposed between anodes 1003 of two adjacent third sub-pixels, which can increase an area of the light-transmitting region K1 as much as possible; if in the first direction X, the light-transmitting region K1 is disposed between anodes 1001 of two adjacent first sub-pixels, or the light-transmitting region K1 is disposed between anodes 1002 of two adjacent second sub-pixels, or the light-transmitting region K1 is disposed between an anode 1001 of a first sub-pixel and an anode 1002 of a second sub-pixel which are adjacent, because areas of the anode 1001 of the first sub-pixel and the anode 1002 of the second sub-pixel are both greater than an area of the anode 1003 of the third sub-pixel, the area of the light-transmitting region K1 is reduced, and it is difficult to improve the light transmittance of the display substrate. In addition, because orthographic projections of anodes of the first sub-pixel and the second sub-pixel on the base substrate are within a range of an orthographic projection of the pixel drive circuit on the base substrate, the light-transmitting region K1 is disposed between an anode 1001 of a first sub-pixel and an anode 1002 of a second sub-pixel which are adjacent in the column direction (i.e., the second direction Y), the anodes of the first sub-pixel and the second sub-pixel do not occupy the space of the light-transmitting region K1 and do not affect the light transmittance. The light transmittance can be increased as much as possible with a reasonable design of the anodes.

An embodiment of the present disclosure further provides a display substrate, as shown in FIG. 5a, including a base substrate, a plurality of pixels, a plurality of data signal lines 81, and a plurality of first power supply lines 91 provided on the base substrate, and on a plane parallel to the display substrate, the plurality of data signal lines 81 and the plurality of first power supply lines 91 extend along the second direction Y and are arranged at intervals along the first direction X, and the first direction X intersects with the second direction Y.

At least some of the sub-pixels include pixel drive circuits, the pixel drive circuits of the plurality of sub-pixels are arranged in a plurality of columns, each data signal line 81 is electrically connected to at least some of pixel drive circuits in one column of the columns of pixel drive circuits, each first power supply line 91 is electrically connected to at least some of pixel drive circuits in one column of the columns of pixel drive circuits, and two adjacent data signal lines 81 are located at two sides of the first power supply line 91 in the first direction X.

In the display substrate according to an embodiment of the present disclosure, two adjacent data signal lines 81 are separated by the first power supply line 91, and signal crosstalk between the two adjacent data signal lines 81 can be avoided.

In an exemplary implementation, as shown in FIG. 5a, each first power supply line 91 is electrically connected to two adjacent columns of pixel drive circuits, and the two adjacent columns of pixel drive circuits are symmetrically disposed along a second midline Q2-Q2, which is a midline of the two adjacent columns of pixel drive circuits extending along the second direction Y.

In an exemplary implementation, as shown in FIG. 5a, the pixel drive circuit may further include a shielding electrode 84 disposed between two adjacent data signal lines 81 in the first direction X, and the data signal line 81 is located between the shielding electrode 84 and the first power supply line 91 in a same column of pixel drive circuits. In an embodiment of the present disclosure, the shielding electrode 84 is located between two adjacent data signal lines 81, and signal crosstalk between the two adjacent data signal lines 81 can be avoided.

In an exemplary implementation, as shown in FIG. 5a, the display substrate may further include a first power supply connection line 93 and a second power supply connection line 94, the first power supply connection line 93 extends along the second direction Y and the second power supply connection line 94 extends along the first direction X on the plane parallel to the display substrate, and each second power supply connection line 94 is connected to at least some of the first power supply lines 91.

In the first direction X, the first power supply connection line 93 is located between two adjacent data signal lines 81; in the second direction Y, the first power supply connection line 93 is located between two adjacent second power supply connection lines 94, and two ends of the first power supply connection line 93 are respectively connected to two adjacent second power supply connection lines 94.

The shielding electrode 84 and the data signal line 81 are located in a same conductive layer, the first power supply line 91, the first power supply connection line 93, and the second power supply connection line 94 are located in a same conductive layer, and the data signal line 81 and the first power supply line 91 are located in different conductive layers; an orthographic projection of the first power supply connection line 93 on the base substrate is at least partially overlapped with an orthographic projection of the shielding electrode 84 on the base substrate, and the first power supply line 91 and the shielding electrode 84 are electrically connected through a via.

In an embodiment of the present disclosure, the second power supply connection line 94 is interconnected with the first power supply line 91 and the first power supply connection line 93 to form a mesh structure, so that a power supply signal provided by the first power supply line 91 to the display substrate is as consistent as possible, and thus the display uniformity can be improved.

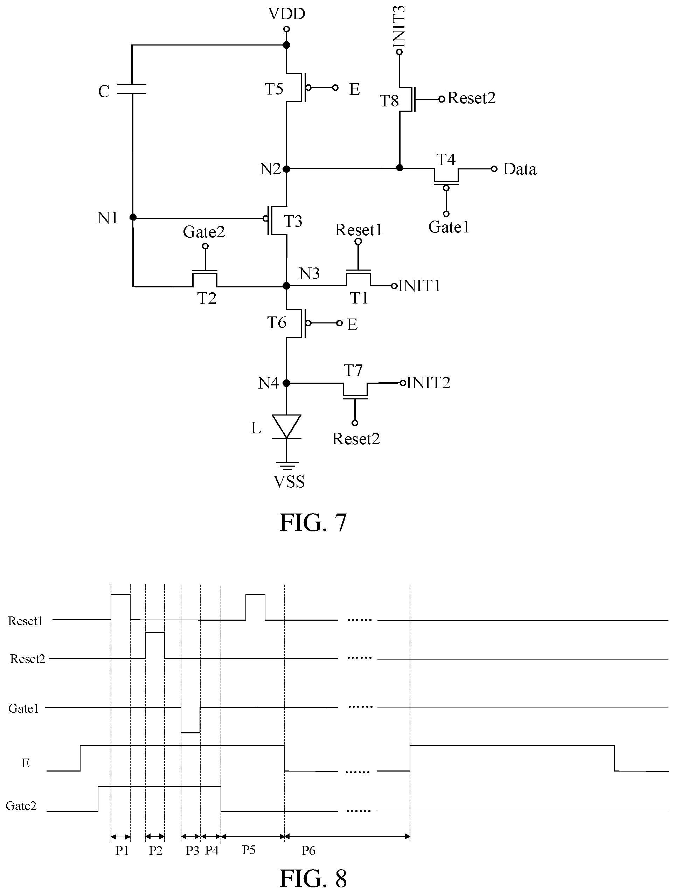

In the display substrate according to an embodiment of the present disclosure, the equivalent circuit of the pixel drive circuit may be as shown in FIG. 7. The difference between FIG. 7 and FIG. 2 is that the first transistor T1, the seventh transistor T7, and the eighth transistor T8 are N-type transistors, and FIG. 8 is a working timing diagram of the pixel drive circuit provided in FIG. 7. In an exemplary implementation, the working process of the pixel drive circuit shown in FIG. 7 may include the first stage to the sixth stage.

In a first stage P1, referred to as a first reset stage, a signal of the first reset line Reset1 is a low-level signal, and signals of the second reset line Reset2, the first scan line Gate1, the second scan line Gate2, and the light emitting line E are high-level signals. The signal of the second reset line Reset2 is a high-level signal, so that the seventh transistor T7 and the eighth transistor T8 are turned on, and a signal of the second initial signal line INIT2 is provided to the fourth node N4, to initialize (reset) a first electrode of the light emitting device L and clear an original charge in the first electrode of the light emitting device L. A signal of the third initial signal line INIT3 is provided to the second node N2, to initialize (reset) the second node N2 and clear an original charge in the second node N2. In this stage, the third transistor T3 is turned on. A signal of the second scan line Gate2 is a high-level signal, and the second transistor T2 is turned on. A signal of the second node N2 is provided to the first node N1 and the third node N3, the first node N1 and the third node N3 are initialized, a signal of the first reset line Reset1 is a low-level signal, signals of the first scan line Gate1 and the light emitting line E are high-level signals, and the first transistor T1, the fourth transistor T4, the fifth transistor T5, and the sixth transistor T6 are turned off. The light emitting device L does not emit light in this stage.

In a second stage P2, referred to as a second reset stage, and a signal of the second reset line Reset 2 is a low-level signal, and signals of the first reset line Reset 1, the first scan line Gate 1, the second scan line Gate 2, and the light emitting line E are high-level signals. The signal of the first reset line Reset1 is a high-level signal, so that signals of the first transistor T1 and the first initial signal line INIT1 are provided to the third node N3, to initialize (reset) the third node N3 again, and clear an original charge in the third node N3. In this stage, the third transistor T3 is continuously turned on. A signal of the second scan line Gate2 is a high-level signal, and the second transistor T2 is turned on. A signal of the third node N3 is provided to the first node N1, to initialize the first node N1 continuously, a signal of the second reset line Reset2 is a low-level signal, signals of the first scan line Gate1 and the light emitting line E are high-level signals, and the fourth transistor T4, the fifth transistor T5, the sixth transistor T6, the seventh transistor T7, and the eighth transistor T8 are turned off. The light emitting device L does not emit light in this stage.

In a third stage P3, referred to as a data writing stage or a threshold compensation stage, a signal of the first scan line Gate1 is a low-level signal, signals of the first reset line Reset1 and the second reset line Reset2 are low-level signals, and signals of the second scan line Gate2 and the light emitting line E are high-level signals. The data line Data outputs a data voltage. In this stage, the third transistor T3 is continuously turned on. The signal of the first scan line Gate1 is a low-level signal, so that the fourth transistor T4 is turned on. A signal of the second scan line Gate2 is a high-level signal, and the second transistor T2 is turned on. The data voltage outputted from the data line Data is provided to the first node N1 through the turned-on fourth transistor T4, the second node N2, the turned-on third transistor T3, the third node N3, and the turned-on second transistor T2, and the difference between the data voltage outputted from the data line Data and the threshold voltage of the third transistor T3 is charged into the capacitor C, the voltage at the second end of the capacitor C (the first node N1) is Vd-|Vth|, Vd is the data voltage outputted from the data line Data, and Vth is the threshold voltage of the third transistor T3. Signals of the first reset line Reset1 and the second reset line Reset2 are low-level signals, a signal of the light emitting line E is a high-level signal, and the first transistor T1, the fifth transistor T5, the sixth transistor T6, the seventh transistor T7, and the eighth transistor T8 are turned off. The light emitting device L does not emit light in this stage.

In a fourth stage P4, referred to as a continuous compensation stage, signals of the first reset line Reset1 and the second reset line Reset2 are low-level signals, and signals of the first scan line Gate1, the second scan line Gate2 and the light emitting line E are high-level signals. A signal of the second scan line Gate2 is a high-level signal, the second transistor T2 is continuously turned on, signals of the first reset line Reset1 and the second reset line Reset2 are low-level signals, signals of the first scan line Gate1 and the light emitting line E are high-level signals, and the first transistor T1, the fourth transistor T4, the fifth transistor T5, the sixth transistor T6, the seventh transistor T7, and the eighth transistor T8 are turned off. Although the signal of the data line Data is stopped to write, signals of the second node N2 is still provided to the first node N1 through the turned-on third transistor T3, the third node N3, and the turned-on second transistor T2, to continuously compensate the threshold voltage of the third transistor T3.

In a fifth stage P5, referred to as a bias stage, signals of the first reset line Reset1 and the second scan line Gate2 are low-level signals, and signals of the second reset line Reset2, the first scan line Gate1 and the light emitting line E are high-level signals. Signals of the first reset line Reset1 and the second scan line Gate2 are low-level signals, and signals of the first scan line Gate1 and the light emitting line E are high-level signals, and the first transistor T1, the second transistor T2, the fourth transistor T4, the fifth transistor T5, and the sixth transistor T6 are all turned off. A signal of the second reset line Reset2 is a high-level signal, the seventh transistor T7 and the eighth transistor T8 are turned on, the signal of the third initial signal line INIT3 is written to the second node N2 and the third node N3, and the signal of the second initial signal line INIT2 is written to the fourth node N3. In this stage, the third transistor T3 is in a biased state, and the light emitting device L does not emit light.

In a sixth stage P6, referred to as a light emitting stage, and signals of the first reset line Reset 1, the second reset line Reset 2, the light emitting line E, and the second scan line Gate 2 are low-level signals, and a signal of the first scan line Gate 1 is a high-level signal. A signal of the light emitting signal line E is a low-level signal, so that the fifth transistor T5 and the sixth transistor T6 are turned on, and a power supply voltage outputted from the first power supply line VDD provides a driving voltage to a first electrode of the light emitting device L through the fifth transistor T5, the third transistor T3 and the sixth transistor T6 which are turned on, so as to drive the light emitting device L to emit light.

A "patterning process" mentioned in the present disclosure includes photoresist coating, mask exposure, development, etching, photoresist stripping, etc., for a metal material, an inorganic material, or a transparent conductive material, and includes organic material coating, mask exposure, development, etc., for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a material on a base substrate (or substrate) using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. "A and B are arranged in a same layer" in the present disclosure means that A and B are formed simultaneously through a same patterning process, and a "thickness" of a film is a dimension of the film in a direction perpendicular to a display substrate. In an exemplary implementation of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A is overlapped with the boundary of the orthographic projection of B. Exemplary description is made below through a preparation process of a display substrate.

In some examples, the preparing process of the display substrate may include the following operations. Hereinafter, the drive circuit layer (which may be referred to as a circuit structure layer) in the display region AA will be described. The example is explained by taking a case that a first pixel drive circuit has the aforementioned 8T1C structure. The connection relationship between eight transistors and a storage capacitor in each first pixel drive circuit can refer to the equivalent circuit diagram shown in FIG. 7.

(101) A substrate is provided. In an exemplary implementation, the substrate may be referred to as a base substrate. In some examples, the substrate may be a rigid base substrate or a flexible base substrate. For example, the rigid substrate may be made of, but not limited to, one or more of glass and quartz. The flexible substrate may be made of, but not limited to, one or more of polyethylene terephthalate, ethylene terephthalate, polyether ether ketone, polystyrene, polycarbonate, polyarylate, polyarylester, polyimide, polyvinyl chloride, polyethylene, and textile fibers. In some examples, the flexible base substrate may include a first flexible material layer, a first inorganic material layer, a second flexible material layer and a second inorganic material layer which are stacked. The first flexible material layer and the second flexible material layer may be made of a material such as Polyimide (PI), Polyethylene Terephthalate (PET), or a polymer soft film on which surface treatment is performed, and a material of the first inorganic material layer and the second inorganic material layer may be Silicon Nitride (SiNx,x>0) or Silicon Oxide (SiOy,y>0), etc., which are used to improve resistance to water and oxygen of the base substrate.

(102) A pattern of a shield layer is formed. In an exemplary implementation, forming the pattern of the shield layer may include: depositing a conductive thin film of the shield layer on the base substrate, patterning the conductive thin film of the shield layer through a patterning process, and forming the pattern of the shield layer on the base substrate, as shown in FIG. 9, which is a planar structure view of the pattern of the shield layer in two sub-pixels.

In an exemplary implementation, the pattern of the shield layer of each sub-pixel may include a first shield structure 11, a second shield structure 12, a third shield structure 13 and a fourth shield structure 14.

In an exemplary implementation, the first shield structure 11 may be in a shape of a rectangle, the second shield structure 12 and the third shield structure 13 may be in a shape of a bending line extending along the second direction Y, and the fourth shield structure 14 may be in a shape of an "L". In the second direction Y, the second shield structure 12 and the third shield structure 13 may be sequentially arranged. In the first direction X, the fourth shield structure 14 may be located at one side of the first shield structure 11, and the second shield structure 12 and the third shield structure 13 may be located at the other side of the first shield structure 11.

In an exemplary implementation, the second connection structure 12 to the fourth connection structure 14 of each sub-pixel are connected to the first connection structure 11 to form an interconnected integral structure.

In an exemplary implementation, the shapes of the shield layers in the two adjacent columns of sub-pixels may be symmetrical along a second midline Q2-Q2, and the second midline Q2-Q2 may be a midline of the two adjacent columns of sub-pixels extending along the second direction Y. In an exemplary implementation, in a same row of sub-pixels, a plurality of shield layers form a plurality of shield structure groups, shield layers of two adjacent sub-pixels are included in a same shield structure group, and the fourth shield structures 14 located in a same shield structure group are interconnected to be an integral structure, thus ensuring that the shield layers of two adjacent sub-pixels in the display substrate have a same potential, which is beneficial to improving uniformity of the panel, avoiding a display defect of the display substrate and ensuring a display effect of the display substrate. For example, in an M-th row of sub-pixels, the fourth shield structures 14 in sub-pixels in an N-th column and an (N+1)-th column may be interconnected to be an integral structure.

In an exemplary implementation, the pattern of the shield layer may be formed after the preparation of the second flexible material (PI2) layer, that is, the pattern of the shield layer may be configured to be prepared on the second flexible material (PI2) layer, and after the preparation of the pattern of the shield layer is completed, the second barrier (Barrier2) layer is prepared; alternatively, the pattern of the shield layer may be formed after the first flexible material (PI1) layer is prepared, that is, the pattern of the shield layer may be configured to be prepared on the first flexible material (PI1) layer, and after the preparation of the pattern of the shield layer is completed, the second flexible material (PI2) layer is prepared, which is not limited in embodiments of the present disclosure.

(103) A pattern of a first semiconductor layer is formed. In an exemplary implementation, forming the pattern of the first semiconductor layer may include: depositing sequentially a first insulation thin film and a first semiconductor thin film on the substrate, and patterning the first semiconductor thin film through a patterning process to form a first insulation layer covering the pattern of the shield layer, and the pattern of the first semiconductor layer disposed on the first insulation layer, as shown in FIGs. 10a and 10b, and FIG. 10b is a schematic plan view of the first semiconductor layers of two sub-pixels in FIG. 10a.

In an exemplary implementation, the pattern of the first semiconductor layer of each sub-pixel may include the active layer 23 of the third transistor T3 to the active layer 26 of the sixth transistor T6 and the active layer 23 of the third transistor T3 to the active layer 26 of the sixth transistor T6 are of an interconnected integral structure.

In an exemplary implementation, in the first direction X, an active layer 24 of the fourth transistor T4 and an active layer 25 of the fifth transistor T5 are located at a same side of the active layer 23 of the third transistor T3, and the active layer 26 of the sixth transistor T6 is located at the other side of the active layer 23 of the third transistor T3; in the second direction Y, the active layer 24 of the fourth transistor T4 and the active layer 25 of the fifth transistor T5 are located at two sides of the active layer 23 of the third transistor T3, and the active layer 25 of the fifth transistor T5 and the second region 26-2 of the active layer 26 of the sixth transistor T6 are located at a same side of the active layer 23 of the third transistor T3, and the active layer 24 of the fourth transistor T4 and the first region 26-1 of the sixth transistor T6 are located at a same side of the active layer 23 of the third transistor T3.

In an exemplary implementation, description is given by taking a sub-pixel in an M-th row and an N-th column as an example: in the first direction X, the active layer 24 of the fourth transistor T4 and the active layer 25 of the fifth transistor T5 are located at a side of the active layer 23 of the third transistor T3 away from an (N+1)-th column of sub-pixels, and the active layer 26 of the sixth transistor T6 is located at a side of the active layer 23 of the third transistor T3 away from an (N-1)-th column of sub-pixels; in the second direction Y, the active layer 24 of the fourth transistor T4 is located at a side of the active layer 23 of the third transistor T3 away from an (M+1)-th row of sub-pixels, and the active layer 25 of the fifth transistor T5 is located at a side of the active layer 23 of the third transistor T3 away from an (M-1)-th row of sub-pixels.

In an exemplary implementation, the active layer 23 of the third transistor T3 may be in a shape of a "Ω" or a shape of a " $\int \mathsf{L}$ ", the active layer 24 of the fourth transistor T4 may be in an "I" shape, the active layer 25 of the fifth transistor T5 may be in a shape of an "L", and the active layer 26 of the sixth transistor T6 may be in a shape of a bending line extending along the second direction Y or may be in a shape of an "L".

In an exemplary implementation, an active layer of each transistor may include a first region, a second region, and a channel region located between the first region and the second region. In an exemplary implementation mode, a first region 23-1 of the active layer 23 of the third transistor T3 may serve as a second region 24-2 of the active layer 24 of the fourth transistor T4 and a second region 25-2 of the active layer 25 of the fifth transistor T5, a second region 23-2 of the active layer 23 of the third transistor T3 may serve as a first region 26-1 of the active layer 26 of the sixth transistor T6, and a first region 24-1 of the active layer 24 of the fourth transistor T4, a first region 25-1 of the active layer 25 of the fifth transistor T5, and a first region 26-1 and a second region 26-2 of the active layer 26 of the sixth transistor T6 may be separately provided. In an exemplary implementation, a channel region 23-3 of the active layer 23 of the third transistor T3 may be located between a first region 23-1 and a second region 23-2 of the active layer 23 of the third transistor T3, a channel region 24-3 of the active layer 24 of the fourth transistor T4 may be located between the first region 24-1 and the second region 24-2 of the active layer 24 of the fourth transistor T4, a channel region 25-3 of the active layer 25 of the fifth transistor T5 may be located between the first region 25-1 and the second region 25-2 of the active layer 25 of the fifth transistor T5, and a channel region 26-3 of the active layer 26 of the sixth transistor T6 may be located between the first region 26-1 and the second region 26-2 of the active layer 26 of the sixth transistor T6.

In an exemplary implementation, shapes of the semiconductor layers in two adjacent columns of sub-pixels may be symmetrical along the second midline Q2-Q2. In an exemplary implementation, the first semiconductor layer may be made of polysilicon (p-Si), i.e., the fourth transistor T4 to the sixth transistor T6 may be LTPS thin film transistors. In an exemplary implementation, patterning the first semiconductor thin film through the patterning process may include: forming an amorphous silicon (a-si) thin film on the first insulation thin film, dehydrogenating the amorphous silicon thin film, and crystallizing the dehydrogenated amorphous silicon thin film to form a polysilicon thin film. Subsequently, the polysilicon thin film is patterned to form the pattern of the first semiconductor layer.

(104) Forming a pattern of a first conductive layer. In an exemplary implementation, forming the pattern of the first conductive layer may include: sequentially depositing a second insulation thin film and a first conductive thin film on the base substrate where the above-mentioned patterns are formed, and patterning the first conductive thin film through a patterning process to form a second insulation layer that covers the pattern of the first semiconductor layer and the pattern of the first conductive layer disposed on the second insulation layer, as shown in FIG. 11a and FIG. 11b, FIG. 11b is a planar schematic view of the first conductive layer in FIG. 11a. In an exemplary implementation, the first conductive layer may be referred to as a first gate metal (GATE1) layer.

In an exemplary implementation, the pattern of the first conductive layer may at least include: a first scan signal line 31 (i.e., a first scan line Gate1 in FIG. 7), a light emitting control line 32 (i.e., a light emitting line E in FIG. 7), a first plate 33 of the storage capacitor (which may serve as a control electrode of the third transistor T3), and the first scan signal line 31 and a main body portion of the light emitting control line 32 may extend along the first direction X.

In an exemplary implementation, in the second direction Y, the first scan signal line 31 and the light emitting control line E are located at two sides of the first plate 33 of the storage capacitor, for example, in a same sub-pixel, the first scan signal line 31, the first plate 33 of the storage capacitor, and the light emitting control line 32 may be arranged along the second direction Y.

Taking a sub-pixel in an M-th row and an N-th column as an example, in the second direction Y, in a same sub-pixel, the light emitting control line 32 may be located on a side of a first electrode plate 33 of a storage capacitor close to a sub-pixel of an (M+1)-th row; the first scan signal line 31 may be located on a side of the first electrode plate 33 of the storage capacitor close to a sub-pixel of an (M-1)-th row.

In an exemplary implementation mode, in the second direction Y, the first electrode plate 33 may be located between the light emitting control line 32 and the first scan signal line 31, the first electrode plate 33 may be in a rectangular shape, corners of the rectangular shape may be provided with chamfers, and there is an overlapping region between an orthographic projection of the first electrode plate 33 on the base substrate and an orthographic projection of the active layer of the third transistor T3 on the base substrate. In an exemplary implementation, the first plate 33 may simultaneously serve as a plate of the storage capacitor and the control electrode of the third transistor T3. In an exemplary implementation, a connection structure 33-1 is provided on a side of the first plate 33 close to the first scan signal line 31.

In an exemplary implementation, the first scan signal line 31 may be in a structure of bending line extending along the first direction X, and the first scan signal line 31 may bypass the connection structure 33-1 disposed on the first plate 33 of the storage capacitor along an opposite direction of the second direction Y. In an exemplary embodiment, a region where the first scan signal line 31 is overlapped with the active layer 24 of the fourth transistor T4 may serve as a control electrode 31-4 of the fourth transistor T4.

In an exemplary implementation, a region where the light emitting control line 32 is overlapped with an active layer of the fifth transistor T5 may serve as a control electrode 32-5 of the fifth transistor T5, and a region where the light emitting control line 32 is overlapped with an active layer of the sixth transistor T6 may serve as a control electrode 32-6 of the sixth transistor T6.

In an exemplary implementation, shapes of the first conductive layers in two adjacent columns of sub-pixels may be symmetrical along the second midline Q2-Q2. In an exemplary implementation mode, the light emitting control lines 32 may be designed with an equal width or with non-equal widths, thereby not only a layout of a pixel structure may be facilitated, but also a parasitic capacitance between signal lines may be reduced.

In an exemplary implementation, after the pattern of the first conductive layer is formed, a conductive processing may be performed on the first semiconductor layer by using the first conductive layer as a shield, the first semiconductor layer in which a region is shielded by the first conductive layer forms channel regions of the third transistor T3 to the sixth transistor T6, and a semiconductor layer in which a region is not shielded by the first conductive layer is made to be conductive. That is, first regions and second regions of the active layer 23 of the third transistor T3 to the active layer 26 of the sixth transistor T6 are made to be conductive.

(105) A pattern of a second conductive layer is formed. In an exemplary implementation, forming the pattern of the second conductive layer may include: depositing sequentially a third insulation thin film and a second conductive thin film on the base substrate where the aforementioned patterns are formed, and patterning the second conductive thin film through a patterning process to form a third insulation layer covering the first conductive layer and the pattern of the second conductive layer disposed on the third insulation layer, as shown in FIG. 12a and FIG. 12b, FIG. 12a is a diagram of a planar structure of two sub-pixels, and FIG. 12b is a planar schematic view of the second conductive layer in FIG. 12a. In an exemplary implementation, the second conductive layer may be referred to as a second gate metal (GATE2) layer.

In an exemplary implementation, the pattern of the second conductive layer at least includes a first initial signal line 41 (i.e., a first initial signal line INIT1 in FIG. 7), a second initial signal line 42 (i.e., a second initial signal line INIT2 in FIG. 7), and a second plate 43 of the storage capacitor. The second plate 43 of the storage capacitor serves as the other plate of the storage capacitor. In the second direction Y, in a same sub-pixel, the first initial signal line 41 and the second initial signal line 42 are located at two sides of the second plate 42, for example, in a same sub-pixel, the first initial signal line 41, the second plate 43 of the storage capacitor, and the second initial signal line 42 are sequentially arranged in the second direction Y.

In an exemplary implementation, a profile of the second plate 43 may be in a shape of a rectangle whose corners may be chamfered, there is an overlapping area between an orthographic projection of the second plate 43 on the base substrate and an orthographic projection of the first plate 33 on the base substrate, and the first plate 33 and the second plate 43 form the storage capacitor of the pixel drive circuit.

In an exemplary implementation, in a same sub-pixel row, two adjacent second plates 43 are connected to each other so that a plurality of second plates 43 located in a same sub-pixel row have substantially the same potential, thus ensuring that second plates of storage capacitors of adjacent sub-pixels have the same potential, which is beneficial to improving the uniformity of panel display, avoiding a display defect of the display substrate and ensuring a display effect of the display substrate.

In an exemplary implementation, the first initial signal line 41 and the second initial signal line 42 may be in a shape of a strip or a bending line extending along the first direction X.

In an exemplary implementation, shapes of the second conductive layers in two adjacent columns of sub-pixels may be symmetrical along the second midline Q2-Q2.

(106) A pattern of a third conductive layer is formed. In an exemplary embodiment, forming the pattern of the third conductive layer may include: depositing sequentially a fourth insulation thin film and a third conductive thin film on a base substrate, on which the aforementioned patterns are formed, patterning the third conductive thin film through a patterning process to form a fourth insulation layer covering the second conductive layer and the pattern of the third conductive layer disposed on the fourth insulation layer, as shown in FIG. 13a to FIG. 13b, wherein FIG. 13a is a planar structure view of two sub-pixels, and FIG. 13b is a planar schematic view of the third conductive layer in FIG. 13a. In an exemplary implementation, the third conductive layer may be referred to as a third gate metal (GATE3) layer.

In an exemplary implementation, the pattern of the third conductive layer at least includes a first shield line 51, a second shield line 52, and a third shield line 53. In an exemplary implementation, in the second direction Y, the first shield line 51 and the third shield line 53 may be located at two sides of the second shield line 52 in one sub-pixel row, for example, in one sub-pixel row, the first shield line 51, the second shield line 52, and the third shield line 53 are sequentially arranged along the second direction Y.

In an exemplary implementation, an orthographic projection of the first shield line 51 on the substrate and an orthographic projection of the first scan signal line 31 on the substrate are at least partially overlapped, which can save space of the display substrate, and is beneficial to improving PPI of the display substrate and improving transmittance of the display substrate. In an exemplary implementation, the first shield line 51 may be in a structure of bending line extending along the first direction X, and the first shield line 51 may bypass the connection structure 33-1 provided on the first plate 33 of the storage capacitor along an opposite direction of the second direction Y.

In an exemplary implementation, the second shield line 52 may have a bending line structure extending along the first direction X.

In an exemplary implementation, an orthographic projection of the third shield line 53 on the substrate and an orthographic projection of the light emitting control line 32 on the substrate are at least partially overlapped, which can save space of the display substrate, and is beneficial to improving PPI of the display substrate and improving transmittance of the display substrate. In an exemplary implementation, the third shield line 53 may be in a structure of a bending line or a strip extending along the first direction X.

In an exemplary implementation, the first shield line 51 may serve as a shield layer of the second transistor T2, to shield the channel of the second transistor T2, and ensure electrical performance of the oxide second transistor T2. In an exemplary implementation, signals of the first shield line 51 and a subsequently formed second scan signal line may be the same, that is, the first shield line 51 is connected in parallel with the subsequently formed second scan signal line, and both are connected to a same signal source, so that the first shield line 51 and a channel region 22-3 of the active layer 22 of the second transistor T2 can serve as a bottom gate electrode (that is, a bottom control electrode 51-2) of the second transistor T2 to form the second transistor T2 with a double-gate structure.

In an exemplary implementation, the second shield line 52 may serve as a shield layer of the first transistor T1, to shield the channel of the first transistor T1, and ensure electrical performance of the oxide first transistor T1. In an exemplary implementation, signals of the second shield line 52 and a subsequently formed first reset control line may be the same, that is, the second shield line 52 is connected in parallel with the subsequently formed first reset control line, and

EP 4 593 568 A1

both are connected to a same signal source, so that a region where the second shield line 52 is overlapped with the channel region 21-3 of the active layer 21 of the first transistor T1 can be used as a bottom gate electrode (that is, a bottom control electrode 52-1) of the first transistor T1 to form the first transistor T1 with a double-gate structure.

In an exemplary implementation, the third shield line 53 may serve as shield layers of the seventh transistor T7 and the eighth transistor T8, to shield the channels of the seventh transistor T7 and the eighth transistor T8, and ensure electrical performance of the oxide seventh transistor T7 and eighth transistor T8. In an exemplary implementation, signals of the third shield line 53 and a subsequently formed second reset control line may be the same, that is, the third shield line 53 is connected in parallel with the subsequently formed second reset control line, and both are connected to a same signal source, so that a region where the third shield line 53 is overlapped with channel regions of the active layers of the seventh transistor T7 and the eighth transistor T8 can serve as a bottom gate electrode (i.e., a bottom control electrode 53-7) of the seventh transistor T7 and a bottom gate electrode (i.e., a bottom control electrode 53-8) of the eighth transistor T8, to form the seventh transistor T7 and the eighth transistor T8 with a double-gate structure.

In an exemplary implementation, shapes of the third conductive layers in two adjacent columns of sub-pixels may be symmetrical along the second midline Q2-Q2.

(107) Forming a pattern of a second semiconductor layer. In an exemplary implementation, forming the pattern of the second semiconductor layer may include: depositing sequentially a fifth insulation thin film and a second semiconductor thin film on the base substrate where the aforementioned patterns are formed, and patterning the second semiconductor thin film by a patterning process to form a fifth insulation layer covering the third conductive layer and the pattern of the second semiconductor layer disposed on the fifth insulation layer, as shown in FIG. 14a and FIG. 14b, FIG. 14a is a diagram of a planar structure of two sub-pixels and FIG. 14b is a planar schematic view of the second semiconductor layer in FIG. 14a.

In an exemplary implementation, the pattern of the second semiconductor layer in each sub-pixel at least includes an active layer 21 of the first transistor T1, an active layer 22 of the first transistor T2, an active layer 27 of the seventh transistor T7, and an active layer 28 of the eighth transistor T8.

In an exemplary implementation, the active layer 21 of the first transistor T1 may be in a shape of an "L", the active layer 22 of the second transistor T2, the active layer 27 of the seventh transistor T7, and the active layer 28 of the eighth transistor T8 may be in an "I" shape, and the active layer 21 of the first transistor T1, the active layer 22 of the second transistor T2, the active layer 27 of the seventh transistor T7, a first region and a second region of the active layer 28 of the eighth transistor T8 may be separately disposed.

In an exemplary implementation, shapes of the second semiconductor layers in two adjacent columns of sub-pixels may be symmetrical along the second midline Q2-Q2.

In an exemplary implementation, in a plane parallel to the display substrate, in the first direction X, the active layer 21 of the first transistor T1 may be located between the active layer 24 of the fourth transistor T4 and the active layer 22 of the second transistor T2, and the active layer 28 of the eighth transistor T8 may be located between the active layer 25 of the fifth transistor T5 and the active layer 27 of the seventh transistor T7; in the second direction Y, the active layer 28 of the eighth transistor T8 may be located at a side of the active layer 23 of the third transistor T3 away from the active layer 24 of the fourth transistor T4, the active layer 25 of the fifth transistor T5, the active layer 27 of the seventh transistor T7 and the active layer 28 of the eighth transistor T8 are located at a same side of the active layer 23 of the third transistor T3, the active layer 22 of the second transistor T2 and the active layer 24 of the fourth transistor T4 are located at the other side of the active layer 23 of the third transistor T3. An orthographic projection of the active layer 21 of the first transistor T1 on the substrate is at least partially overlapped with an orthographic projection of the active layer 23 of the third transistor T3 on the base substrate, and orthographic projections of the active layer 22 of the second transistor T2 and the active layer 27 of the seventh transistor T7 on the substrate are partially overlapped with an orthographic projection of the active layer 26 of the sixth transistor T6 on the substrate. For example, an orthographic projection of the active layer 22 of the second transistor T2 on the substrate is overlapped with an orthographic projection of the first region 26-1 of the active layer 26 of the sixth transistor T6 on the substrate, and an orthographic projection of the active layer 27 of the seventh transistor T7 on the substrate is overlapped with an orthographic projection of the second region 26-2 of the active layer 26 of the sixth transistor T6 on the substrate .

In an exemplary implementation, an active layer of each transistor may include a first region, a second region, and a channel region located between the first region and the second region. In an exemplary implementation, first regions and second regions of active layers of the first transistor T1, the second transistor T2, the seventh transistor T7, and the eighth transistor T8 may be provided independently. In an exemplary implementation, the channel region 21-3 of the active layer 21 of the first transistor T1 may be located between the first region 21-1 and the second region 21-2; the channel region 22-3 of the active layer 22 of the second transistor T2 may be located between the first region 22-1 and the second region 22-2; the channel region 27-3 of the active layer 27 of the seventh transistor T7 may be located between the first region 27-1 and the second region 27-2; the channel region 28-3 of the active layer 28 of the eighth transistor T8 may be located between the first region 28-1 and the second region 28-2.

In an exemplary implementation, the second semiconductor layer may be made of oxides, that is, the first

24

transistor T1, the second transistor T2, the seventh transistor T7 and the eighth transistor T8 are oxide thin film transistors. In an exemplary implementation, the oxide may be any one or more of following: Indium Gallium Zinc Oxide (InGaZnO), Indium Gallium Zinc Oxynitride (InGaZnON), Zinc Oxide (ZnO), Zinc Oxynitride (ZnON), Zinc Tin Oxide (ZnSnO), Cadmium Tin Oxide (CdSnO), Gallium Tin Oxide (GaSnO), Titanium Tin Oxide (TiSnO), Copper Aluminum Oxide (CuAlO), Strontium Copper Oxide (SrCuO), Lanthanum Copper Sulfur Oxide (LaCuOS), Gallium Nitride (GaN), Indium Gallium Nitride (InGaN), Aluminum Gallium Nitride (AlGaN), and Indium Gallium Aluminum Nitride (InGaAlN). In some possible implementations, the second semiconductor thin film may be made of Indium Gallium Zinc Oxide (IGZO), an electron mobility of Indium Gallium Zinc Oxide (IGZO) is higher than an electron mobility of amorphous silicon. Because the leakage current of the IGZO TFT is relatively small, the leakage of the first node N1 in the light emitting stage can be avoided.

In an exemplary implementation, shapes of the second semiconductor layers in two adjacent columns of sub-pixels may be symmetrical along the second midline Q2-Q2.

(108) A pattern of a fourth conductive layer is formed. In an exemplary implementation, forming the pattern of the fourth conductive layer may include sequentially depositing a sixth insulating thin film and a fourth conductive thin film on the base substrate on which the above-mentioned patterns are formed, patterning the fourth conductive thin film using a patterning process to form a fifth insulating layer covering the second semiconductor layer, and the pattern of the fourth conductive layer disposed on the sixth insulating layer, as shown in FIGs. 15a to 15b, herein FIG. 15a is a diagram of a planar structure of two sub-pixels, and FIG. 15b is a plan schematic diagram of the fourth conductive layer in FIG. 15a. In an exemplary implementation, the fourth conductive layer may be referred to as a fourth gate metal (GATE4) layer.

In an exemplary implementation, the pattern of the fourth conductive layer at least includes a second scan signal line 61 (i.e., a second scan line Gate2 in FIG. 7), a first reset control line 62 (i.e., a first reset line Reset1 in FIG. 7), a second reset control line 63 (i.e., a second reset line Reset2 in FIG. 7), and a third initial signal line 64 (i.e., a third initial signal line INIT3 in FIG. 7). In an exemplary embodiment, in one sub-pixel row, the second scan signal line 61, the first reset control line 62, the second reset control line 63, and the third initial signal line 64 are sequentially arranged along the second direction Y.

In an exemplary implementation, the second scan signal line 61 may be in a structure of bending line extending along the first direction X, and the second scan signal line 61 may bypass the connection structure 33-1 provided on the first plate 33 of the storage capacitor along an opposite direction of the second direction Y. In an exemplary embodiment, an orthographic projection of the second scan signal line 61 on the substrate is at least partially overlapped with an orthographic projection of the first shield line 51 on the substrate. In an exemplary implementation, a region where the second scan signal line 61 is overlapped with the active layer 22 of the second transistor T2 serves as a control electrode (which may be referred to as a top gate) 61-2 of the second transistor T2. In an exemplary implementation, signals of the first shield line 51 and the second scan signal line 61 may be the same, i.e., the first shield line 51 and the second scan signal line 61 are connected in parallel and connected to a same signal source, so that the first shield line 51 may serve as a bottom gate electrode (i.e., a bottom control electrode) of the second transistor T2, forming the second transistor T2 with a double-gate structure.

In an exemplary implementation, the first reset control line 62 may in a structure of bending line extending along the first direction X. An orthographic projection of the first reset control line 62 on the substrate is at least partially overlapped with an orthographic projection of the second shield line 52 on the substrate. In an exemplary implementation, a portion where the first reset control line 62 is overlapped with the active layer 21 of the first transistor T1 may serve as a control electrode 62-1 of the first transistor T1. In an exemplary implementation mode, signals of the second shield line 52 and the first reset control line 62 may be the same, i.e., the second shield line 52 and the first reset control line 62 are connected in parallel and connected with a same signal source, so that the second shield line 52 may serve as a bottom gate electrode (i.e., a bottom control electrode) of the first transistor T1, forming the first transistor T1 with a double-gate structure.

In an exemplary implementation, the second reset control line 63 may have a structure of bending line extending along the first direction X. An orthographic projection of the second reset control line 63 on the substrate is at least partially overlapped with an orthographic projection of the third shield line 53 on base substrate. In an exemplary implementation, a region where the second reset control line 63 is overlapped with active layers of the seventh transistor T7 and the eighth transistor T8 may serve as a control electrode 63-7 of the seventh transistor T7 and a control electrode 63-8 of the eighth transistor T8. In an exemplary implementation, signals of the third shield line 53 and the second reset control line 63 may be the same, that is, the third shield line 53 and the second reset control line 63 are connected in parallel and connected with a same signal source, so that the third shield line 53 may serve as bottom gate electrodes (that is, bottom control electrodes) of the seventh transistor T7 and the eighth transistor T8 to form the seventh transistor T7 and the eighth transistor T8 with a double-gate structure.

In an exemplary implementation, the third initial signal line 64 may in a structure of bending line or a strip extending along the first direction X.

In an exemplary implementation, shapes of the fourth conductive layers in two adjacent columns of sub-pixels may be symmetrical along the second midline Q2-Q2.

(109) A pattern of a seventh insulation layer is formed. In an exemplary embodiment, forming the pattern of the seventh insulating layer may include: depositing a seventh insulating thin film on the base substrate on which the above-mentioned patterns are formed, patterning the seventh insulating thin film using a patterning process to form a seventh insulating layer covering the fourth conductive layer, and a plurality of vias are provided on the seventh insulating layer, as shown in FIG. 16, which is a diagram of a planar structure of two sub-pixels.

In an exemplary implementation, the plurality of vias in each sub-pixel at least includes a first via V1, a second via V2, a third via V3, a fourth via V4, a fifth via V5, a sixth via V6, a seventh via V7, an eighth via V8, a ninth via V9, a tenth via V10, an eleventh via V11, a twelfth via V12, a thirteenth via V13, a fourteenth via V14, a fifteenth via V15, a sixteenth via V16, a seventeenth via V17, and an eighteenth via V18.

In an exemplary implementation, an orthographic projection of the first via V1 on the base substrate is within a range of an orthographic projection of the active layer 24 of the fourth transistor T4 on the base substrate, and the seventh insulating layer, the sixth insulating layer, the fifth insulating layer, the fourth insulating layer, the third insulating layer, and the second insulating layer in the first via V1 are etched away to expose a surface of a first region 24-1 of the active layer 24 of the fourth transistor T4. The first via V1 is configured such that the first electrode of the fourth transistor T4 formed subsequently is connected to the active layer 24 of the fourth transistor T4 through this via.

In an exemplary implementation, an orthographic projection of the second via V2 on the base substrate is within a range of an orthographic projection of the active layer 24 of the fourth transistor T4 on the base substrate, and the seventh, sixth, fifth, fourth, third and second insulating layers within the second via V2 are etched away to expose a surface of a second region 24-2 of the active layer 24 of the fourth transistor T4 (also a first region 23-1 of the active layer 23 of the third transistor T3 and a second region 25-2 of the active layer 25 of the fifth transistor T5). The second via V2 is configured such that the second electrode of the fourth transistor T4 formed subsequently is connected to the active layer 24 of the fourth transistor T4 through the via, and a second electrode of the fifth transistor T5 formed subsequently is connected to the active layer 25 of the fifth transistor T5 through the via, and a first electrode of the third transistor T3 formed subsequently is connected to the active layer 23 of the third transistor T3 through this via.

In an exemplary implementation, an orthographic projection of the third via V3 on the base substrate is within a range of an orthographic projection of the active layer 25 of the fifth transistor T5 on the base substrate, and the seventh insulating layer, the sixth insulating layer, the fifth insulating layer, the fourth insulating layer, the third insulating layer, and the second insulating layer within the third via V3 are etched away to expose the first region 25-1 of the active layer 25 of the fifth transistor T5. The third via V3 is configured such that the first electrode of the fifth transistor T5 formed subsequently is connected to the active layer 25 of the fifth transistor T5 through this via.

In an exemplary implementation, an orthographic projection of the fourth via V4 on the base substrate is within a range of an orthographic projection of the active layer 26 of the sixth transistor T6 on the base substrate, and the seventh, sixth, fifth, fourth, third, and second insulating layers within the fourth via V4 are etched away to expose a surface of the first region 26-1 of the active layer 26 of the sixth transistor T6 (also the second region 23-2 of the active layer 23 of the third transistor T3). The fourth via V4 is configured such that the first electrode of the sixth transistor T6 subsequently formed is connected to the active layer 26 of the sixth transistor T6 through the via, and a second electrode of the third transistor T3 subsequently formed is connected to the active layer 23 of the third transistor T3 through this via.

In an exemplary implementation, an orthographic projection of the fifth via V5 on the base substrate is within a range of an orthographic projection of the active layer 26 of the sixth transistor T6 on the base substrate, and the seventh insulating layer, the sixth insulating layer, the fifth insulating layer, the fourth insulating layer, the third insulating layer, and the second insulating layer within the fifth via V5 are etched away to expose a surface of the second region 26-2 of the active layer 26 of the sixth transistor T6. The fifth via V5 is configured such that the second electrode of the sixth transistor T6 subsequently formed is connected to the active layer 26 of the sixth transistor T6 through this via.

In an exemplary implementation, an orthographic projection of the sixth via V6 on the base substrate is within a range of an orthographic projection of the active layer 21 of the first transistor T1 on the base substrate, and the seventh insulating layer and the sixth insulating layer within the sixth via V6 are etched away to expose a surface of the first region 21-1 of the active layer 21 of the first transistor T1. The sixth via V6 is configured such that the first electrode of the first transistor T1 subsequently formed is connected to the active layer 21 of the first transistor T1 through this via.

In an exemplary implementation, an orthographic projection of the seventh via V7 on the base substrate is within a range of an orthographic projection of the active layer 21 of the first transistor T1 on the base substrate, and the seventh insulating layer and the sixth insulating layer in the seventh via V7 are etched away to expose a surface of the second region 21-2 of the active layer 21 of the first transistor T1. The seventh via V7 is configured such that the second electrode of the first transistor T1 subsequently formed is connected to the active layer 21 of the first transistor T1 through this via.

In an exemplary implementation, an orthographic projection of the eighth via V8 on the base substrate is within a range of an orthographic projection of the active layer 22 of the second transistor T2 on the base substrate, and the seventh and sixth insulating layers within the eighth via V8 are etched away to expose a surface of the first region 22-1 of the active layer 22 of the second transistor T2. The eighth via V8 is configured such that the first electrode of the second transistor T2 subsequently formed is connected to the active layer 22 of the second transistor T2 through this via.

In an exemplary implementation, an orthographic projection of the ninth via V9 on the base substrate is within a range of an orthographic projection of the active layer 22 of the second transistor T2 on the base substrate, and the seventh insulating layer and the sixth insulating layer within the ninth via V9 are etched away to expose a surface of the second region 22-2 of the active layer 22 of the second transistor T2. The ninth via V9 is configured so that the second electrode of the second transistor T2 subsequently formed is connected to the active layer 22 of the second transistor T2 through this via.

In an exemplary implementation, an orthographic projection of the tenth via V10 on the base substrate is within a range of an orthographic projection of the active layer 27 of the seventh transistor T7 on the base substrate, and the seventh insulating layer and the sixth insulating layer in the tenth via V10 are etched away to expose a surface of the first region 27-1 of the active layer 27 of the seventh transistor T7. The tenth via V10 is configured so that the first electrode of the seventh transistor T7 subsequently formed is connected to the active layer 27 of the seventh transistor T7 through this via.

In an exemplary implementation, an orthographic projection of the eleventh via V11 on the base substrate is within a range of an orthographic projection of the active layer 27 of the seventh transistor T7 on the base substrate, and the seventh insulating layer and the sixth insulating layer in the eleventh via V11 are etched away to expose a surface of the second region 27-2 of the active layer 27 of the seventh transistor T7. The eleventh via V11 is configured such that the second electrode of the seventh transistor T7 subsequently formed is connected to the active layer 27 of the seventh transistor T7 through this via.

In an exemplary implementation, an orthographic projection of the twelfth via V12 on the base substrate is within a range of an orthographic projection of the active layer 28 of the eighth transistor T8 on the base substrate, and the seventh and sixth insulating layers within the twelfth via V12 are etched away to expose a surface of the first region 28-1 of the active layer 28 of the eighth transistor T8. The twelfth via V12 is configured such that the first electrode of the eighth transistor T8 formed subsequently is connected to the active layer 28 of the eighth transistor T8 through this via.

In an exemplary implementation, an orthographic projection of the thirteenth via V13 on the base substrate is within a range of an orthographic projection of the active layer 28 of the eighth transistor T8 on the base substrate, and the seventh and sixth insulating layers within the thirteenth via V13 are etched away to expose a surface of the second region 28-2 of the active layer 28 of the eighth transistor T8. The thirteenth via V13 is configured such that the second electrode of the eighth transistor T8 formed subsequently is connected to the active layer 28 of the eighth transistor T8 through this via.

In an exemplary implementation, an orthographic projection of the fourteenth via V14 on the base substrate is within a range of an orthographic projection of the connection structure 33-1 in the first plate 33 on the base substrate, and the seventh insulating layer, the sixth insulating layer, the fifth insulating layer, the fourth insulating layer, and the third insulating layer in the fourteenth via V14 are etched away to expose a surface of the connection structure 33-1. The fourteenth via V14 is configured such that the first electrode of the second transistor T2 formed subsequently is connected to the connection structure 33-1 through this via.

In an exemplary implementation, an orthographic projection of the fifteenth via V15 on the base substrate is within a range of an orthographic projection of the first initial signal line 41 on the base substrate, and the seventh insulating layer, the sixth insulating layer, the fifth insulating layer, and the fourth insulating layer in the fifteenth via V15 are etched away to expose a surface of the first initial signal line 41. The fifteenth via V15 is configured so that the first electrode of the first transistor T1 subsequently formed is connected to the first initial signal line 41 through this via.

In an exemplary implementation, an orthographic projection of the sixteenth via V16 on the base substrate is within a range of an orthographic projection of the second initial signal line 42 on the base substrate, and the seventh insulating layer, the sixth insulating layer, the fifth insulating layer, and the fourth insulating layer within the sixteenth via V16 are etched away to expose a surface of the second initial signal line 42. The sixteenth via V16 is configured such that the first electrode of the seventh transistor T7 formed subsequently is connected to the second initial signal line 42 through this via.

In an exemplary implementation, an orthographic projection of the seventeenth via V17 on the base substrate is within a range of an orthographic projection of the second plate 43 of the storage capacitor on the base substrate, and the seventh insulating layer, the sixth insulating layer, the fifth insulating layer, and the fourth insulating layer in the seventeenth via V17 are etched away to expose a surface of the second plate 43 of the storage capacitor. The seventeenth via V17 is configured such that the first electrode of the fifth transistor T5 formed subsequently is connected to the second plate 43 of the storage capacitor through this via.

In an exemplary implementation, an orthographic projection of the eighteenth via V18 on the base substrate is within a range of an orthographic projection of the third initial signal line 64 on the base substrate, and the seventh insulating layer within the eighteenth via V18 is etched away to expose a surface of the third initial signal line 64. The eighteenth via V18 is configured such that the first electrode of the eighth transistor T8 formed subsequently is connected to the third initial signal line 64 through this via.

(110) A pattern of a fifth conductive layer is formed. In an exemplary embodiment, forming the fifth conductive layer may include: depositing a fifth conductive thin film on the base substrate on which the above-mentioned patterns are formed, patterning the fifth conductive thin film using a patterning process to form a fifth conductive layer disposed on the seventh insulating layer, as shown in FIGs. 17a to 17b, FIG. 17a is a diagram of a planar structure of two sub-pixels, and FIG. 17b is a plan schematic diagram of the fifth conductive layer in FIG. 17a. In an exemplary implementation, the fifth conductive layer may be referred to as a first source-drain metal (SD1) layer.

In an exemplary implementation, the fifth conductive layer at least includes a first connection electrode 71, a second connection electrode 72, a third connection electrode 73, a fourth connection electrode 74, a fifth connection electrode 75, a sixth connection electrode 76, a seventh connection electrode 77, an eighth connection electrode 78, and a ninth connection electrode 79.

In an exemplary implementation, the first connection electrode 71 may be in a shape of a strip whose main portion extends in the second direction Y, and one end of the first connection electrode 71 is connected to the first region 21-1 of the active layer 21 of the first transistor T1 through the sixth via V6 and the other end of the first connection electrode 71 is connected to the first initial signal line 41 in a current sub-pixel row through the fifteenth via V15. In an exemplary implementation, the first connection electrode 71 may serve as the first electrode of the first transistor T1, and the first connection electrode 71 is configured to be connected to the first initial signal line 41 and the active layer 21 of the first transistor T1.

In an exemplary implementation, a main body portion of the second connection electrode 72 extends along the second direction Y, and a first end of the second connection electrode 72 is connected to the second region 21-2 of the active layer 21 of the first transistor T1 through the seventh via V7, a second end of the second connection electrode 72 is connected to the second region 22-2 of the active layer 22 of the second transistor T2 through the ninth via V9, and is connected to the first region 26-1 of the active layer 26 of the sixth transistor T6 (also the second region 23-2 of the active layer 23 of the third transistor T3) through the fourth via V4, so that the second electrode of the first transistor T1, the second electrode of the second transistor T2, the second electrode of the third transistor T3, and the first electrode of the sixth transistor T6 have the same potential. In an exemplary embodiment, the second connection electrode 72 may serve as the second electrode of the first transistor T1, the second electrode of the second transistor T2, the second electrode of the third transistor T3, and the first electrode of the sixth transistor T6.

In an exemplary implementation, the third connection electrode 73 may have a structure of a strip , an extension direction of the third connection electrode 73 may be at an acute angle to the second direction Y, one end of the third connection electrode 73 may be connected to the first region 22-1 of the active layer 22 of the second transistor T2 through the eighth via V8, and the other end of the third connection electrode 73 may be connected to the connection structure 33-1 through the fourteenth via V14, so that the first region 22-1 of the active layer 22 of the second transistor T2 and the first plate 33 have the same potential. In an exemplary implementation, the third connection electrode 73 may serve as the first electrode of a second transistor T2.

In an exemplary implementation, a shape of the fourth connection electrode 74 may substantially be in a structure of a rectangle, corners of the rectangle may be provided with chamfers and the fourth connection electrode 74 may be connected to the first region 24-1 of the active layer 24 of the fourth transistor T4 through the first via V1. In an exemplary implementation, the fourth connection electrode 74 may serve as the first electrode of the fourth transistor T4. In an exemplary implementation, the fourth connection electrode 74 may be configured to be electrically connected to the subsequently formed data signal line.

In an exemplary implementation, the fifth connection electrode 75 may be in a shape of a bending line extending along the second direction Y, one end of the fifth connection electrode 75 is connected to the second region 28-2 of the active layer 28 of the eighth transistor T8 through the thirteenth via V13, and the other end of the fifth connection electrode 75 is connected to the second region 24-2 of the fourth transistor T4 (also the first region 23-1 of the active layer 23 of the third transistor T3 and the second region 25-2 of the active layer 25 of the fifth transistor T5) through the second via V2. In an exemplary implementation, the fifth connection electrode 75 may serve as the first electrode of the third transistor T3, the second electrode of the fourth transistor T4, and the second electrode of the fifth transistor T5.

In an exemplary implementation, the sixth connection electrode 76 may have a shape of a strip or a bending line extending along the second direction Y, one end of the sixth connection electrode 76 may be connected to the first region 25-1 of the active layer 25 of the fifth transistor T5 through the third via V3, and the other end of the sixth connection electrode 76 may be connected to the second plate 43 through the seventeenth via V17, so that the first region 25-1 of the active layer 25 of the fifth transistor T5 and the second plate 43 have the same potential. In an exemplary implementation, the sixth connection electrode 76 may serve as the first electrode of the fifth transistor T5.

In an exemplary implementation, the seventh connection electrode 77 may be in a shape of an "L", and the seventh connection electrode 77 may be connected to the first region 27-1 of the active layer 27 of the seventh transistor T7 through the tenth via V10, and may be connected to the second initial signal line 42 through the sixteenth via V16. In an exemplary implementation, the seventh connection electrode 77 may serve as the first electrode of the seventh transistor T7. In an exemplary implementation, in an M-th row of sub-pixels, the seventh connection electrodes 77 located in sub-pixels in an N-th column and an (N+1)-th column are interconnected to be an integral structure, and the seventh connection electrodes 77 located in sub-pixels in an (N+2)-th column and an (N+3)-th column are interconnected to be an integral structure.

In an exemplary implementation, the eighth connection electrode 78 may have a structure of a polygon (e.g., may substantially have a structure of triangle), the eighth connection electrode 78 may be connected to the second region 26-6 of the active layer 26 of the sixth transistor T6 through the fifth via V5, and may be connected to the second region 27-2 of the active layer 27 of the seventh transistor T7 through the eleventh via V11. In an exemplary implementation, the eighth connection electrode 58 may serve as a first electrode of the ninth transistor T9 such that the second region 26-2 of the active layer 26 of the sixth transistor T6 and the second region 27-2 of the active layer 27 of the seventh transistor T7 have the same potential. In an exemplary implementation, the eighth connection electrode 78 may serve as the second electrode of the sixth transistor T6 and as the second electrode of the seventh transistor T7. In an exemplary implementation, the eighth connection electrode 78 is configured to be connected to an anode connection electrode of a light emitting element subsequently formed.

In an exemplary implementation, the ninth connection electrode 79 may have a structure of a strip with a main body portion extending along the second direction Y, the ninth connection electrode 79 is connected to the first region 28-1 of the active layer 28 of the eighth transistor T8 through the twelfth via V12, and is connected to the third initial signal line 64 through the eighteenth via V18, and the third initial signal line 64 may write an initial voltage to a plurality of eighth transistors T8 in a sub-pixel row, so that the third initial signal line 64 is electrically connected with the first regions 28-1 of the active layers 28 of the eighth transistors T8. In an exemplary implementation, because the third initial signal line 64 is connected to the first regions 18-1 of the active layers 28 of all eighth transistors T8 in a sub-pixel row, the first electrodes of all eighth transistors T8 in a sub-pixel row may be ensured to have a same potential, which is beneficial to improving uniformity of the panel, avoiding display defect of the display substrate, and ensuring the display effect of the display substrate. In an exemplary embodiment, a ninth connection electrode 79 may serve as the first electrode of the eighth transistor T8.

In an exemplary implementation, shapes of the fifth conductive layers in two adjacent columns of sub-pixels may be symmetrical along the second midline Q2-Q2.

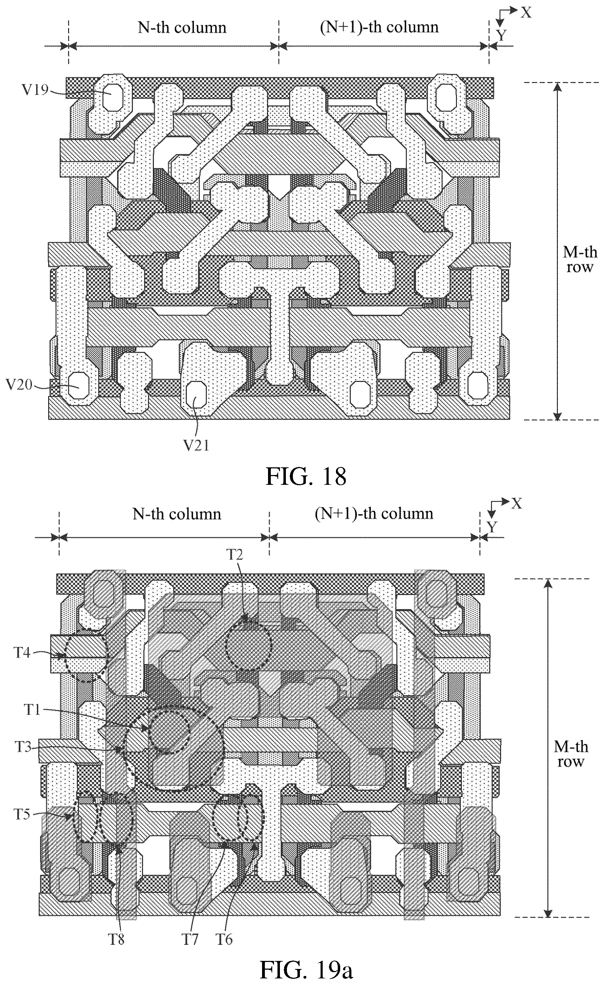

(111) Patterns of an eighth insulating layer and a first planarization layer are formed. In an exemplary implementation, forming the patterns of the eighth insulating layer and the first planarization layer may include: first depositing an eighth insulating thin film on the base substrate on which the above-mentioned patterns are formed, then coating a first planarization thin film, patterning the first planarization thin film and the eighth insulating thin film using a patterning process to form an eighth insulating layer covering the pattern of the fifth conductive layer and a first planarization layer disposed on the eighth insulating layer, and a plurality of vias are provided on the eighth insulating layer and first planarization layer, as shown in FIG. 18, which is a diagram of a planar structure of two sub-pixels.

In an exemplary implementation, the plurality of vias in each sub-pixel may at least include a nineteenth via V19, a twentieth via V20, and a twenty-first via V21.

In an exemplary implementation, an orthographic projection of the nineteenth via V19 on the base substrate is within a range of an orthographic projection of the fourth connection electrode 74 on the base substrate, and the first planarization layer and the eighth insulating layer within the nineteenth via V19 are etched away to expose a surface of the fourth connection electrode 74. The nineteenth via V19 is configured such that the data signal line formed subsequently is connected to the fourth connection electrode 74 through this via.

In an exemplary implementation, an orthographic projection of the twentieth via V20 on the base substrate is within a range of an orthographic projection of the sixth connection electrode 76 on the base substrate, and the first planarization layer and the eighth insulating layer within the twentieth via V20 are etched away to expose a surface of the sixth connection electrode 76. The twentieth via V20 is configured such that a first power supply transfer electrode formed subsequently is electrically connected to the sixth connection electrode 76 through this via.

In an exemplary implementation, an orthographic projection of the twenty-first via V21 on the base substrate is within a range of an orthographic projection of the eighth connection electrode 78 on the base substrate, and the first planarization layer and the eighth insulating layer within the twenty-first via V21 are etched away to expose a surface of the eighth connection electrode 78. The twenty-first via V 21 is configured such that an anode connection electrode of the light emitting element subsequently formed (for example, the subsequently formed first anode connection electrode) is connected to the eighth connection electrode 78 through this via.

(112) Forming a pattern of a sixth conductive layer. In an exemplary embodiment, forming the sixth conductive layer may include: depositing a sixth conductive thin film on the base substrate on which the above-mentioned patterns are formed, patterning the sixth conductive thin film using a patterning process to form a sixth conductive layer disposed on the first planarization layer, as shown in FIGs. 19a to 19b, FIG. 19a is a diagram of a planar structure of two sub-pixels, and FIG. 19b is a plan schematic diagram of the sixth conductive layer in FIG. 19a. In an exemplary implementation, the sixth conductive layer may be referred to as a second source-drain metal (SD2) layer.

In an exemplary implementation, the sixth conductive layer at least includes a data signal line 81 (i.e., a data line Data in FIG. 7), a first power supply transfer electrode 82, a first anode connection electrode 83, and a shielding electrode 84.

In an exemplary implementation, the data signal line 81 has a shape of a strip or a bending line with a main body portion extending along the second direction Y, and the data signal line 81 is connected to the fourth connection electrode 74 through the nineteenth via V19. Because the fourth connection electrode 74 is connected to the first region 24-1 of the active layer 24 of the fourth transistor T4 through a via, the connection of the data signal line 81 and the first electrode of the fourth transistor T4 is achieved, and a data signal is written to the fourth transistor T4.

In an exemplary embodiment, the first power supply transfer electrode 82 has a shape of a bending line or a strip with a main body portion extending along the second direction Y, and the first power supply transfer electrode 82 is connected to the sixth connection electrode 76 through the twentieth via V20. Because the sixth connection electrode 76 is connected to the first region 25-1 of the active layer 25 of the fifth transistor T5 and the second plate 43 through a via, the connection of the first power supply transfer electrode 82 to the first electrode of the fifth transistor T5 and the second plate 43 is achieved, and a power supply signal of the subsequently formed first power supply line can be written to the second plate 43 and the first electrode of the fifth transistor T5.

In an exemplary embodiment, the first anode connection electrode 83 has a shape of a bending line or a strip with a main body portion extending along the second direction Y, and the first anode connection electrode 83 is connected to the eighth connection electrode 78 through the twenty-first via V21. Because the eighth connection electrode 78 is connected to the second electrode of the sixth transistor T6 and the second electrode of the seventh transistor T7 through a via, the connection of the first anode connection electrode 83 to the second electrode of the sixth transistor T6 and the second electrode of the seventh transistor T7 is achieved. In a same sub-pixel, the first power supply transfer electrode 82 and the first anode connection electrode 83 may be located at two sides of the data signal line 81 in the first direction X.

In an exemplary embodiment, the shielding electrode 84 may be substantially in a shape of an "n", in the first direction X, the shielding electrode 84 may be located between two adjacent data signal lines 81, and in the second direction Y, the first anode connection electrode 83 may be located at a side of the shielding electrode 84, for example, the shielding electrode 84 and the first anode connection electrode 83 may be sequentially arranged along the second direction Y. In an exemplary embodiment, an orthographic projection of the shielding electrode 84 on the substrate may be at least partially overlapped with orthographic projections of the second connection electrode 72 and the third connection electrode 73 on the substrate, and the first node N1 of the pixel drive circuit being shielded may be achieved, thereby shielding the influence of the other signals on the first node N1 of the pixel drive circuit. In an exemplary embodiment, in a same sub-pixel row, one shielding electrode 84 may achieve shielding the first nodes N1 in two adjacent sub-pixels.

(113) A pattern of a second planarization layer is formed. In an exemplary embodiment, forming the pattern of the second planarization layer may include: coating a second planarization thin film on the base substrate on which the above-mentioned patterns are formed, patterning the second planarization thin film using a patterning process to form a second planarization layer covering the pattern of the sixth conductive layer , and a plurality of vias are provided on the second planarization layer, as shown in FIG. 20, which is a diagram of a planar structure of two sub-pixels.

In an exemplary implementation, the plurality of vias may at least include a twenty-second via V22, a twenty-third via V23, and a twenty-fourth via V24.

In an exemplary implementation, an orthographic projection of the twenty-second via V22 on the base substrate is within a range of an orthographic projection of the shielding electrode 84 on the base substrate, the second planarization layer within the twenty-second via V22 is removed to expose a surface of the shielding electrode 84, and the twenty-second via V22 is configured such that the subsequently formed first power supply signal connection line is electrically connected with the shielding electrode 84 through this via.

In an exemplary implementation, an orthographic projection of the twenty-third via V23 on the base substrate is within a range of an orthographic projection of the first power supply transfer electrode 82 on the base substrate, the second planarization layer in the twenty-third via V23 is removed to expose a surface of the first power supply transfer electrode 82, and the twenty-third via V23 is configured such that the subsequently formed first power supply line is electrically connected to the first power supply transfer electrode 82 through this via.

In an exemplary implementation, vias of each sub-pixel at least include a twenty-fourth via V24. An orthographic projection of the twenty-fourth via V24 on the base substrate is within a range of an orthographic projection of the first anode connection electrode 83 on the base substrate, the second planarization layer within the twenty-fourth via V24 is removed to expose a surface of the first anode connection electrode 83, and the twenty-fourth via V24 is configured such that the subsequently formed second anode connection electrode is electrically connected with the first anode connection electrode 83 through this via.

(114) A pattern of a seventh conductive layer is formed. In an exemplary embodiment, forming the seventh conductive layer may include: depositing a seventh conductive thin film on the base substrate on which the above-mentioned patterns are formed, patterning the seventh conductive thin film using a patterning process to form a seventh conductive layer disposed on the second planarization layer, as shown in FIGs. 21a to 21b, FIG. 21a is a diagram of a planar structure of two sub-pixels, and FIG. 21b is a plan schematic diagram of the seventh conductive layer in FIG. 21a. In an exemplary embodiment, the seventh conductive layer may be referred to as a third source-drain metal (SD3) layer.

In an exemplary embodiment, the seventh conductive layer at least includes a first power supply line 91 (i.e., a first power supply line VDD in FIG. 7), a second anode connection electrode 92, a first power supply connection line 93, and a second power supply connection line 94. In an exemplary embodiment, the first anode connection electrode 83 and the second anode connection electrode 92 may be an anode connection electrode of a light emitting element.

In an exemplary embodiment, the first power supply line 91 has a shape of a bending line or a strip with a main body portion extending along the second direction Y, and the first power supply line 91 is connected to the first power supply transfer electrode 82 through the twenty-third via V23. Because the first power supply transfer electrode 82 is connected to the sixth connection electrode 76 through a via, and the sixth connection electrode 76 is connected to the first region 25-1 of the active layer 25 of the fifth transistor T5 and the second plate 43 through a via, the connection of the first power supply line 91 to the first electrode of the fifth transistor T5 and the second plate 43 is achieved, and a power supply signal is written to the second plate 43 and a first electrode of the fifth transistor T5.

In an exemplary implementation, a plurality of columns of first power supply lines 91 are electrically connected with second plates 43 of a plurality of rows of sub-pixels (a plurality of second plates 43 in a same row of sub-pixels are connected to each other) to form a mesh, so that a plurality of first power supply lines 91 in the display substrate can have substantially the same potential, which is beneficial to improving uniformity of the panel, avoiding display defect of the display substrate, and ensuring the display effect of the display substrate.

In an exemplary embodiment, the second anode connection electrode 92 may be substantially in a shape of a rectangle or a strip extending along the second direction Y, and the second anode connection electrode 92 is connected to the first anode connection electrode 83 through the twenty-fourth via V24. Because the first anode connection electrode 83 is connected to the eighth connection electrode 78 through a via, and the eighth connection electrode 78 is connected to the second region 26-2 of the active layer 26 of the sixth transistor T6 (also the second region 27-2 of the active layer 27 of the seventh transistor T7) through a via, the connection of the second anode connection electrode 92 to the second electrode of the sixth transistor T6 and the second electrode of the seventh transistor T7 is achieved.

In an exemplary embodiment, the first power supply connection line 93 may have a structure of a strip extending along the second direction Y, the first power supply connection line 93 may be electrically connected to the shielding electrode 84 through the twenty-second via V22, and the first power supply connection line 93 may be connected to the first power supply line 91 through the second power supply connection line 94 or to a first power signal supply line located in a bezel region (FIGs. 21a and 21b show that the first power supply connection line 93 is connected to the first power supply line 91 through the second power supply connection line 94) to provide a power supply signal to the shielding electrode 84.

In an exemplary embodiment, the second power supply connection line 94 may have a structure of a strip extending along the first direction X, and the second power supply connection line 94 may be connected to the first power supply line 91. The second power supply connection line 94 is interconnected with the first power supply line 91 and the first power supply connection line 93 to form a mesh structure, so that a power supply signal provided to the display substrate by the first power supply line 91 is as consistent as possible, and thus display uniformity can be improved.

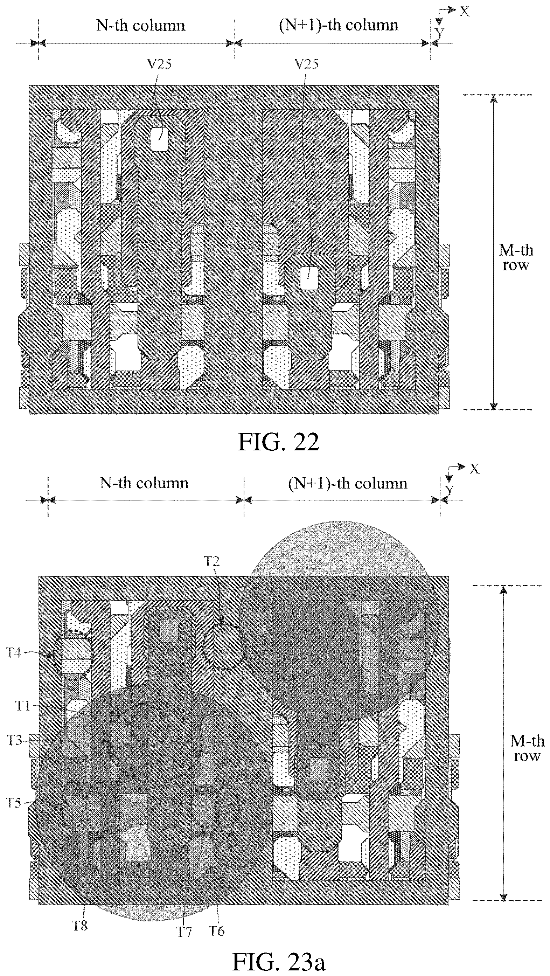

*(115)* A pattern of a third planarization layer is formed. In an exemplary implementation, forming the pattern of the third planarization layer may include: coating a third planarization thin film on the base substrate where the aforementioned patterns are formed, patterning the third planarization thin film using a patterning process to form a third planarization layer covering the pattern of the seventh conductive layer, the third planarization layer is provided with a plurality of vias, as shown in FIG. 22, which is a planar structure diagram of two sub-pixels.

In an exemplary implementation, the plurality of vias may at least include a twenty-fifth via V25.

In an exemplary implementation, the via of each sub-pixel at least includes a thirty-fifth via V25. An orthographic projection of the twenty-fifth via V25 on the base substrate is within a range of the orthographic projection of the second anode connection electrode 92 on the base substrate, the third planarization layer within the twenty-fifth via V25 is etched away to expose a surface of the second anode connection electrode 92, and the twenty-fifth via V25 is configured such that an anode formed subsequently is electrically connected to the second anode connection electrode 92 through this via. In an exemplary embodiment, the twenty-fifth via V25 may serve as an anode via.

So far, a drive circuit layer has been manufactured on the base substrate. In an exemplary implementation, in a plane perpendicular to the display substrate, the drive circuit layer may include a first semiconductor layer, a first conductive layer, a second conductive layer, a third conductive layer, a second semiconductor layer, a fourth conductive layer, a fifth conductive layer, and a sixth conductive layer, which are sequentially disposed on the base substrate.

In an exemplary implementation, the drive circuit layer may include a first insulating layer, a second insulating layer, a third insulating layer, a fourth insulating layer, a fifth insulating layer, a sixth insulating layer, a seventh insulating layer, an eighth insulating layer, a first planarization layer, a second planarization layer and a third planarization layer, wherein the first insulating layer is disposed between the base substrate (or the shield layer) and the first semiconductor layer, the second insulating layer is disposed between the first semiconductor layer and the first conductive layer, the third insulating layer is disposed between the first and second conductive layers, the fourth insulating layer is disposed between the second and third conductive layers, the fifth insulating layer is disposed between the third conductive layer and second semiconductor layers, the sixth insulating layer is disposed between the second semiconductor layer and fourth conductive layer, the seventh insulating layer is disposed between the fourth and fifth conductive layers, the eighth insulating layer and the first planarization layer are disposed between the fifth and sixth conductive layers, the second planarization layer is disposed between the sixth and seventh conductive layers, and the third planarization layer is disposed on the seventh conductive layer.

In an exemplary embodiment, after preparation of the drive circuit layer is completed, a light emitting structure layer is prepared on the drive circuit layer, and the preparation process of the light emitting structure layer may include the following operations: forming a pattern of an anode (i.e., an anode conductive layer), and the anode is connected to the second anode connection electrode through an anode via (i.e., the twenty-fifth via V25); forming a pixel definition layer, wherein pixel openings are provided on the pixel definition layer, and a pixel opening exposes an anode; forming an organic light emitting layer using an evaporation process and inkjet printing process, the organic light emitting layer is connected with an anode through a pixel opening, and a cathode is formed on the organic light emitting layer; forming an encapsulation layer, wherein the encapsulation layer may include a first encapsulation layer, a second encapsulation layer and a third encapsulation layer that are stacked, the first encapsulation layer and the third encapsulation layer may be made of an inorganic material, the second encapsulation layer may be made of an organic material, and the second encapsulation layer is disposed between the first encapsulation layer and the third encapsulation layer to ensure that external water vapor cannot enter the light emitting structure layer; and forming a black matrix layer. Acts of forming the anode conductive layer, the pixel definition layer, the encapsulation layer and the black matrix layer are as follows.

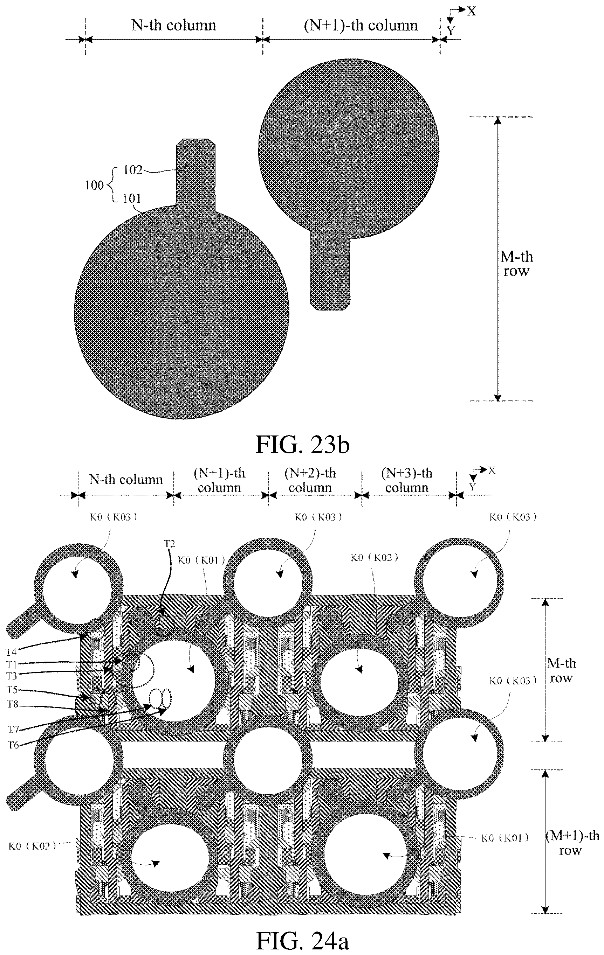

(116) A pattern of an anode conductive layer is formed. In an exemplary implementation, forming the pattern of the anode conductive layer may include: depositing an anode conductive thin film on the base substrate on which the above-mentioned patterns are formed, patterning the anode conductive thin film using a patterning process to form the pattern of the anode conductive layer disposed on the third planarization layer, as shown in FIGs. 23a to 23b, FIG. 23a is a schematic diagram of a planar structure of two sub-pixels, and FIG. 23b is a schematic planar view of the anode conductive layer in FIG. 23a.

In an exemplary implementation, the pattern of the anode conductive layer may at least include a plurality of anodes 100, as shown in FIGs. 6e and 6f, the plurality of anodes 100 may include: a first anode 1001 of a red light emitting unit (i.e., an anode 1001 of a first sub-pixel), a second anode 1002 of a blue light emitting unit (i.e., an anode 1002 of a second sub-pixel), and a third anode 1003 of a green light emitting unit (i.e., an anode 1003 of a third sub-pixel), a region where the first anode 1001 is located can form a red light emitting unit that emits red light, a region where the second anode 1002 is located can form a blue light emitting unit that emits blue light, and a region where the third anode 1003 is located can form a green light emitting unit that emits green light.

In an exemplary implementation, the first anode 1001, the second anode 1001, and the third anode 1003 may be connected to the second connection electrodes 92 in the corresponding sub-pixels through the twenty-fifth vias V25. Because the second anode connection electrode 92 in the sub-pixel is electrically connected to the second electrode of the sixth transistor T6 (also the second electrode of the seventh transistor T7) through the via, the first anode 1001, the second anode 1002 and the third anode 1003 can be connected to the second electrode of the sixth transistor T6 and the second electrode of the seventh transistor T7 through the second anode connection electrode 92, respectively, thereby achieving that the pixel drive circuit drives the light emitting device to emit light.

In an exemplary implementation, the anode 100 may include an anode main body portion 101 and an anode connection portion 102, the anode main body portion 101 may have a circular structure or an elliptic structure, one end of the anode connection portion 102 is connected to the anode main body portion 101, and the other end of the anode connection portion 102 is electrically connected to the second anode connection electrode 92 through the twenty-fifth via V25. The anode connection portion 102 may have a structure of a strip, the anode connection portion 102 may be configured to compensate for a difference in parasitic capacitance among a plurality of sub-pixels due to signal lines, and by providing the anode connection portion 102, the parasitic capacitance of the plurality of sub-pixels can be kept consistent, thereby improving display uniformity of the display substrate.

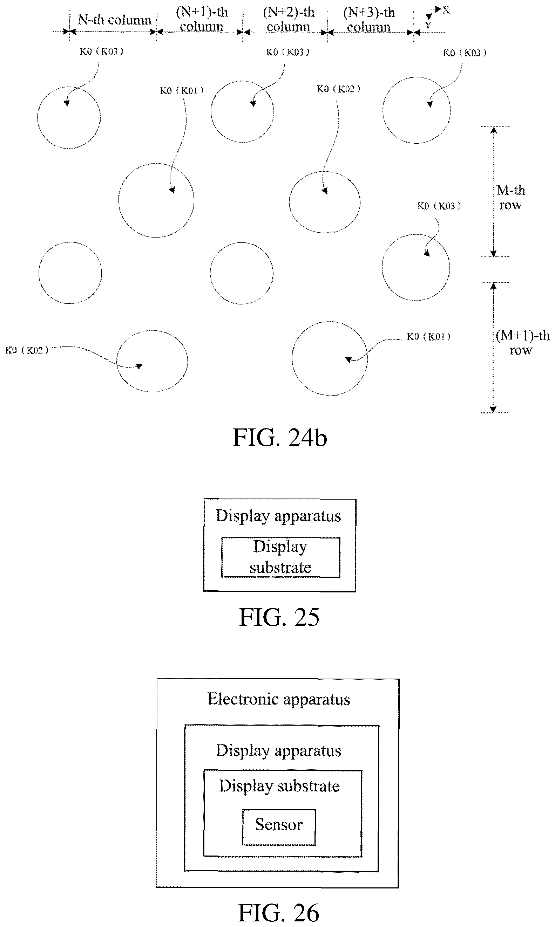

(117) A pattern of a pixel definition layer is formed. In an exemplary implementation, forming the pattern of the pixel definition layer may include: depositing a pixel definition layer thin film on the base substrate on which the above-mentioned patterns are formed, patterning the pixel definition layer thin film using a patterning process to form a pattern of an anode conductive layer disposed on the anode conductive layer, as shown in FIGs. 24a to 24b, FIG. 24a is a schematic diagram of a planar structure of four sub-pixels, and FIG. 24b is a plan schematic diagram of the pixel definition layer in FIG. 24a.

In an exemplary implementation, the pattern of the pixel definition layer can include at least a plurality of pixel openings K0. The plurality of pixel openings K0 may include a first pixel opening K01, a second pixel opening K02, and a third pixel opening K03. An orthographic projection of the first pixel opening K01 on the base substrate is within a range of an orthographic projection of the first anode 1001 on the base substrate; an orthographic projection of the second pixel opening K02 on the base substrate is within a range of an orthographic projection of the second anode 1002 on the base substrate; an orthographic projection of the third pixel opening K03 on the base substrate is within a range of an orthographic projection of the third anode 1003 on the base substrate.

(118) A pattern of an encapsulation layer is formed. In an exemplary implementation, forming the encapsulation layer may include: depositing an encapsulation layer thin film on the base substrate on which the above-mentioned patterns are formed, patterning the encapsulation layer thin film using a patterning process to form the pattern of the encapsulation layer disposed on the pixel definition layer.

(119) A pattern of a black matrix layer is formed. In an exemplary implementation, forming the pattern of the black matrix layer may include: depositing a black matrix layer thin film on the base substrate on which the above-mentioned patterns are formed, patterning the black matrix layer thin film using a patterning process to form the pattern of the black matrix layer disposed on the encapsulation layer, as shown in FIGs. 6c, 6d, 6g, and 6h, FIGs. 6g and 6h are schematic diagrams of planar structural of four sub-pixels, and FIGs. 6c and 6d are plan schematic diagrams of the pixel definition layers in FIGs. 6h and 6g, respectively.

In an exemplary implementation, the pattern of the black matrix layer may at least include a plurality of light-transmitting holes K3 and a plurality of light-transmitting openings K2, and orthographic projections of the plurality of light-transmitting holes K3 on the base substrate respectively cover orthographic projections of the plurality of pixel openings K0 on the base substrate, and in general, a light-transmitting hole K3 is larger than a pixel openings K0 corresponding to it, thereby avoiding shielding the pixel opening. The plurality of light-transmitting openings K2 forms a plurality of light-transmitting regions K1 to improve the light transmittance of the display substrate.

In some examples, the first conductive layer, the second conductive layer, the third conductive layer, the fourth conductive layer, the fifth conductive layer, the sixth conductive layer and the seventh conductive layer may be made of a metal material, such as any one or more of Silver (Ag), Copper (Cu), Aluminum (Al), and Molybdenum (Mo), or an alloy material of the aforementioned metals, such as an Aluminum Neodymium alloy (AlNd) or a Molybdenum Niobium alloy (MoNb), and may be of a single-layer structure or a multi-layer composite structure, such as Mo/Cu/Mo. The first insulation layer, the second insulation layer, the third insulation layer, the fourth insulation layer, the fifth insulation layer, the sixth insulation layer, the seventh insulation layer and the eighth insulation layer may be made of any one or more of Silicon Oxide (SiOx, x>0), Silicon Nitride (SiNy, y>0), and Silicon OxyNitride (SiON), and may be a single layer, a multi-layer, or a composite layer. The first planarization layer, the second planarization layer and the third planarization layer may be made of an organic material, such as polyimide, acrylic, or polyethylene terephthalate. The pixel definition layer may be made of an organic material, such as polyimide, acrylic, or polyethylene terephthalate. The anode layer may be made of a reflective material such as a metal, and the cathode may be made of a transparent conductive material. However, the present embodiment is not limited thereto.

A structure and a preparation process of the display substrate of the embodiment are merely illustrative. In some exemplary implementations, a corresponding structure may be changed and a patterning process may be added or removed according to actual needs. The manufacturing process of the exemplary embodiment may be implemented using an existing mature manufacturing device, and may be compatible well with an existing manufacturing process, simple in process implementation, easy to implement, high in a production efficiency, low in a production cost, and high in yield. The display substrate according to an embodiment of the present disclosure may be applied to another display apparatus having a pixel drive circuit, such as quantum dot display, which is not limited in the present disclosure.

An embodiment of the present disclosure further provides a display apparatus, and as shown in FIG. 25, the display apparatus may include the display substrate described in any of the above embodiments.

An embodiment of the present disclosure further provides an electronic apparatus. As shown in FIG. 26, the electronic apparatus may include a sensor and the display apparatus as described in FIG. 25, the display apparatus may include the display substrate as described in any of the above embodiments, the sensor may be located at a side of a non-display surface of the display substrate, the display substrate may include a first display region, and an orthographic projection of the sensor on the display substrate is at least partially overlapped with the first display region of the display substrate.

In an exemplary implementation, as shown in FIG. 1, the display substrate may include a first display region A1 and a second display region A2, the second display region A2 may be located at least a side of the first display region A1, for example, the second display region A2 is disposed around the first display region A1. In some examples, as shown in FIG. 1, the first display region A1 may be a light-transmitting display region, and may be referred to as a Full Display with Camera (FDC) region, and the second display region A2 may be referred to as a normal display region. For example, an orthographic projection of a sensor (such as a camera and other hardware) on the display substrate may be located within the first display region A1 of the display substrate. In some examples, as shown in FIG. 1, the first display region A1 may be circular, and a size of an orthographic projection of the sensor on the display substrate may be less than or equal to a size of the first display region A1. However, the present embodiment is not limited thereto. In some other examples, the first display region A1 may be rectangular, and a size of the orthographic projection of the sensor on the display substrate may be less than or equal to a size of an inscribed circle of the first display region A1.

In an exemplary implementation, the display apparatus may be any product or component with a display function, such as a mobile phone, a tablet computer, a television, a display, a laptop, a digital photo frame, or a navigator.

In the display substrate, the display apparatus, and the electronic apparatus according to an embodiment of the present disclosure, an orthographic projection of at least one first-type transistor on the base substrate is at least partially overlapped with an orthographic projection of at least one second-type transistor on the base substrate , which can reduce the area of the pixel drive circuit, save the space of the display substrate, and can increase the light transmittance of the display substrate, or improve the PPI of the display substrate.

The drawings of the embodiments of the present disclosure only involve structures involved in the embodiments of the present disclosure, and other structures may refer to a general design.

The embodiments of the present disclosure, that is, features in the embodiments, may be combined with each other to obtain a new embodiment in a situation of no conflicts.

Although the implementations disclosed in the embodiments of the present disclosure are described above, contents are only implementations for facilitating understanding of the embodiments of the present disclosure, but are not intended to limit the embodiments of the present disclosure. Any person skilled in the art to which the embodiments of the present disclosure pertain may make any modifications and variations in forms and details of implementation without departing from the spirit and the scope disclosed in the embodiments of the present disclosure. Nevertheless, the scope of patent protection of the embodiments of the present disclosure shall still be subject to the scope defined by the appended claims.

## Claims

1. A display substrate, comprising a base substrate and a plurality of sub-pixels disposed on the base substrate, wherein at least one sub-pixel comprises a pixel drive circuit, at least one pixel drive circuit comprises a plurality of first-type transistors and a plurality of second-type transistors, an orthographic projection of at least one of the first-type transistors on the base substrate is at least partially overlapped with an orthographic projection of at least one of the second-type transistors on the base substrate.

2. The display substrate according to claim 1, wherein pixel drive circuits of the plurality of sub-pixels form a plurality of rows of pixel drive circuits, a light-transmitting region is provided between two adjacent rows of pixel drive circuits, and there is no overlapping region between an orthographic projection of the light-transmitting region on the base substrate and orthographic projections of the pixel drive circuits on the base substrate.

3. The display substrate according to claim 2, further comprising a shield layer, wherein the shield layer is located between the base substrate and the pixel drive circuits in a direction perpendicular to a plane on which the display substrate is located, the shield layer is provided with a light-transmitting opening, and boundary lines of the light-transmitting opening are smoothly connected; or
the display substrate further comprises a black matrix layer, the black matrix layer is located at a side of the pixel drive circuits away from the base substrate in a direction perpendicular to a plane on which the display substrate is located, the black matrix layer is provided with a light-transmitting opening, and boundary lines of the light-transmitting opening are smoothly connected.

4. The display substrate according to claim 3, wherein an orthographic projection of the light-transmitting opening on the base substrate is overlapped with an orthographic projection of the light-transmitting region on the base substrate.

5. The display substrate according to claim 3, wherein the light-transmitting opening is in a shape of an ellipse or a polygon, and corners of the polygon are provided with rounded corner structures.

6. The display substrate according to any one of claims 2 to 4, further comprising an anode conductive layer, the anode conductive layer is located at a side of the pixel drive circuits away from the base substrate, the anode conductive layer comprises a plurality of anodes, each sub-pixel comprises at least one anode, the anode and the pixel drive circuit in a same sub-pixel are electrically connected with each other, and there is no overlapping region between an orthographic projection of the anode on the base substrate and an orthographic projection of the light-transmitting region on the base substrate.

7. The display substrate according to claim 6, wherein the plurality of sub-pixels comprise a plurality of first sub-pixels, a plurality of second sub-pixels, and a plurality of third sub-pixels, an area of an anode of a first sub-pixel and an area of an anode of a second sub-pixel are each greater than an area of an anode of a third sub-pixel, and orthographic projections of anodes of the first sub-pixel and the second sub-pixel on the base substrate are within a range of an orthographic projection of the pixel drive circuit on the base substrate.

8. The display substrate according to claim 7, wherein anodes of the plurality of third sub-pixels are arranged in an array on a plane parallel to the display substrate, and the light-transmitting region is located between anodes of two adjacent columns of third sub-pixels in a row direction; in a column direction, anodes of the first sub-pixels and anodes of the second sub-pixels are alternately arranged, and the light-transmitting region is located between anodes of a first sub-pixel and a second sub-pixel which are adjacent.

9. The display substrate according to claim 1, wherein the first-type transistors at least comprise a third transistor as a drive transistor, the second-type transistors at least comprise a first transistor as a first initialization transistor, a second electrode of the first transistor is electrically connected with a second electrode of the third transistor; an orthographic projection of the first transistor on the base substrate is at least partially overlapped with an orthographic projection of the third transistor on the base substrate.

10. The display substrate according to claim 9, wherein orthographic projections of a control electrode and an active layer of the third transistor on the base substrate are at least partially overlapped with orthographic projections of a control electrode and an active layer of the first transistor on the base substrate, respectively.

11. The display substrate according to claim 9, wherein the first-type transistors further comprise a sixth transistor as a light emitting transistor, and the second-type transistors further comprise a seventh transistor as a second initialization transistor, a first electrode of the sixth transistor and a second electrode of the seventh transistor are both electrically connected with the second electrode of the third transistor; an orthographic projection of the sixth transistor on the base substrate is at least partially overlapped with an orthographic projection of the seventh transistor on the base substrate.

12. The display substrate according to claim 11, wherein orthographic projections of a control electrode and an active layer of the sixth transistor on the base substrate are at least partially overlapped with orthographic projections of a control electrode and an active layer of the seventh transistor on the base substrate, respectively.

13. The display substrate according to claim 11, wherein the first-type transistors further comprise a fourth transistor as a data writing transistor and a fifth transistor as a light emitting transistor, the second-type transistors further comprise a second transistor as a compensation transistor and an eighth transistor as a third initialization transistor, a second electrode of the fourth transistor, a second electrode of the fifth transistor and a second electrode of the eighth transistor are all electrically connected with a first electrode of the third transistor, a first electrode of the second transistor is electrically connected with a control electrode of the third transistor, and second electrode of the second transistor is electrically connected with the second electrode of the third transistor; and
on a plane parallel to the display substrate, in a first direction, the fourth transistor and the fifth transistor are located at a side of the first transistor and the third transistor, the second transistor, the sixth transistor, and the seventh transistor are located at the other side of the third transistor and the first transistor, and the eighth transistor is located between the fifth transistor and the seventh transistor; in a second direction, the fourth transistor and the second transistor are located at a side of the third transistor, the fifth transistor to the eighth transistor are located at the other side of the third transistor, and the first direction and the second direction are intersected.

14. The display substrate according to claim 13, wherein an orthographic projection of an active layer of the second transistor on the base substrate is at least partially overlapped with an orthographic projection of an active layer of the sixth transistor on the base substrate.

15. The display substrate according to claim 13, further comprising a drive circuit layer, the drive circuit layer is provided with pixel drive circuits of the plurality of sub-pixels, a pixel drive circuit further comprises a storage capacitor, the drive circuit layer comprises a first semiconductor layer, a first conductive layer, a second conductive layer, a third conductive layer, a second semiconductor layer, and a fourth conductive layer sequentially disposed on the base substrate in a direction perpendicular to a plane on which the display substrate is located; and
the first semiconductor layer at least comprises: an active layer of a first-type transistor; the first conductive layer at least comprises a control electrode of the first-type transistor and a first plate of the storage capacitor; the second conductive layer at least comprises: a second plate of the storage capacitor; the third conductive layer at least comprises: a shield layer of a second-type transistor; the second semiconductor layer at least comprises: an active layer of the second-type transistor; the fourth conductive layer at least comprises a control electrode of the second-type transistor.

16. The display substrate according to claim 15, wherein the drive circuit layer further comprises a fifth conductive layer located on a side of the fourth conductive layer away from the second semiconductor layer, the fifth conductive layer at least comprises: first electrodes and second electrodes of the first-type transistor and the second-type transistor; and orthographic projections of the first plate and the second plate on the base substrate are at least partially overlapped with the orthographic projection of the third transistor on the base substrate, on the plane parallel to the display substrate, in the second direction, a side of the first plate close to the second transistor is provided with a connection structure, an orthographic projection of the connection structure on the base substrate is not overlapped at least partially with orthographic projections of the storage capacitor and the third transistor on the base substrate, the first electrode of the second transistor is electrically connected with the connection structure through a via, and there is no overlapping region between an orthographic projection of the second transistor on the base substrate and an orthographic projection of the storage capacitor on the base substrate.

17. The display substrate according to claim 16, wherein the pixel drive circuits of the plurality of sub-pixels form a plurality of columns of pixel drive circuits, the drive circuit layer further comprises a sixth conductive layer and a seventh conductive layer, in the direction perpendicular to a plane on which the display substrate is located, the sixth conductive layer is located on a side of the fifth conductive layer away from the fourth conductive layer, and the seventh conductive layer is located on a side of the sixth conductive layer away from the fifth conductive layer, the sixth conductive layer at least comprises: a data signal line electrically connected with first electrodes of fourth transistors in one column of pixel drive circuits of the plurality of columns pixel drive circuits; the seventh conductive layer at least comprises: a first power supply line electrically connected with first electrodes of fifth transistors and second plates of storage capacitors in two adjacent columns of the plurality of columns of pixel drive circuits; and

on the plane parallel to the display substrate, the data signal line and the first power supply line are extended along the second direction and are arranged at intervals along the first direction, and data signal lines of two adjacent columns of pixel drive circuits are located at two sides of the first power supply line electrically connected with the two adjacent columns of pixel drive circuits; two adjacent columns of pixel drive circuits are symmetrically disposed along a second midline, and the second midline is a midline of the two adjacent columns of pixel drive circuits extending along the second direction.

18. The display substrate according to claim 17, wherein the sixth conductive layer further comprises a shielding electrode, and the seventh conductive layer further comprises first power supply connection lines and second power supply connection lines;

on the plane parallel to the display substrate, the first power supply connection lines are extended along the second direction, the second power supply connection lines are extended along the first direction, each second power supply connection line is connected with at least some of first power supply lines; in the first direction, the shielding electrode and a first power supply connection line are located between two adjacent data signal lines; in the second direction, the first power supply connection line is located between two adjacent second power supply connection lines, and two ends of the first power supply connection line are respectively connected with the two adjacent second power supply connection lines; and

an orthographic projection of the shielding electrode on the base substrate covers an orthographic projection of the connection structure on the base substrate; the first power supply connection line is at least partially overlapped with an orthographic projection of the shielding electrode on the base substrate, and the first power supply connection line is electrically connected with the shielding electrode through a via.

19. The display substrate according to claim 1, wherein at least partial structure of first-type transistors and at least partial structure of second-type transistors are located at different conductive layers, an orthographic projection of the at least partial structure of at least one of the first-type transistors on the base substrate and is at least partially overlapped with an orthographic projection of the at least partial structure of at least one of the second-type transistors on the base substrate, the partial structure comprises one or more of a control electrode and an active layer of a transistor.

20. A display substrate, comprising a base substrate and a plurality of sub-pixels, a plurality of data signal lines, and a plurality of first power supply lines which are disposed on the base substrate, on a plane parallel to the display substrate, the plurality of data signal lines and the plurality of first power supply lines are extended along a second direction and are arranged at intervals along a first direction, and the first direction are intersected with the second direction; and

at least some of the sub-pixels comprise pixel drive circuits, pixel drive circuits of the plurality of sub-pixels form a plurality of columns of pixel drive circuits, each data signal line is electrically connected with at least some pixel drive circuits in one column of pixel drive circuits of the plurality of columns of pixel drive circuits, each first power supply line is electrically connected with at least some pixel drive circuits in at least one column of pixel drive circuits, and in the first direction, two adjacent data signal lines are located at two sides of the first power supply line.

21. The display substrate according to claim 20, wherein each first power supply line is electrically connected with two adjacent columns of pixel drive circuits, two adjacent columns of pixel drive circuits are symmetrically disposed along a second midline, and the second midline is a midline of the two adjacent columns of pixel drive circuits extending along the second direction.

22. The display substrate according to claim 21, wherein a pixel drive circuit further comprises a shielding electrode disposed between two adjacent data signal lines in the first direction, and the data signal line is located between the shielding electrode and the first power supply line in a same column of pixel drive circuits.

23. The display substrate according to claim 22, further comprising first power supply connection lines and second power supply connection lines, wherein on a plane parallel to the display substrate, the first power supply connection lines are extended along the second direction and the second power supply connection lines are extended along the first direction, each second power supply connection line is connected with at least some of first power supply lines;

in the first direction, a first power supply connection line is located between two adjacent data signal lines; in the second direction, the first power supply connection line is located between two adjacent second power supply connection lines, and two ends of the first power supply connection line are respectively connected two with two adjacent second power supply connection lines; and
the shielding electrode and the data signal lines are located in a same conductive layer, the first power supply line, the first power supply connection lines and the second power supply connection lines are located in a same conductive layer, and the data signal lines and the first power supply lines are located in different conductive layers; an orthographic projection of the first power supply connection line on the base substrate is at least partially overlapped with an orthographic projection of the shielding electrode on the base substrate, and the first power supply line and the shielding electrode are electrically connected through a via.

24. A display apparatus, comprising a display substrate, the display substrate is the display substrate according to any one of claims 1 to 19, or the display substrate is the display substrate according to any one of claims 20 to 23.

25. An electronic apparatus, comprising a sensor and the display apparatus according to claim 24, the display apparatus comprises the display substrate, the sensor is located on a side of a non-display surface of the display substrate, the display substrate comprises a first display region, an orthographic projection of the sensor on the display substrate is at least partially overlapped with the first display region of the display substrate.

BB    A1

Pxij

AA

A2

Y
X

FIG. 1

VDD

INIT3

C

T5    E    T8    Reset2

N2    T4    Data

N1

Gate2    T3    Reset1    Gate1

T2    N3    T1    INIT1

T6    E

N4    T7    INIT2

L    Reset2

VSS

FIG. 2

FIG. 3

FIG. 4

FIG. 5a

FIG. 5b

FIG. 5c

FIG. 6a

FIG. 6b

FIG. 6c

FIG. 6d

FIG. 6e

FIG. 6f

FIG. 6g

FIG. 6h

FIG. 7

FIG. 8

FIG. 9

FIG. 10a

FIG. 10b

FIG. 11a

FIG.11b

FIG. 12a

N-th column    (N+1)-th column

41

43

42

M-th
row

FIG. 12b

N-th column    (N+1)-th column

T4

T3

T5

M-th
row

T6

FIG. 13a

FIG. 13b

FIG. 14a

N-th column | (N+1)-th column

X
Y

22-1
22
22-3

21-1
21
21-3

22-2

27-1
27
27-3

28-2
21-2
28-3

28
27

28-1
27-2

M-th
row

## FIG. 14b

N-th column | (N+1)-th column

X
Y

T2

T4

T1

T3

T5

M-th
row

T8    T7   T6

## FIG. 15a

FIG. 15b

FIG. 16

FIG. 17a

FIG. 17b

FIG. 18

FIG. 19a

FIG. 19b

FIG. 20

N-th column    (N+1)-th column

T2

T4

T1

T3

T5

M-th
row

T8    T7    T6

## FIG. 21a

N-th column    (N+1)-th column

91

92

92

M-th
row

94    93

## FIG. 21b

FIG. 22

FIG. 23a

N-th column | (N+1)-th column | X / Y

100 { 102 / 101

M-th row

## FIG. 23b

N-th column | (N+1)-th column | (N+2)-th column | (N+3)-th column | X / Y

K0 (K03)     K0 (K03)     K0 (K03)

T2   K0 (K01)    K0 (K02)

T4
T1
T3
T5
T8
T7
T6

K0 (K03)

M-th row

K0 (K02)      K0 (K01)

(M+1)-th row

## FIG. 24a

FIG. 24b

FIG. 25

FIG. 26

## INTERNATIONAL SEARCH REPORT

| International application No. |
|---|
| **PCT/CN2023/125965** |

| **A.** | **CLASSIFICATION OF SUBJECT MATTER** |
|---|---|

H10K 59/121(2023.01)i

According to International Patent Classification (IPC) or to both national classification and IPC

| **B.** | **FIELDS SEARCHED** |
|---|---|

Minimum documentation searched (classification system followed by classification symbols)

IPC: H10K 59/-

Documentation searched other than minimum documentation to the extent that such documents are included in the fields searched

Electronic data base consulted during the international search (name of data base and, where practicable, search terms used)

CNTXT, ENTXTC, WPABS, CNKI, ENTXT: 京东方, 像素, 驱动电路, 第八, 第一类晶体管, 第二类晶体管, P型, N型, 交叠, 重叠, 投影, 透光区, 相邻, 电源线, 数据线, 屏蔽电极, 中线, 对称, array substrate, pixel circuit?, T8, DL, data, oled, center line, symmetric, overlap+, type, transistor, TFT

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| X | CN 114093898 A (BOE TECHNOLOGY GROUP CO., LTD. et al.) 25 February 2022 (2022-02-25)<br>description, paragraphs [0069]-[0147], and figures 1A-6 | 1-16, 19, 24-25 |
| Y | CN 114093898 A (BOE TECHNOLOGY GROUP CO., LTD. et al.) 25 February 2022 (2022-02-25)<br>description, paragraphs [0069]-[0147], and figures 1A-6 | 17-18 |
| X | CN 116568078 A (BOE TECHNOLOGY GROUP CO., LTD. et al.) 08 August 2023 (2023-08-08)<br>description, paragraphs [0107]-[0119], [0129]-[0144], [0164], [0222]-[0249], and [0313]-[0314], and figures 1-18 and 36 | 20-25 |
| Y | CN 116568078 A (BOE TECHNOLOGY GROUP CO., LTD. et al.) 08 August 2023 (2023-08-08)<br>description, paragraphs [0107]-[0119], [0129]-[0144], [0164], [0222]-[0249], and [0313]-[0314], and figures 1-18 and 36 | 17-18 |

☑ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **18 December 2023** | **21 December 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
| --- |
| **PCT/CN2023/125965** |

### C. DOCUMENTS CONSIDERED TO BE RELEVANT

| Category* | Citation of document, with indication, where appropriate, of the relevant passages | Relevant to claim No. |
| --- | --- | --- |
| X | CN 114241996 A (WUHAN TIANMA MICROELECTRONICS CO., LTD.) 25 March 2022 (2022-03-25)<br>description, paragraphs [0048]-[0116], and figures 1-11 | 1-16, 19, 24-25 |
| X | CN 116887624 A (YUNGU (GU'AN) TECHNOLOGY CO., LTD.) 13 October 2023 (2023-10-13)<br>description, paragraphs [0047]-[0100], and figures 2-9 | 20-25 |
| A | CN 111524945 A (HEFEI BOE JOINT TECHNOLOGY CO., LTD. et al.) 11 August 2020 (2020-08-11)<br>entire document | 1-25 |
| A | CN 115101565 A (WUHAN TIANMA MICROELECTRONICS CO., LTD. et al.) 23 September 2022 (2022-09-23)<br>entire document | 1-25 |
| A | CN 115377165 A (BOE TECHNOLOGY GROUP CO., LTD. et al.) 22 November 2022 (2022-11-22)<br>entire document | 1-25 |
| A | CN 116709854 A (BOE TECHNOLOGY GROUP CO., LTD. et al.) 05 September 2023 (2023-09-05)<br>entire document | 1-25 |
| A | US 2018226464 A1 (SAMSUNG DISPLAY CO., LTD.) 09 August 2018 (2018-08-09)<br>entire document | 1-25 |

Form PCT/ISA/210 (second sheet) (July 2022)

<div align="center">

**INTERNATIONAL SEARCH REPORT**
**Information on patent family members**

</div>

| International application No. |
| --- |
| **PCT/CN2023/125965** |

| Patent document cited in search report | | | Publication date (day/month/year) | Patent family member(s) | | | Publication date (day/month/year) |
| --- | --- | --- | --- | --- | --- | --- | --- |
| CN | 114093898 | A | 25 February 2022 | None | | | |
| CN | 116568078 | A | 08 August 2023 | None | | | |
| CN | 114241996 | A | 25 March 2022 | CN | 114241996 | B | 26 May 2023 |
| CN | 116887624 | A | 13 October 2023 | None | | | |
| CN | 111524945 | A | 11 August 2020 | WO | 2021218438 | A1 | 04 November 2021 |
| | | | | US | 2023006023 | A1 | 05 January 2023 |
| CN | 115101565 | A | 23 September 2022 | None | | | |
| CN | 115377165 | A | 22 November 2022 | None | | | |
| CN | 116709854 | A | 05 September 2023 | None | | | |
| US | 2018226464 | A1 | 09 August 2018 | US | 2020381503 | A1 | 03 December 2020 |
| | | | | US | 10985230 | B2 | 20 April 2021 |
| | | | | KR | 20170124679 | A | 13 November 2017 |
| | | | | US | 10229962 | B2 | 12 March 2019 |
| | | | | US | 2017317156 | A1 | 02 November 2017 |
| | | | | US | 9954047 | B2 | 24 April 2018 |
| | | | | US | 2021257431 | A1 | 19 August 2021 |
| | | | | US | 11690259 | B2 | 27 June 2023 |
| | | | | US | 2023301145 | A1 | 21 September 2023 |
| | | | | US | 2019245023 | A1 | 08 August 2019 |
| | | | | US | 10707287 | B2 | 07 July 2020 |

Form PCT/ISA/210 (patent family annex) (July 2022)